# EUROPEAN PATENT APPLICATION

(11) **EP 3 896 073 A1**
(43) Date of publication of application: **20.10.2021**
(21) Application number: 21167798.4
(22) Date of filing: 12.04.2021
(51) Int. Cl.: C07F 15/00, C09K 11/00, H01L 51/00, H01L 51/50

(54) **ORGANOMETALLIC COMPOUND, ORGANIC LIGHT-EMITTING DEVICE INCLUDING ORGANOMETALLIC COMPOUND, AND ELECTRONIC APPARATUS INCLUDING ORGANIC LIGHT-EMITTING DEVICE**

(30) Priority: 14.04.2020 KR 20200045374
(71) Applicant: Samsung Electronics Co., Ltd., Suwon-si 16677 (KR)
(72) Inventor: YI, Jeoungin, 16678 Gyeonggi-do (KR); KANG, Byungjoon, 16678 Gyeonggi-do (KR); KIM, Sangdong, 16678 Gyeonggi-do (KR); KIM, Hyungjun, 16678 Gyeonggi-do (KR); LEE, Yong Joo, 16678 Gyeonggi-do (KR); CHOI, Byoungki, 16678 Gyeonggi-do (KR); HONG, Youngki, 16678 Gyeonggi-do (KR); HWANG, Kyuyoung, 16678 Gyeonggi-do (KR)
(74) Representative: Elkington and Fife LLP

(57) **Abstract**

Provided are an organometallic compound, an organic light-emitting device including the organometallic compound, and an electronic apparatus including the organic light-emitting device, in which the organometallic compound may be represented by Formula 1-1: 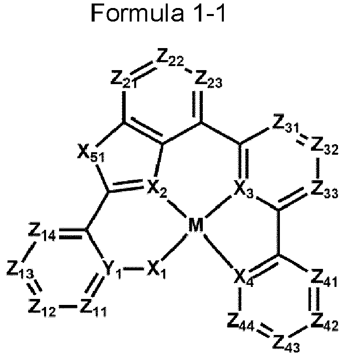 wherein Formula 1-1 may be understood by referring to the description of Formula 1-1 provided herein.

## Description

### FIELD OF THE APPLICATION

The present disclosure relates to an organometallic compound, an organic light-emitting device including the organometallic compound, and an electronic apparatus including the organic light-emitting device.

### BACKGROUND OF THE INVENTION

Organic light-emitting devices (OLEDs) are self-emissive devices which produce full-color images. In addition, OLEDs have wide viewing angles and exhibit excellent driving voltage and response speed characteristics.

OLEDs include an anode, a cathode, and an organic layer between the anode and the cathode and including an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transit from an excited state to a ground state, thus generating light.

### SUMMARY OF THE INVENTION

Provided are an organometallic compound, an organic light-emitting device including the organometallic compound, and an electronic apparatus including the organic light-emitting device.

Additional aspects will be set forth in part in the description which follows and, in part, will be apparent from the description, or may be learned by practice of the presented embodiments of the disclosure.

According to an aspect of an embodiment, an organometallic compound represented by Formula 1-1 may be provided.

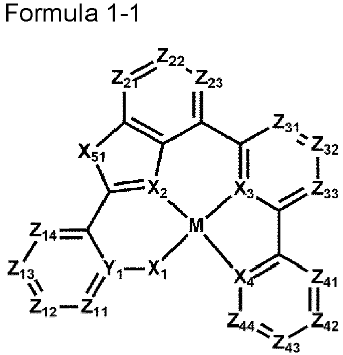

In Formula 1-1,
M may be a transition metal,
X₁ may be O, S, or N(R"'),
a bond between X₁ and M may be a covalent bond,
X₂ to X₄ and Y₁ may each independently be C or N,
one bond of a bond between X₂ and M, a bond between X₃ and M, and a bond between X₄ and M may be a covalent bond, while the remaining bonds may each be a coordinate bond,
X₅₁ may be O, S, N-[(L₇)_{b7}-(R₇)_{c7}], C(R₇)(R₈), Si(R₇)(R₈), Ge(R₇)(R₈), or C(=O),
Z₁₁ may be N or C-[(L₁₁)_{b11}-(T₁₁)_{c11}], Z₁₂ may be N or C-[(L₁₂)_{b12}-(T₁₂)_{c12}], Z₁₃ may be N or C-[(L₁₃)_{b13}-(T₁₃)_{c13}], and Z₁₄ may be N or C-[(L₁₄)_{b14}-(T₁₄)_{c14}],
Z₂₁ may be N or C-[(L₂₁)_{b21}-(T₂₁)_{c21}], Z₂₂ may be N or C-[(L₂₂)_{b22}-(T₂₂)_{c22}], and Z₂₃ may be N or C-[(L₂₃)_{b23}-(T₂₃)_{c23}],
Z₃₁ may be N or C-[(L₃₁)_{b31}-(T₃₁)_{c31}], Z₃₂ may be N or C-[(L₃₂)_{b32}-(T₃₂)_{c32}], and Z₃₃ may be N or C-[(L₃₃)_{b33}-(T₃₃)_{c33}],
Z₄₁ may be N or C-[(L₄₁)_{b41}-(T₄₁)_{c41}], Z₄₂ may be N or C-[(L₄₂)_{b42}-(T₄₂)_{c42}], Z₄₃ may be N or C-[(L₄₃)_{b43}-(T₄₃)_{c43}], and Z₄₄ may be N or C-[(L₄₄)_{b44}-(T₄₄)_{c44}],
L₇, L₁₁ to L₁₄, L₂₁ to L₂₃, L₃₁ to L₃₃ and L₄₁ to L₄₄ may each independently be a single bond, a C₁-C₁₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ,
b7, b11 to b14, b21 to b23, b31 to b33 and b41 to b44 may each independently be 1, 2, 3, 4, or 5,
R'", R₇, R₈, T₁₁ to T₁₄, T₂₁ to T₂₃, T₃₁ to T₃₃ and T₄₁ to T₄₄ may each independently be hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C1-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₆),-B(Q₆)(Q₇), -P(=O)(Q₈)(Q₉), or -P(Q₆)(Q₉),
c7, c11 to c14, c21 to c23, c31 to c33 and c41 to c44 may each independently be 1, 2, 3, 4, or 5,
wherein, the organometallic compound represented by Formula 1-1 may satisfy
1) one of Condition 11, Condition 12 and Condition 13,
2) Condition 11 and Condition 13, or
3) Condition 12 and Condition 13,
   Condition 11
      Z₄₂ in Formula 1-1 is C-[(L₄₂)_{b42}-(T₄₂)_{c42}],
      T₄₂ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
      c42 is 1,
   Condition 12
      Z₄₂ in Formula 1-1 is C-[(L₄₂)_{b42}-(T₄₂)_{c42}],
      T₄₂ is a group represented by Formula 41, and
      c42 is 1,

      Formula 41 *-C(Q₄₁)(Q₄₂)(Q₄₃)

      wherein in Formula 41,
      Q₄₁ to Q₄₃ are each independently deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
      at least one of Q₄₁ to Q₄₃ are each independently a substituted or unsubstituted C₂-C₆₀ alkyl group, a substituted or unsubstituted C₃-C₁₀ cycloalkyl group, or a substituted or unsubstituted C₆-C₆₀ aryl group, and
      * indicates a binding site to an adjacent atom,
   Condition 13
      X₅₁ in Formula 1-1 is N-[(L₇)_{b7}-(R₇)_{c7}],
      L₇ is a benzene group, or a naphthalene group, each unsubstituted or substituted with at least one R₁₀ₐ,
      R₇ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
      c7 is 1,
      each of i) at least two of T₁₁ to T₁₄, ii) at least two of T₂₁ to T₂₃, iii) at least two of T₃₁ to T₃₃, iv) at least two of T₄₁ to T₄₄ and v) at least two of T₁₁ to T₁₄, T₂₁ to T₂₃, T₃₁ to T₃₃, and T₄₁ to T₄₄ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      R₁₀ₐ may be understood by referring to the description of T₁₁ provided herein,
      a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be
      deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group,
      a C₁-C₆₀ alkyl group, a C₂-C₆₀ alkenyl group, a C₂-C₆₀ alkynyl group, or a C1-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), -Ge(Q₁₃)(Q₁₄)(Q₁₆), -B(Q₁₆)(Q₁₇), -P(=O)(Q₁₈)(Q₁₉),-P(Q₁₈)(Q₁₉), or any combination thereof,
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₈)(Q₂₉), -P(Q₂₆)(Q₂₉), or any combination thereof,
      -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₆)(Q₃₉), or -P(Q₃₈)(Q₃₉), or
      any combination thereof,
      wherein Q₁ to Q₉, Q₁₁ to Q₁₉, Q₂₁ to Q₂₉, and Q₃₁ to Q₃₉ may each independently be hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group unsubstituted or substituted with deuterium, a C₁-C₆₀ alkyl group, a C₆-C₆₀ aryl group, or any combination thereof, a C₂-C₆₀ alkenyl group, a C₂-C₆₀ alkynyl group, a C₁-C₆₀ alkoxy group, a C₃-C₁₀ cycloalkyl group, a C1-C₁₀ heterocycloalkyl group, a C₃-C₁₀ cycloalkenyl group, a C₁-C₁₀ heterocycloalkenyl group, a C₆-C₆₀ aryl group unsubstituted or substituted with deuterium, a C₁-C₆₀ alkyl group, a C₆-C₆₀ aryl group, or any combination thereof, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group.

According to an aspect of another embodiment, an organic light-emitting device may include a first electrode, a second electrode, and an organic layer between the first electrode and the second electrode, the organic layer including an emission layer and at least one of the organometallic compound.

The organometallic compound may be included in the emission layer of the organic layer, and the organometallic compound included in the emission layer may serve as a dopant.

According to an aspect of another embodiment, an electronic apparatus may include the organic light-emitting device.

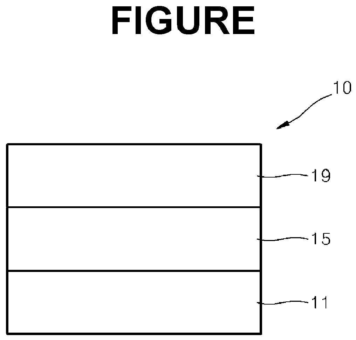

### BRIEF DESCRIPTION OF THE DRAWING

The above and other aspects, features, and advantages of certain embodiments of the disclosure will be more apparent from the following description taken in conjunction with the accompanying drawings, in which

The FIGURE is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

An organometallic compound may be represented by Formula 1-1: 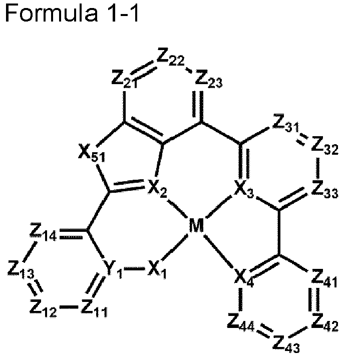 wherein Formula 1-1 may be understood by referring to the description.

In an embodiment, the organometallic compound may have △ST in a range of about 0.1 eV to about 0.2 eV.

In an embodiment, the organometallic compound may have a horizontal orientation ratio of about 85 % or greater.

△ST indicates an energy gap (an absolute value) between a singlet (S₁) energy level and a triplet (T₁) energy level of the organometallic compound represented by Formula 1-1. The singlet (S₁) energy level and the triplet (T₁) energy level of the organometallic compound may be calculated using a density functional theory (DFT). A method of measuring the singlet (S₁) energy level and the triplet (T₁) energy level of the organometallic compound may be understood with reference to Evaluation Example 1.

In an embodiment, the organometallic compound may have △ST in a range of about 0.13 eV to about 0.2 eV, about 0.15 eV to about 0.2 eV or about 0.176 eV to about 0.2 eV.

In one or more embodiments, the organometallic compound may have △ST in a range of about 0.10 eV to about 0.17 eV, about 0.12 eV to about 0.17 eV, or about 0.125 eV to about 0.16 eV.

In one or more embodiments, the organometallic compound may have a horizontal orientation ratio in a range of about 85 % to about 95 % or about 87 % to about 95 %.

In one or more embodiments, the organometallic compound may have a horizontal orientation ratio in a range of about 85 % to about 100 %, about 87 % to about 97 %, or about 88 % to about 95 %.

The horizontal orientation ratio of the organometallic compound, as used herein, may be a horizontal orientation ratio of a transition dipole moment of the organometallic compound. The term "horizontal orientation ratio of a transition dipole moment", as used herein, refers to, in a film including the organometallic compound, a ratio of the organometallic compound having a transition dipole moment which is horizontal with respect to the film, relative to the total organometallic compound included in the film. A horizontal orientation ratio may be measured by preparing a film including a predetermined matrix compound (e.g., mCP) and the organometallic compound and measuring a horizontal orientation ratio of the film. For example, a method of measuring a horizontal orientation ratio of the organometallic compound may be understood by referring to Evaluation Example 2.

Since the organometallic compound has a high horizontal orientation ratio of a transition dipole moment as such, namely, a greatly oriented transition dipole moment (i.e., a large optical orientation in a horizontal direction), when the film includes the organometallic compound, it may be possible for the organometallic compound to emit a large electric field in a vertical direction with respect to the film. Since light emitted by this mechanism may pass to the outside with high efficiency (i.e., efficiency of light emitted from the organometallic compound passing to the outside in a device (e.g., an organic light-emitting device) including a film (e.g., an emission layer described herein) including the organometallic compound), an electronic device, e.g., an organic light-emitting device, employing the organometallic compound, may have excellent luminous efficiency.

In one or more embodiments, the organometallic compound may have a sublimation temperature in a range of about 200 °C to about 350 °C, about 200 °C to about 340 °C, or about 200 °C to about 300 °C. The organometallic compound may have a molecular weight of 1,200 or less or 1100 or less. As the organometallic compound has a sublimation temperature and/or a molecular weight as described above, when forming a thin film including the organometallic compound, decomposition of the organometallic compound may be substantially prevented, thus forming a thin film showing excellent performance.
wherein, in Formula 1-1, M may be a transition metal.

For example, M may be cobalt (Co), copper (Cu), zinc (Zn), gallium (Ga), zirconium (Zr), ruthenium (Ru), rhodium (Rh), palladium (Pd), silver (Ag), rhenium (Re), platinum (Pt), or gold (Au).

In an embodiment, M may be Pt, Pd, or Au.

In Formula 1-1, X₁ may be O, S, or N(R"'), and a bond between X₁ and M may be a covalent bond. R'" may be understood by referring to the description of R'" provided herein.

In some embodiments, X₁ may be O or S.

In an embodiment, X₁ may be O.

In Formula 1-1, X₂ to X₄ and Y₁ may each independently be C or N.

For example, X₂ and X₄ may each be N, and Y₁ and X₃ may each be C.

In Formula 1-1, one bond of a bond between X₂ and M, a bond between X₃ and M, and a bond between X₄ and M may be a covalent bond, while the remaining bonds may each be a coordinate bond. The organometallic compound represented by Formula 1-1 may be electrically neutral.

In some embodiments, a bond between X₂ and M and a bond between X₄ and M may each be a coordinate bond, and a bond between X₃ and M may be a covalent bond.

X₅₁ in Formula 1-1 may be O, S, N-[(L₇)_{b7}-(R₇)_{c7}], C(R₇)(R₈), Si(R₇)(R₈), Ge(R₇)(R₈), or C(=O). Each of R₇, b7, R₈ and b8 may be understood by referring to the description provided herein. R₇ and R₈ may optionally be bound to each other via a first linking group to form a C₅-C₃₀ carbocyclic group unsubstituted or substituted with at least one R₁₀ₐ or a C₁-C₃₀ heterocyclic group unsubstituted or substituted with at least one R₁₀ₐ.

In an embodiment, X₅₁ in Formula 1-1 may be O, S, or N-[(L₇)_{b7}-(R₇)_{c7}].

In an embodiment, X₅₁ in Formula 1-1 may be N-[(L₇)_{b7}-(R₇)_{c7}].

In Formula 1-1,
Z₁₁ may be N or C-[(L₁₁)_{b11}-(T₁₁)_{c11}], Z₁₂ may be N or C-[(L₁₂)_{b12}-(T₁₂)_{c12}], Z₁₃ may be N or C-[(L₁₃)b₁₃-(T₁₃)c₁₃], and Z₁₄ may be N or C-[(L₁₄)b₁₄-(T₁₄)c₁₄],
Z₂₁ may be N or C-[(L₂₁)b₂₁-(T₂₁)c₂₁], Z₂₂ may be N or C-[(L₂₂)_{b22}-(T₂₂)_{c22}], and Z₂₃ may be N or C-[(L₂₃)b₂₃-(T₂₃)c₂₃],
Z₃₁ may be N or C-[(L₃₁)_{b31}-(T₃₁)_{c31}], Z₃₂ may be N or C-[(L₃₂)_{b32}-(T₃₂)_{c32}], and Z₃₃ may be N or C-[(L₃₃)_{b33}-(T₃₃)_{c33}], and
Z₄₁ may be N or C-[(L₄₁)_{b41}-(T₄₁)_{c41}], Z₄₂ may be N or C-[(L₄₂)_{b42}-(T₄₂)_{c42}], Z₄₃ may be N or C-[(L₄₃)_{b43}-(T₄₃)_{c43}], and Z₄₄ may be N or C-[(L₄₄)_{b44}-(T₄₄)_{c44}].

In an embodiment, none of Z₁₁ to Z₁₄, none of Z₂₁ to Z₂₃, none of Z₃₁ to Z₃₃ and none of Z₄₁ to Z₄₄ may be N.

In Formula 1-1, L₇, L₁₁ to L₁₄, L₂₁ to L₂₃, L₃₁ to L₃₃ and L₄₁ to L₄₄ may each independently be a single bond, a C₁-C₁₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ.

For example, in Formula 1-1, L₇, L₁₁ to L₁₄, L₂₁ to L₂₃, L₃₁ to L₃₃ and L₄₁ to L₄₄ may each independently be:
a single bond; or
a methylene group, an ethylene group, a cyclopentane group, a cyclohexane group, a cycloheptane group, a cyclopentene group, a cyclohexene group, a cycloheptene group, an adamantane group, norbornane group, a norbornene group, a bicyclo[1.1.1]pentane group, a bicyclo[2.1.1]hexane group, a bicyclo[2.2.2]octane group, a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one R₁₀ₐ.

In some embodiments, in Formula 1-1, L₇, L₁₁ to L₁₄, L₂₁ to L₂₃, L₃₁ to L₃₃ and L₄₁ to L₄₄ may each independently be:
a single bond; or
a methylene group, a cyclopentane group, a cyclohexane group, a cycloheptane group, a cyclopentene group, a cyclohexene group, a cycloheptene group, an adamantane group, a norbornane group, a norbornene group, a bicyclo[1.1.1]pentane group, a bicyclo[2.1.1]hexane group, a bicyclo[2.2.2]octane group, a benzene group, or a naphthalene group, each unsubstituted or substituted with at least one R₁₀ₐ.

In Formula 1-1, b7, b11 to b14, b21 to b23, b31 to b33 and b41 to b44 may respectively indicate the number of L₇, L₁₁ to L₁₄, L₂₁ to L₂₃, L₃₁ to L₃₃ and L₄₁ to L₄₄, and b7, b11 to b14, b21 to b23, b31 to b33 and b41 to b44 may each independently be 1, 2, 3, 4, or 5.For example, in Formula 1-1, b7, b11 to b14, b21 to b23, b31 to b33 and b41 to b44 may each independently be 1, 2, or 3.

In Formula 1-1, R'", R₇, R₈, T₁₁ to T₁₄, T₂₁ to T₂₃, T₃₁ to T₃₃ and T₄₁ to T₄₄ may each independently be hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C1-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₆),-B(Q₆)(Q₇), -P(=O)(Q₈)(Q₉), or -P(Q₆)(Q₉). Q₁ to Q₉ may respectively be understood by referring to the descriptions of Q₁ to Q₃ provided herein.

For example, in Formula 1-1, R'", R₇, R₈, T₁₁ to T₁₄, T₂₁ to T₂₃, T₃₁ to T₃₃ and T₄₁ to T₄₄ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₂-C₁₀ alkyl group or a C₂-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₈)(Q₉),
wherein Q₁ to Q₉ may each independently be:
   -CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂;
   an n-propyl group, an *iso*-propyl group, an n-butyl group, a sec-butyl group, an isobutyl group, a tert-butyl group, an n-pentyl group, a *tert*-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In some embodiments, in Formula 1-1, R'", R₇, R₈, T₁₁ to T₁₄, T₂₁ to T₂₃, T₃₁ to T₃₃ and T₄₁ to T₄₄ may each independently be:
hydrogen, deuterium, -F, or a cyano group; or
a C₁-C₂₀ alkyl group, a C₃-C₁₀ cycloalkyl group, a phenyl group, a biphenyl group or a naphtyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a (C₁-C₂₀ alkyl)C₃-C₁₀ cycloalkyl group, a deuterated C₃-C₁₀ cycloalkyl group, a fluorinated C₃-C₁₀ cycloalkyl group, or any combination thereof.

In Formula 1-1, c7, c11 to c14, c21 to c23, c31 to c33 and c41 to c44 may respectively indicate the number of R₇, T₁₁ to T₁₄, T₂₁ to T₂₃, T₃₁ to T₃₃ and T₄₁ to T₄₄, and c7, c11 to c14, c21 to c23, c31 to c33 and c41 to c44 may each independently be 1, 2, 3, 4, or 5. For example, c7, c11 to c14, c21 to c23, c31 to c33 and c41 to c44 may each independently be 1 or 2.

The organometallic compound represented by Formula 1-1 may satisfy:
1) one of Condition 11, Condition 12 and Condition 13,
2) Condition 11 and Condition 13, or
3) Condition 12 and Condition 13.
   Condition 11
      Z₄₂ in Formula 1-1 is C-[(L₄₂)_{b42}-(T₄₂)_{c42}],
      T₄₂ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
      c42 is 1.
   Condition 12
      Z₄₂ in Formula 1-1 is C-[(L₄₂)_{b42}-(T₄₂)_{c42}],
      T₄₂ is a group represented by Formula 41, and
      c42 is 1:

      Formula 41 *-C(Q₄₁)(Q₄₂)(Q₄₃)

      wherein in Formula 41,
      Q₄₁ to Q₄₃ are each independently deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
      at least one of Q₄₁ to Q₄₃ are each independently a substituted or unsubstituted C₂-C₆₀ alkyl group, a substituted or unsubstituted C₃-C₁₀ cycloalkyl group, or a substituted or unsubstituted C₆-C₆₀ aryl group, and
      * indicates a binding site to an adjacent atom.
   Condition 13
      X₅₁ in Formula 1-1 is N-[(L₇)_{b7}-(R₇)_{c7}],
      L₇ is a benzene group, or a naphthalene group, each unsubstituted or substituted with at least one R₁₀ₐ,
      R₇ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
      c7 is 1.

In some embodiments, the organometallic compound represented by Formula 1-1 may satisfy Condition 11 or Condition 12.

In some embodiments, the organometallic compound represented by Formula 1-1 may satisfy Condition 11 and L₄₂ may be a benzene group, or a naphthalene group, each unsubstituted or substituted with at least one R₁₀ₐ.

In some embodiments, the organometallic compound represented by Formula 1-1 may satisfy Condition 12 and L₄₂ may be a benzene group, or a naphthalene group, each unsubstituted or substituted with at least one R₁₀ₐ.

In some embodiments, the organometallic compound represented by Formula 1-1 may satisfy Condition 11 or Condition 13, and T₄₂ and R₇ may each independently be a C₃-C₁₀ cycloalkyl group unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a (C₁-C₂₀ alkyl) phenyl group, a deuterated phenyl group, a fluorinated phenyl group, or any combination thereof.

In some embodiments, the organometallic compound represented by Formula 1-1 may satisfy Condition 12, and Q₄₁ to Q₄₃ in Formula 41 may each independently be:
deuterium; or
a C₁-C₂₀ alkyl group, a C₃-C₁₀ cycloalkyl group, a phenyl group, a biphenyl group or a naphtyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a (C₁-C₂₀ alkyl) C₃-C₁₀ cycloalkyl group, a deuterated C₃-C₁₀ cycloalkyl group, a fluorinated C₃-C₁₀ cycloalkyl group, or any combination thereof.

In some embodiments, the organometallic compound represented by Formula 1-1 may satisfy Condition 12 and at least one of Q₄₁ to Q₄₃ in Formula 41 may each independently be a C₂-C₂₀ alkyl group, a C₃-C₁₀ cycloalkyl group, a phenyl group, a biphenyl group or a naphtyl group, each unsubstituted or substituted with deuterium, - F, a cyano group, a C₁-C₂₀ alkyl group, a deuterated C₁-C₂₀ alkyl group, a fluorinated C₁-C₂₀ alkyl group, a C₃-C₁₀ cycloalkyl group, a (C₁-C₂₀ alkyl) C₃-C₁₀ cycloalkyl group, a deuterated C₃-C₁₀ cycloalkyl group, a fluorinated C₃-C₁₀ cycloalkyl group, or any combination thereof.

Each of i) at least two of T₁₁ to T₁₄, ii) at least two of T₂₁ to T₂₃, iii) at least two of T₃₁ to T₃₃, iv) at least two of T₄₁ to T₄₄ and v) at least two of T₁₁ to T₁₄, T₂₁ to T₂₃, T₃₁ to T₃₃, and T₄₁ to T₄₄ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ may be understood by referring to the description of T₁₁ provided herein, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C1-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -Ge(Q₁₃)(Q₁₄)(Q₁₆), -B(Q₁₆)(Q₁₇), -P(=O)(Q₁₈)(Q₁₉),-P(Q₁₆)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₆)(Q₂₉), -P(Q₂₈)(Q₂₉), or any combination thereof;
-N(Q31)(Q32), -Si(Q₃₃)(Q₃₄)(Q₃₅), -Ge(Q₃₃)(Q₃₄)(Q₃₅), -B(Q₃₆)(Q₃₇),-P(=O)(Q₃₆)(Q₃₉), or -P(Q₃₆)(Q₃₉); or
any combination thereof,
wherein Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

In an embodiment, in Formula 1-1, X₅₁ may be N-[(L₇)_{b7}-(R₇)_{c7}], and the group represented by *-[(L₇)_{b7}-(R₇)_{c7}] may be a group represented by Formula N51: 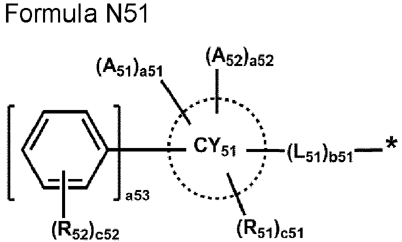 wherein, in Formula N51, ring CY₅₁ may be a C₅-C₃₀ carbocyclic group or a C1-C₃₀ heterocyclic group. For example, ring CY₅₁ may be a benzene group or a naphthalene group.

In Formula N51, L₅₁, b51, R₅₁, and c51 may respectively be understood by referring to the descriptions of L₇, b7, R₇, and c7 provided herein, and R₅₂ and c52 may respectively be understood by referring to the descriptions of R₇ and c7 provided herein.

In Formula N51, A₅₁ may be a C₁-C₆₀ alkyl group unsubstituted or substituted with a C₃-C₁₀ cycloalkyl group. For example, A₅₁ may be a C₁-C₂₀ alkyl group unsubstituted or substituted with a C₃-C₁₀ cycloalkyl group or a C₄-C₂₀ alkyl group unsubstituted or substituted with a C₃-C₁₀ cycloalkyl group.

In Formula N51, A₅₂ may be a deuterated C₁-C₆₀ alkyl group unsubstituted or substituted with a C₃-C₁₀ cycloalkyl group. For example, A₅₂ may be a deuterated C₁-C₂₀ alkyl group unsubstituted or substituted with a C₃-C₁₀ cycloalkyl group.

When X₅₁ in Formula 1-1 is N-[(L₇)_{b7}-(R₇)_{c7}] and the group represented by *-[(L₇)_{b7}-(R₇)_{c7}] is a group represented by Formula N51, an angle between a plane including a transition dipole moment of the organometallic compound and a plane including four atoms of a tetradentate ligand bound to a metal (M) in Formula 1-1 may be 10° or less. In addition, a horizontal orientation ratio of a transition dipole moment of the organometallic compound represented by Formula 1-1 may be in a range of about 80 % to about 100 %.

For example, an angle between a plane including a transition dipole moment of the organometallic compound and a plane including four atoms of a tetradentate ligand bound to a metal (or platinum) in Formula 1-1 may be in a range of about 0° to about 10°, about 0° to about 9°, about 0° to about 8°, about 0° to about 7°, about 0° to about 6°, about 0° to about 5°, about 0° to about 4°, about 0° to about 3°, about 0° to about 2°, or about 0° to about 1°. As an angle between a plane including a transition dipole moment of the organometallic compound represented by Formula 1-1 and a plane including four atoms bound to a metal in Formula 1-1 is within any of these ranges, the organometallic compound may have excellent planar properties, and a thin film formed using the organometallic compound may have excellent electrical characteristics.

In an embodiment, A₅₁ may be a linear or branched C₄-C₁₀ alkyl group, and A₅₂ may be a hydrogen-free deuterated C₁-C₁₀ alkyl group.

In one or more embodiments, A₅₁ may be *an* n-butyl group, a sec-butyl group, an isobutyl group, a tert-butyl group, *an* n-pentyl group, a *tert*-pentyl group, a neopentyl group, an isopentyl group, a sec-pentyl group, a 3-pentyl group, or a sec-isopentyl group.

In one or more embodiments, A₅₂ may be a methyl group, an ethyl group, *an* n-propyl group, an iso-propyl group, *an* n-butyl group, a sec-butyl group, an isobutyl group, a *tert-butyl group, an n*-pentyl group, a *tert*-pentyl group, a neopentyl group, an isopentyl group, a sec-pentyl group, a 3-pentyl group, or a sec-isopentyl group, each substituted with at least one deuterium (or a hydrogen-free methyl group, a hydrogen-free ethyl group, a hydrogen-free n-propyl group, a hydrogen-free iso-propyl group, a hydrogen-free n-butyl group, a hydrogen-free sec-butyl group, a hydrogen-free isobutyl group, a hydrogen-free *tert*-butyl group, a hydrogen-free n-pentyl group, a hydrogen-free *tert*-pentyl group, a hydrogen-free neopentyl group, a hydrogen-free isopentyl group, a hydrogen-free sec-pentyl group, a hydrogen-free 3-pentyl group, or a hydrogen-free sec-isopentyl group, each substituted with at least one deuterium).

In one or more embodiments, in Formulae 1-1 and N51, R'", R₇, R₈, T₁₁ to T₁₄, T₂₁ to T₂₃, T₃₁ to T₃₃, T₄₁ to T₄₄, R₅₁, and R₅₂ may each independently be hydrogen, deuterium, -F, a cyano group, a nitro group, -SF₅, -CH₃, -CD₃, -CD₂H, -CDH₂, -CF₃,-CF₂H, -CFH₂, a group represented by one of Formulae 9-1 to 9-39, a group represented by one of Formulae 9-1 to 9-39 in which at least one hydrogen is substituted with deuterium, a group represented by one of Formulae 9-201 to 9-237, a group represented by one of 9-201 to 9-237 in which at least one hydrogen is substituted with deuterium, a group represented by one of Formulae 10-1 to 10-129, a group represented by one of Formulae 10-1 to 10-129 in which at least one hydrogen is substituted with deuterium, a group represented by one of Formulae 10-201 to 10-350, a group represented by one of Formulae 10-201 to 10-350 in which at least one hydrogen is substituted with deuterium, -Si(Q₃)(Q₄)(Q₅), or -Ge(Q₃)(Q₄)(Q₆), wherein Q₃ to Q₅ may respectively be understood by referring to the descriptions of Q₃ to Q₅ provided herein.

In one or more embodiments, in Formula N51, A₅₁ may be a group represented by Formulae 9-4 to 9-39.

In one or more embodiments, in Formula N51, A₅₂ may be a group represented by one of Formulae 9-1 to 9-39 in which at least one hydrogen is substituted with deuterium.

In one or more embodiments, in Formula N51, a group represented by 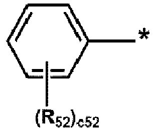 may be a group represented by one of Formulae 10-12 to 10-129:

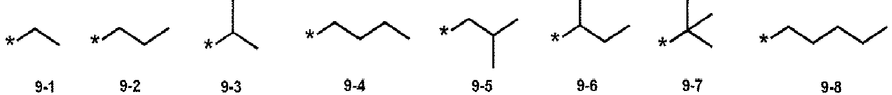

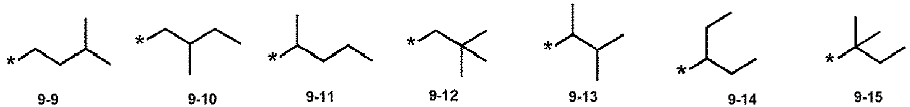

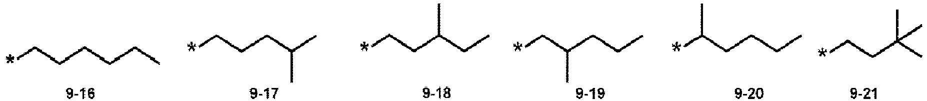

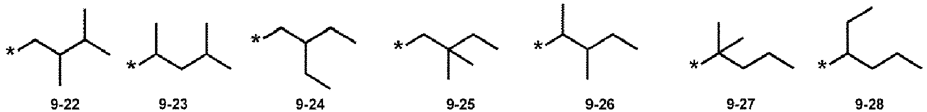

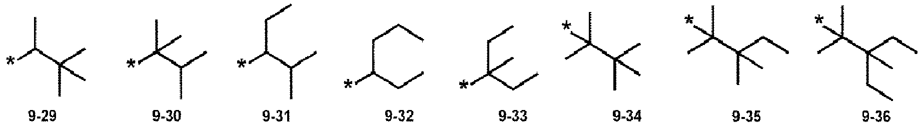

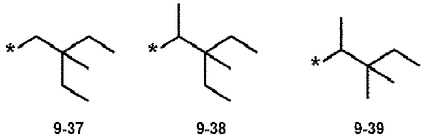

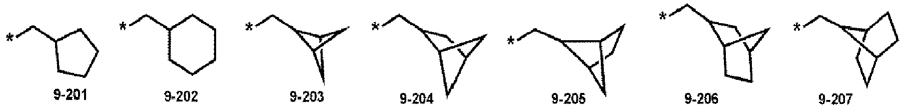

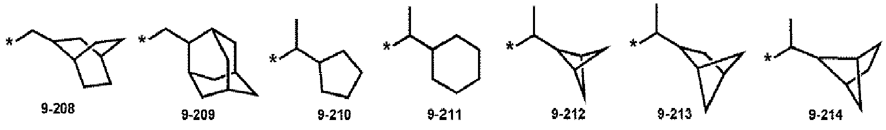

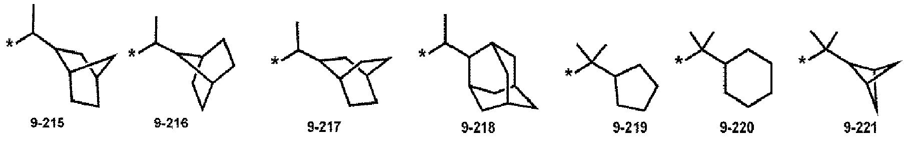

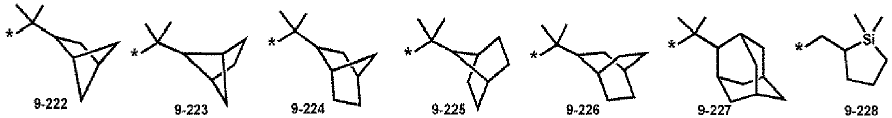

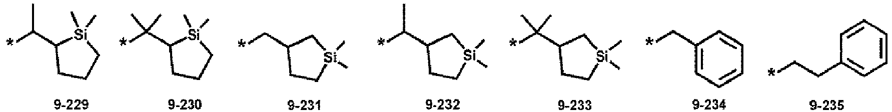

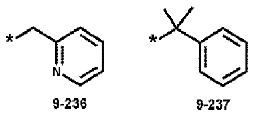

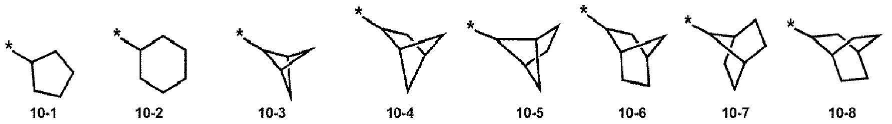

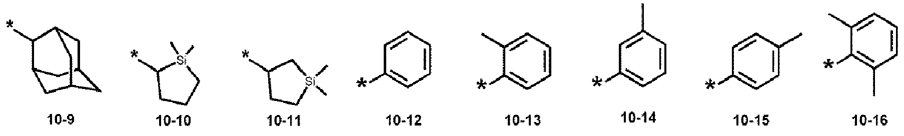

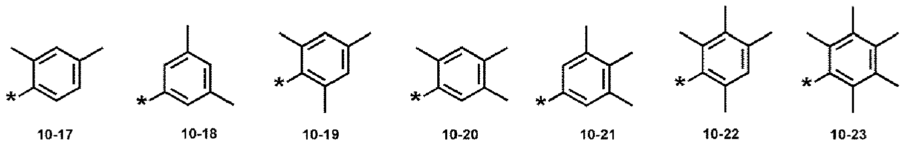

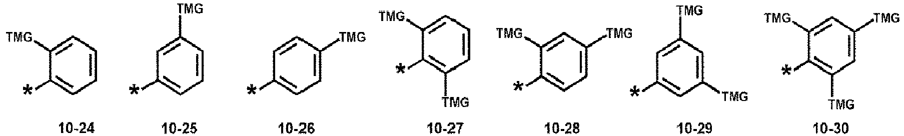

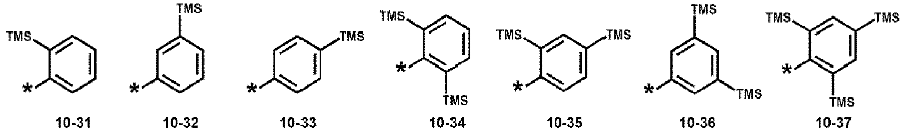

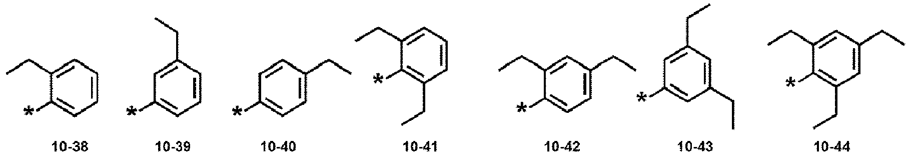

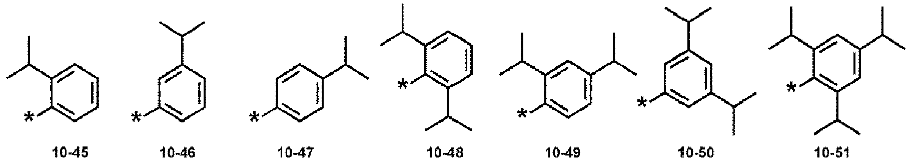

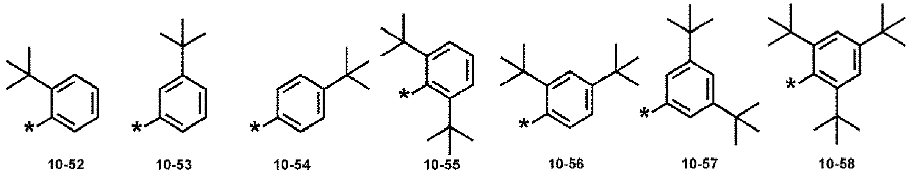

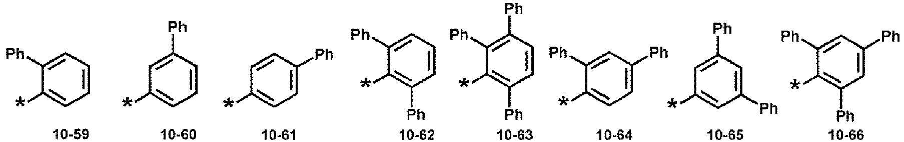

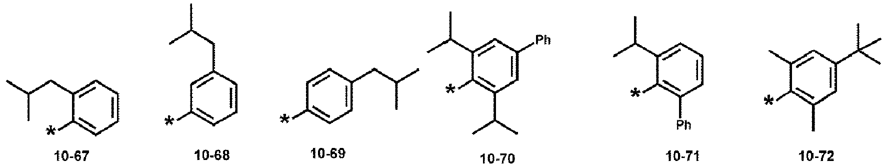

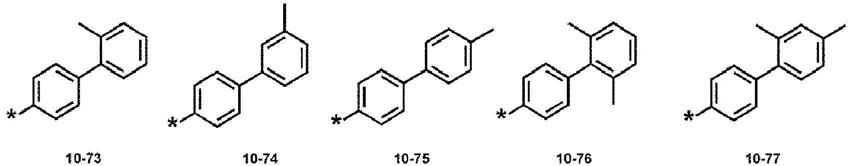

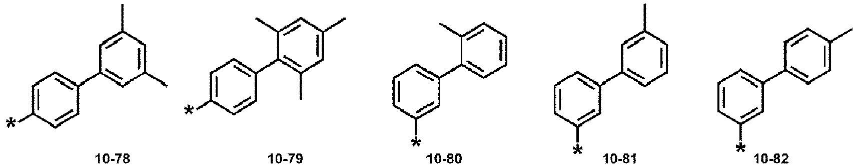

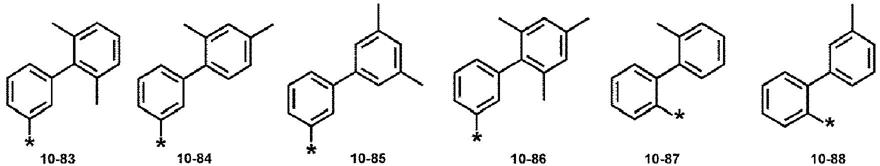

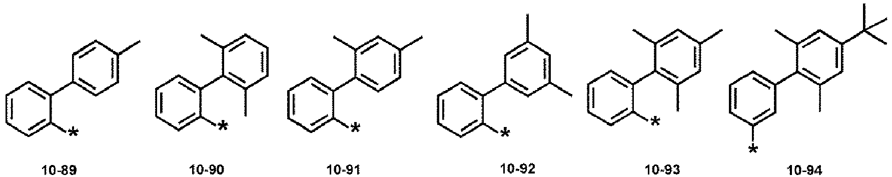

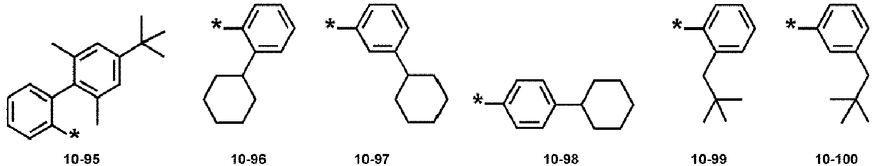

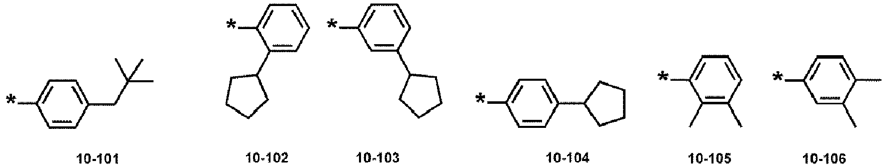

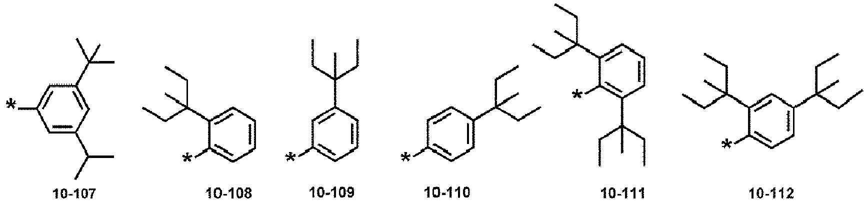

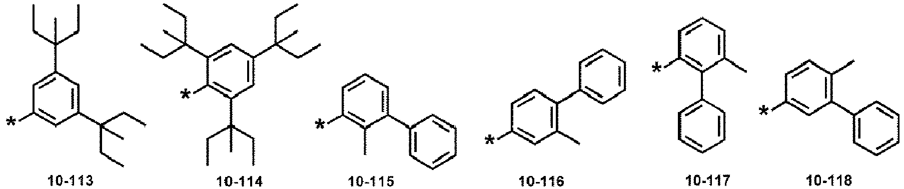

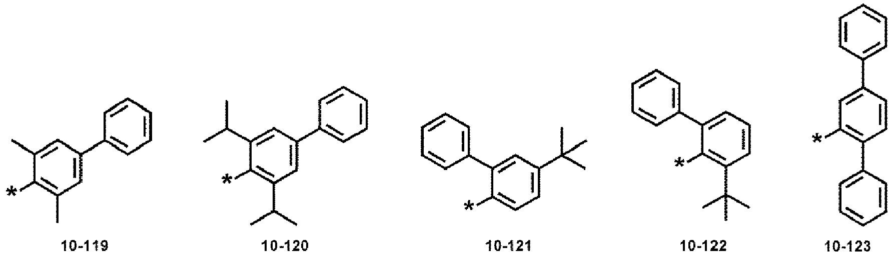

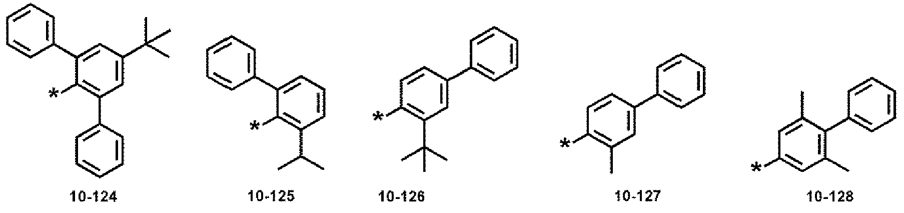

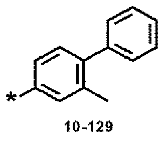

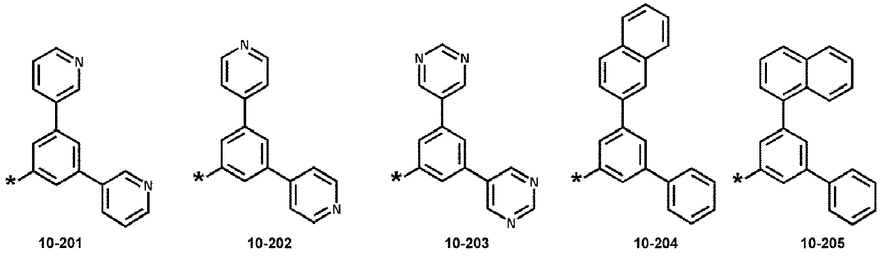

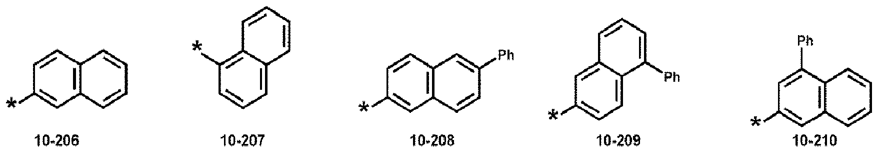

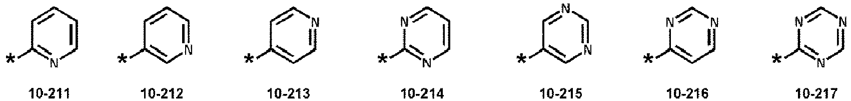

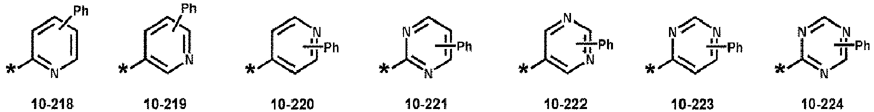

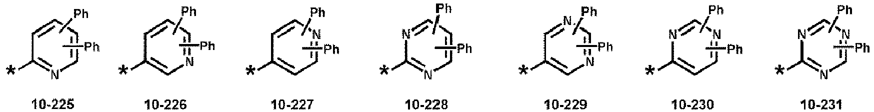

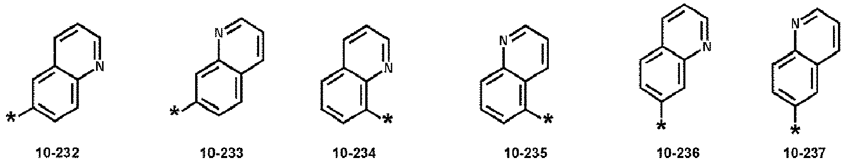

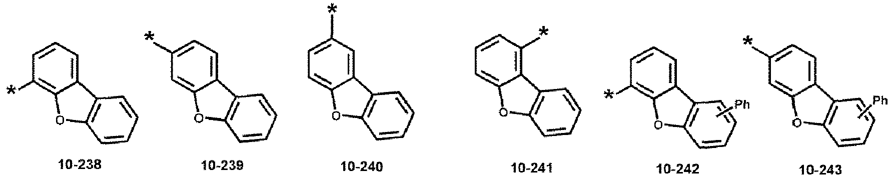

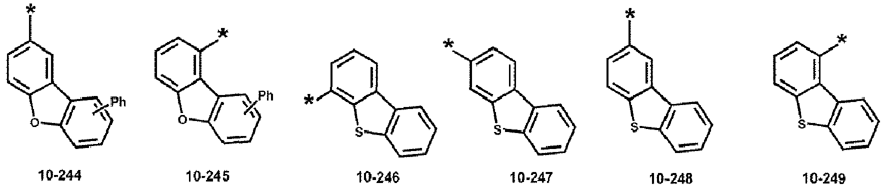

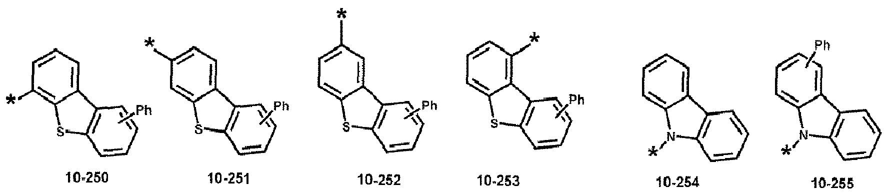

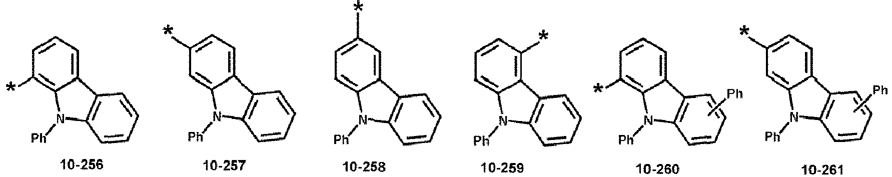

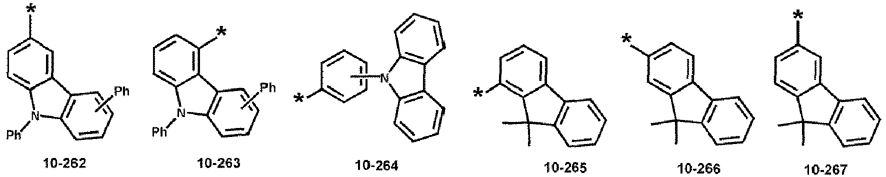

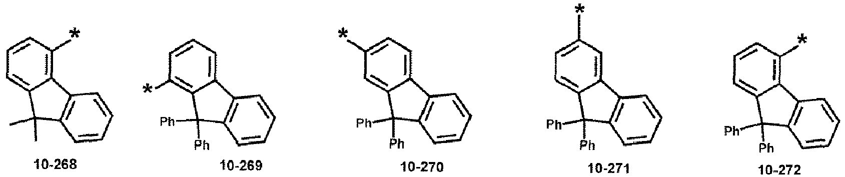

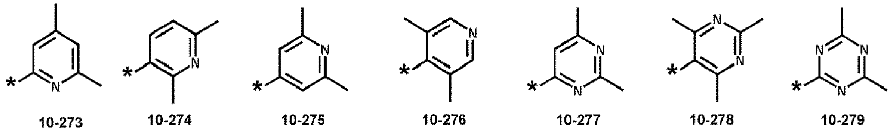

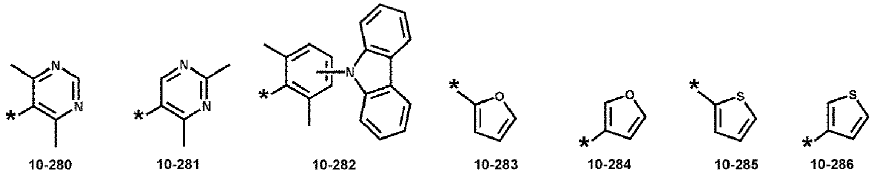

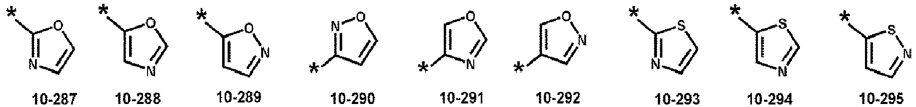

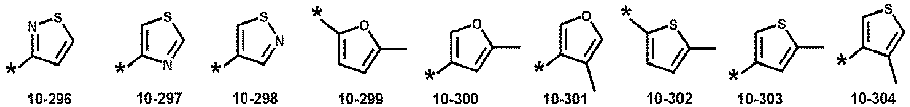

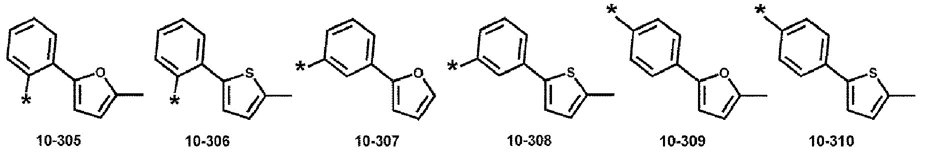

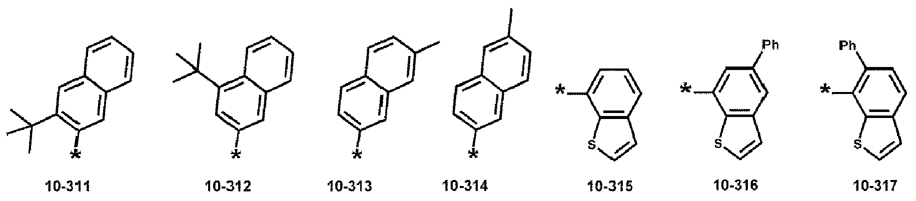

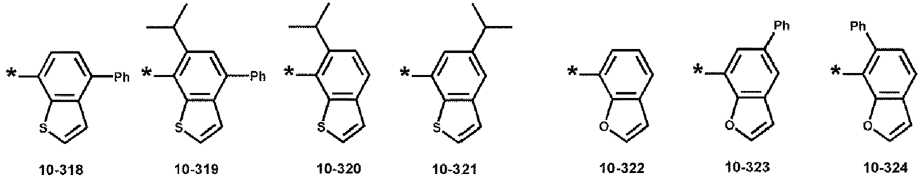

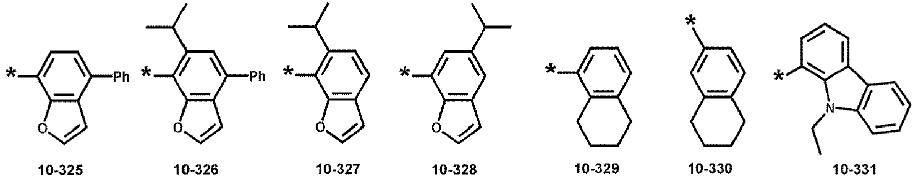

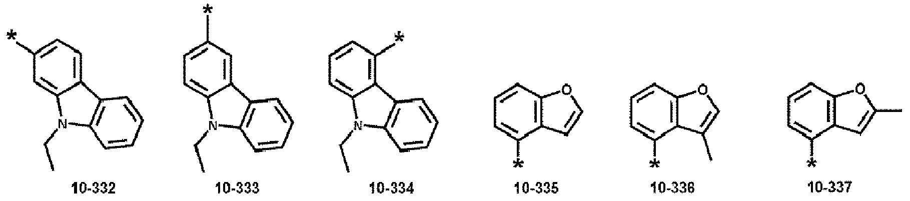

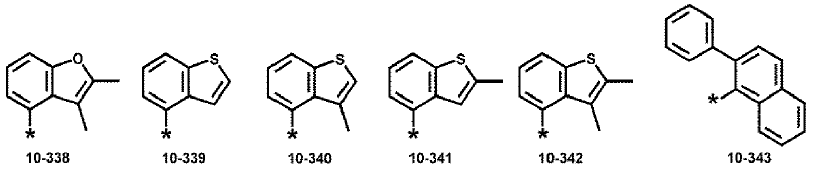

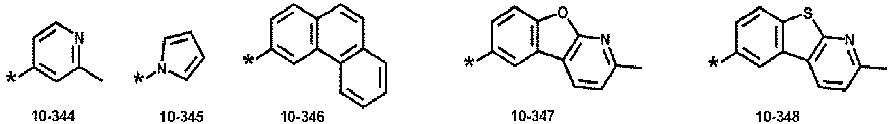

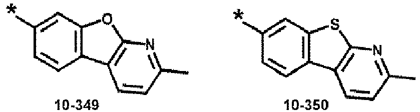

In Formulae 9-1 to 9-39, 9-201 to 9-237, 10-1 to 10-129, and 10-201 to 10-350, * indicates a binding site to an adjacent atom, "Ph" represents a phenyl group, "TMS" represents a trimethylsilyl group, and "TMG" represents a trimethylgermyl group.

The "group represented by one of Formulae 9-1 to 9-39 in which at least one hydrogen is substituted with deuterium" and the "group represented by one of Formulae 9-201 to 9-237 in which at least one hydrogen is substituted with deuterium " may each be, for example, a group represented by one of Formulae 9-501 to 9-514 and 9-601 to 9-636:

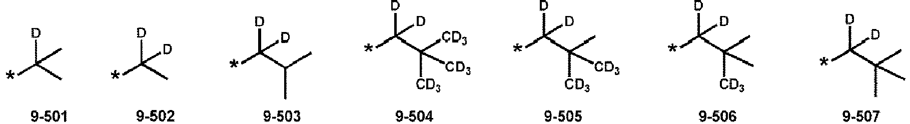

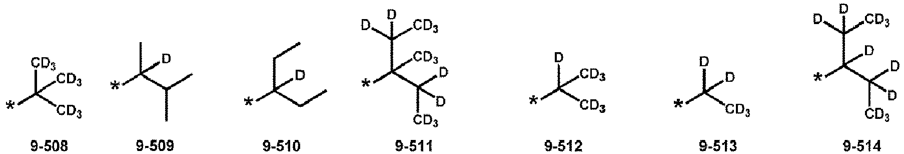

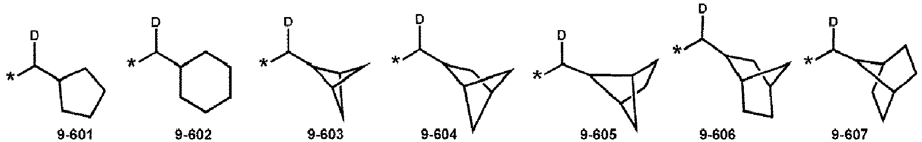

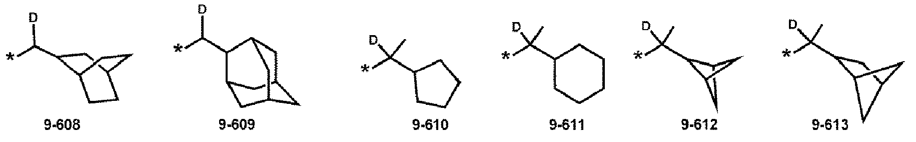

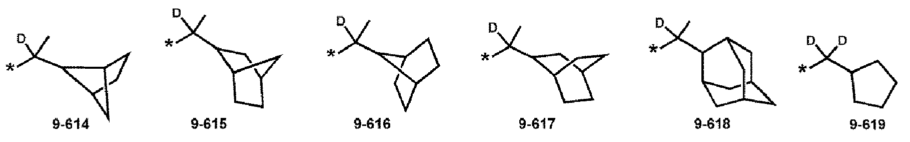

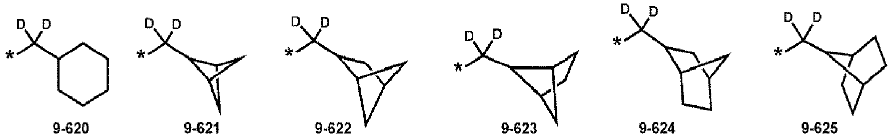

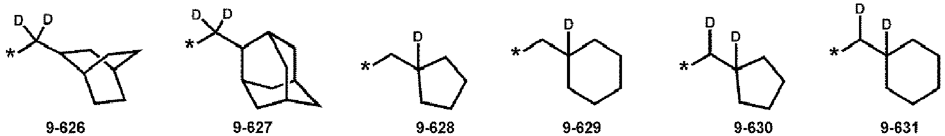

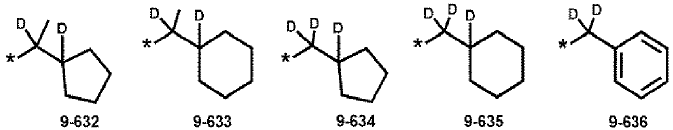

The "group represented by one of Formulae 10-1 to 10-129 in which at least one hydrogen is substituted with deuterium" and the "group represented by one of Formulae 10-201 to 10-350 in which at least one hydrogen is substituted with deuterium" may each be, for example, a group represented by one of Formulae 10-501 to 553:

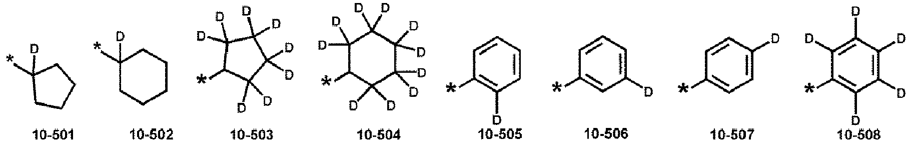

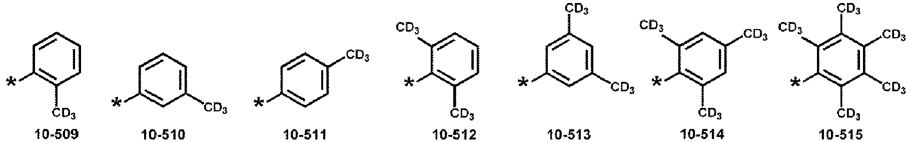

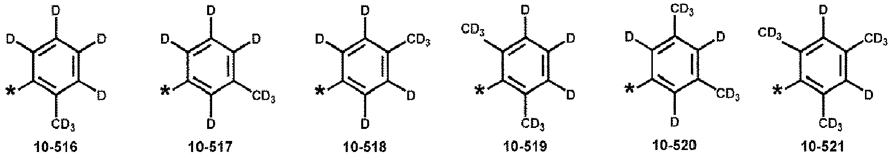

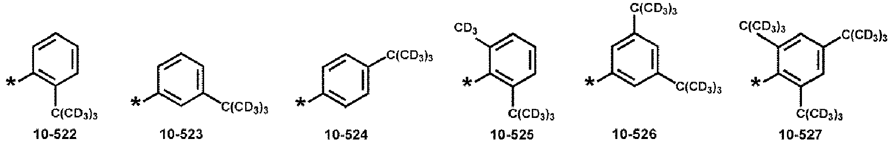

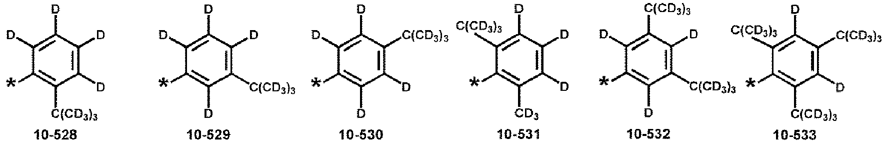

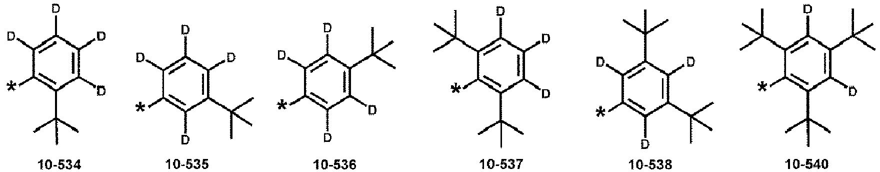

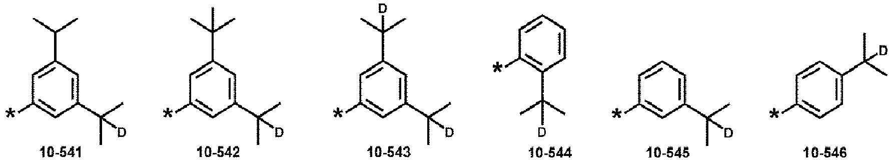

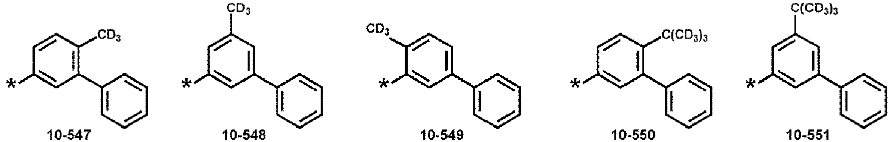

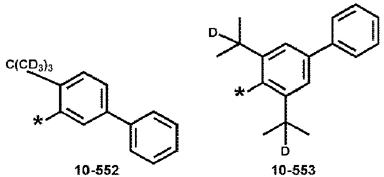

In some embodiments, in Formula N51, A₅₂ may be a group represented by one of Formulae 9-1 to 9-39 in which all hydrogens are substituted with deuteriums.

In one or more embodiments, in Formula 1-1, X₅₁ may be N-[(L₇)_{b7}-(R₇)_{c7}], and a group represented by *-[(L₇)_{b7}-(R₇)_{c7}] may be a phenyl group substituted with both 1) at least one C₄-C₁₀ alkyl group and 2) at least one phenyl group.

In one or more embodiments, in Formula 1-1, X₅₁ may be N-[(L₇)_{b7}-(R₇)_{c7}], and a group represented by *-[(L₇)_{b7}-(R₇)_{c7}] may be a phenyl group substituted with both 1) at least one tert-butyl group and 2) at least one phenyl group.

In Formula N51, a51 and a52 may respectively indicate the number of A₅₁(s) and A₅₂(s), and a51 and a52 may each independently be an integer from 0 to 10. When a51 is 2 or greater, at least two A₅₁(s) may be identical to or different from each other. When a52 is 2 or greater, at least two A₂(s) may be identical to or different from each other.

For example, in Formula N51, a51 and a52 may each independently be 0, 1, 2, 3, 4, 5, or 6.

In Formula N51, a sum of a51 and a52 may be 1 or greater. That is, in Formula N51, ring CY₅₁ is substituted with the group represented by A₅₁, the group represented by A₅₂, or any combination thereof. While not wishing to be bound by theory, ring CY₅₁ is substituted with at least one electron donating group, and thus, an electronic device, e.g., an organic light-emitting device, including the organometallic compound represented by Formula 1-1 including the group represented by Formula N51 may have improved luminescence efficiency and lifespan.

In some embodiments, a sum of a51 and a52 may be 1, 2, or 3. In an embodiment, a sum of a51 and a52 may be 1.

In Formula N51, a53 indicates the number of a group represented by 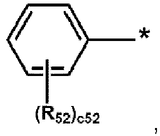 and a53 may be an integer from 1 to 10. That is, a53 in Formula N51 may not be 0, and thus ring CY₅₁ in Formula N51 is substituted with at least one group represented by 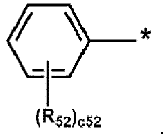 While not wishing to be bound by theory, due to resonance effects of the group represented by 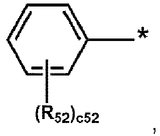 an electronic device, e.g., an organic light-emitting device, including the organometallic compound represented by Formula 1-1 including the group represented by Formula N51 may have improved luminescence efficiency and lifespan. While not wishing to be bound by theory, because a benzimidazole group in Formula 1-1 including the group represented by Formula N51 may be protected from electrons or heat by the group represented by 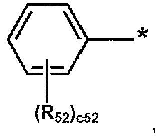 an electronic device, e.g., an organic light-emitting device, including the organometallic compound represented by Formula 1-1 may have improved luminescence efficiency and lifespan.

In an embodiment, in Formula N51, a51 and a52 may each independently be 0, 1, or 2 (e.g., 0 or 1), and a sum of a51 and a52 may be 1 or 2 (e.g., 1), and a53 may be 1 or 2 (e.g., 1).
wherein in Formula N51, * indicates a binding site to an adjacent atom.

In one or more embodiments, in Formula N51, the group represented by 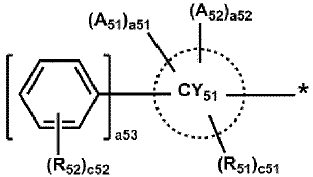 may be a group represented by one of Formulae 51-1 to 51-20: 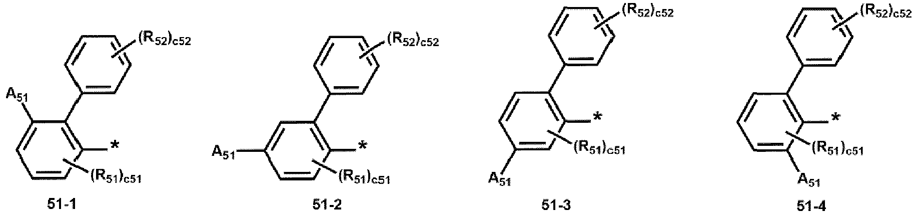 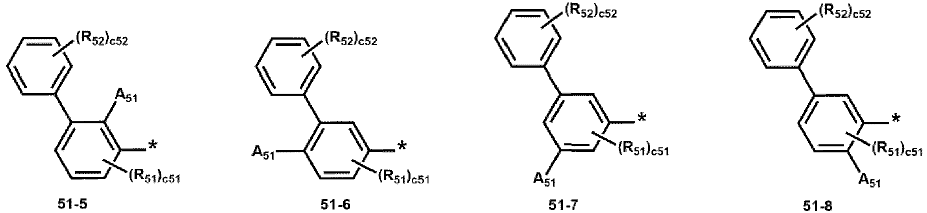 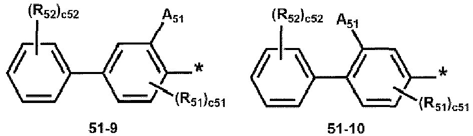 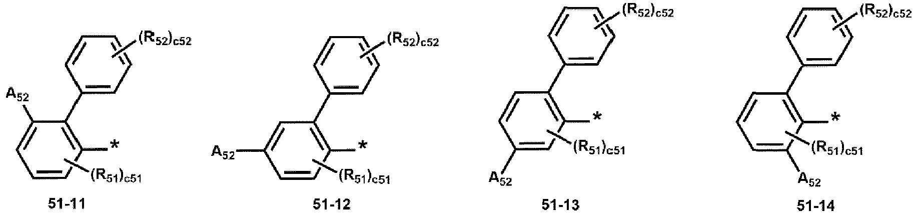 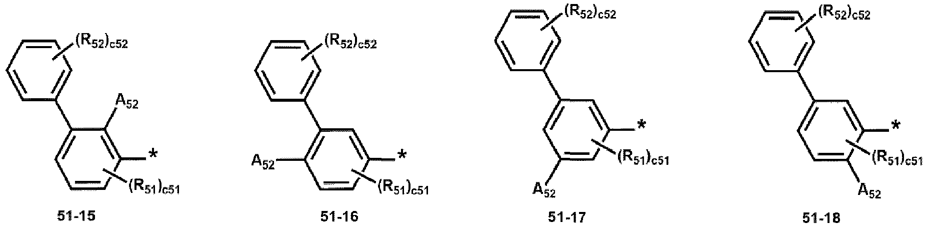 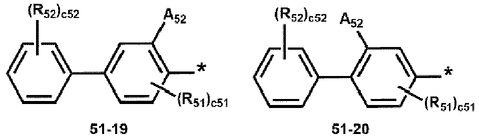 wherein, in Formulae 51-1 to 51-20, R₅₁, R₅₂, c51, c52, A₅₁, and A₅₂ may respectively be understood by referring to the descriptions of R₅₁, R₅₂, c51, c52, A₅₁, and A₅₂ provided herein, and * indicates a binding site to L₅₁.

In one or more embodiments, in Formula 1-1, each of Z₁₂ and Z₁₄ may be C(H).

In one or more embodiments, in Formula 1-1, each of Z₁₁ may be C-[(L₁₁)_{b11}-(T₁₁)_{c11}] and T₁₁ may not be hydrogen.

In one or more embodiments, in Formula 1-1, each of Z₁₃ may be C-[(L₁₃)_{b13}-(T₁₃)_{c13}] and T₁₃ may not be hydrogen.

In one or more embodiments, in Formula 1-1, each of Z₂₁ to Z₂₂ may be C(H).

In one or more embodiments, in Formula 1-1, each of Z₃₁ and Z₃₃ may be C(H).

In one or more embodiments, in Formula 1-1,
Z32 may be C-[(L₃₂)b₃₂-(T₃₂)c₃₂],
L₃₂ may be a single bond, and
T₃₂ may be a substituted or unsubstituted C₁-C₆₀ alkyl group or a substituted or unsubstituted C₆-C₆₀ aryl group.

In one or more embodiments, in Formula 1-1, each of Z₄₁, Z₄₃ and Z₄₄ may be C(H).

In one or more embodiments, in Formula 1-1, each of Z₄₂ may be C-[(L₄₂)_{b42}-(T₄₂)_{c42}] and T₄₂ may not be hydrogen.

In one or more embodiments, in Formula 1-1,
Z11 may be C-[(L₁₁)_{b11}-(T₁₁)_{c11}], Z₁₂ may be C-[(L₁₂)_{b12}-(T₁₂)_{c12}], Z₁₃ may be C-[(L₁₃)_{b13}-(T₁₃)_{c13}], Z₁₄ may be C-[(L₁₄)_{b14}-(T₁₄)_{c14}], Z₃₁ may be C-[(L₃₁)_{b31}-(T₃₁)_{c31}], Z₃₂ may be C-[(L₃₂)_{b32}-(T₃₂)_{c32}], Z₃₃ may be C-[(L₃₃)_{b33}-(T₃₃)_{c33}],
at least one of T₁₁ to T₁₄, at least one of T₃₁ to T₃₃, or any combination thereof may each independently be :
a methyl group, an ethyl group, *an n*-propyl group, an iso-propyl group, *an n-*butyl group, a sec-butyl group, an isobutyl group, a *tert-butyl group, an n*-pentyl group, a *tert*-pentyl group, a neopentyl group, an isopentyl group, a sec-pentyl group, a 3-pentyl group, or a sec-isopentyl group, each unsubstituted or substituted with at least one deuterium, -F, a cyano group, or any combination thereof; or
a phenyl group, or naphtyl group, each unsubstituted or substituted with at least one deuterium, -F, a cyano group, a methyl group, an ethyl group, *an n*-propyl group, an iso-propyl group, *an n*-butyl group, a *sec*-butyl group, an isobutyl group, a *tert-butyl group, an n*-pentyl group, a *tert*-pentyl group, a neopentyl group, an isopentyl group, *a sec-*pentyl group, a 3-pentyl group, or a *sec*-isopentyl group, or any combination thereof.

In one or more embodiments, in Formula 1-1, a group represented by 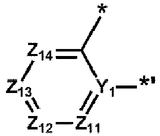 may be represented by one of Formulae A1-1 to A1-9: 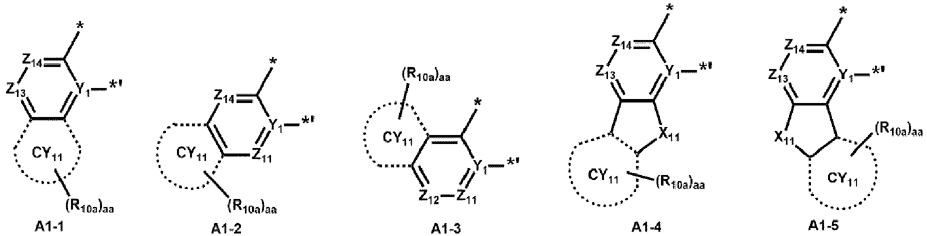 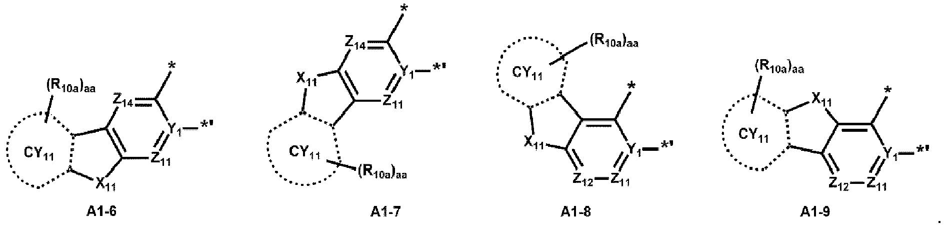 wherein, in Formulae A1-1 to A1-9,
Y₁, Z₁₁ to Z₁₄ and R₁₀ₐ may respectively be understood by referring to the descriptions of Y₁, Z₁₁ to Z₁₄ and R₁₀ₐ provided herein,
ring CY₁₁ may be a C₅-C₃₀ carbocyclic group or a C₁-C₃₀ heterocyclic group (for example, a cyclohexane group, a norbornane group, a benzene group, or a naphthalene group),
X₁₁ may be O, S, N(R₁₁), C(R₁₁)(R₁₂), or Si(R₁₁)(R₁₂),
R₁₁ and R₁₂ may each be understood by referring to the description of T₁₁ provided herein,
aa may be an integer from 0 to 6,
*' indicates a binding site to X₁ in Formula 1-1, and
* indicates a binding site to an adjacent atom.

In one or more embodiments, in Formula 1-1, a group represented by 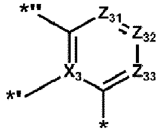 may be represented by one of Formulae A3-1 to A3-6: 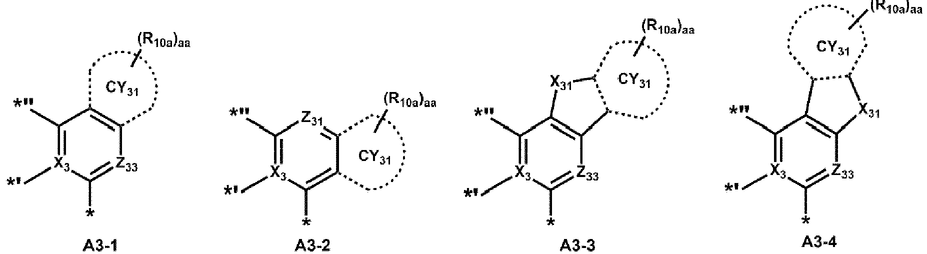 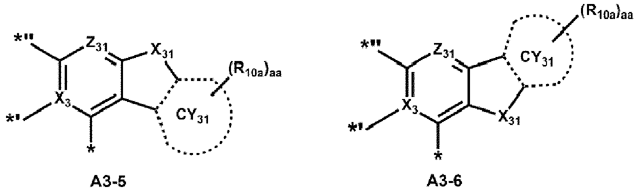 wherein, in Formulae A3-1 to A3-1,
X₃, Z₃₁ to Z₃₃ and R₁₀ₐ may respectively be understood by referring to the descriptions of X₃, Z₃₁ to Z₃₃ and R₁₀ₐ provided herein,
ring CY₃₁ may be a C₅-C₃₀ carbocyclic group or a C₁-C₃₀ heterocyclic group (for example, a cyclohexane group, a norbornane group, a benzene group, or a naphthalene group),
X₃₁ may be O, S, N(R₃₁), C(R₃₁)(R₃₂), or Si(R₃₁)(R₃₂),
R₃₁ and R₃₂ may each be understood by referring to the description of T₃₁ provided herein,
aa may be an integer from 0 to 6,
each of *" and * indicates a binding site to an adjacent atom,
*' indicates a binding site to M in Formula 1-1.

In one or more embodiments, in Formula 1-1, a group represented by 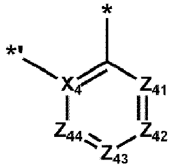 may be represented by one of Formulae A4-1 to A4-9: 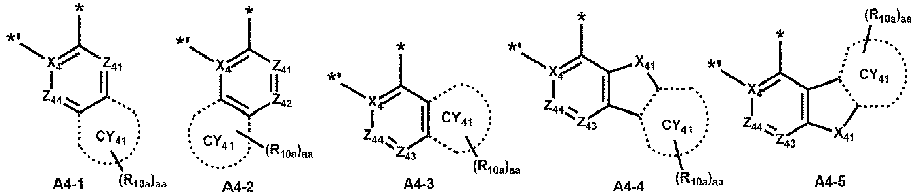 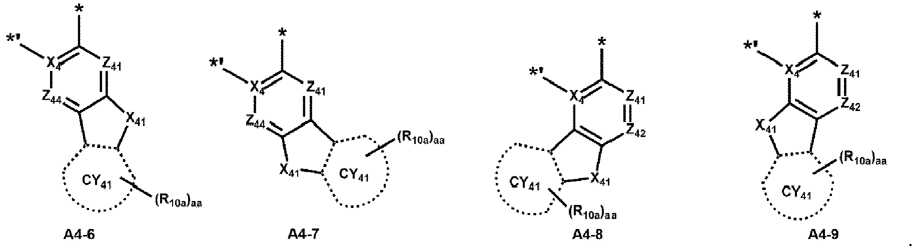 wherein, in Formulae A4-1 to A4-9,
X₄, Z₄₁ to Z₄₄ and R₁₀ₐ may respectively be understood by referring to the descriptions of X₄, Z₄₁ to Z₄₄ and R₁₀ₐ provided herein,
ring CY₄₁ may be a C₅-C₃₀ carbocyclic group or a C₁-C₃₀ heterocyclic group (for example, a cyclohexane group, a norbornane group, a benzene group, or a naphthalene group),
X₄₁ may be O, S, N(R₄₁), C(R₄₁)(R₄₂), or Si(R₄₁)(R₄₂),
R₄₁ and R₄₂ may each be understood by referring to the description of T₄₁ provided herein,
aa may be an integer from 0 to 6,
*' indicates a binding site to M in Formula 1-1, and
* indicates a binding site to an adjacent atom in Formula 1-1.

In one or more embodiments, the organometallic compound represented by Formula 1-1 may include at least one deuterium.

The organometallic compound represented by Formula 1-1 may be one of the Compounds 1 to 420:

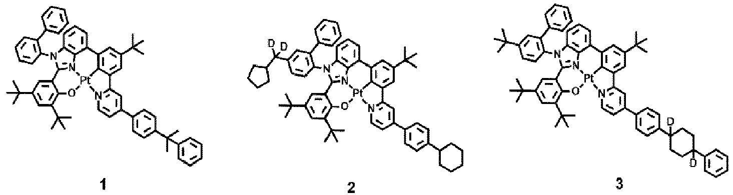

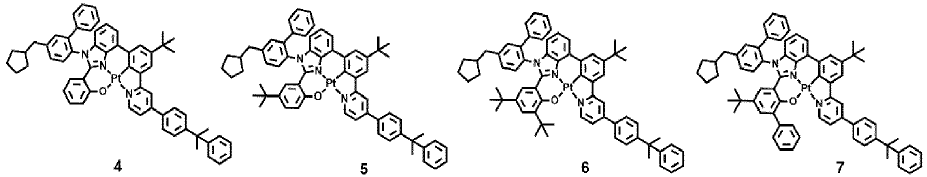

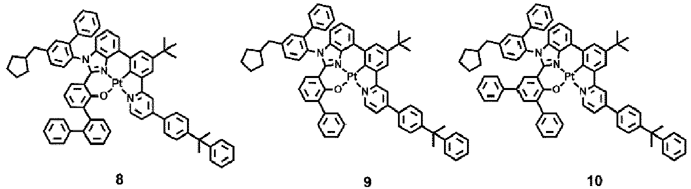

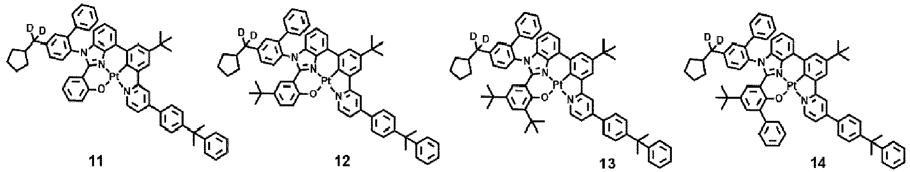

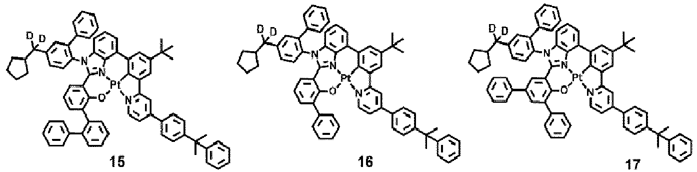

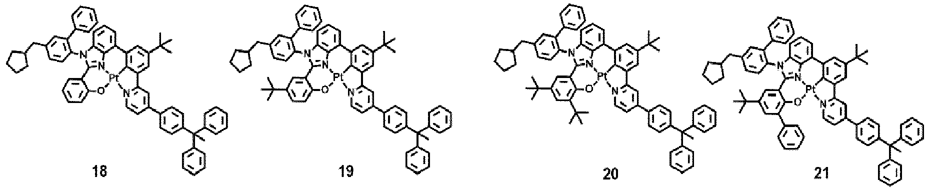

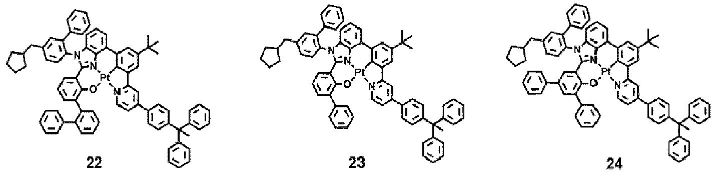

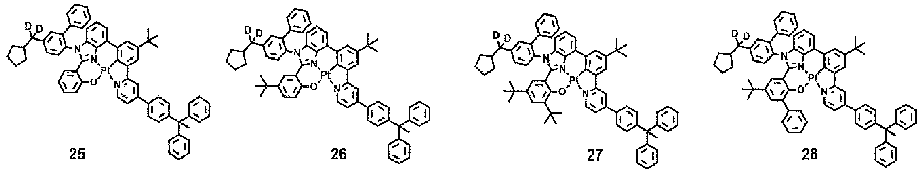

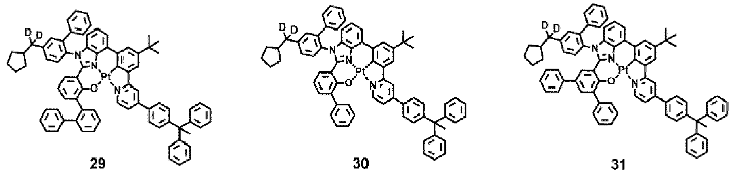

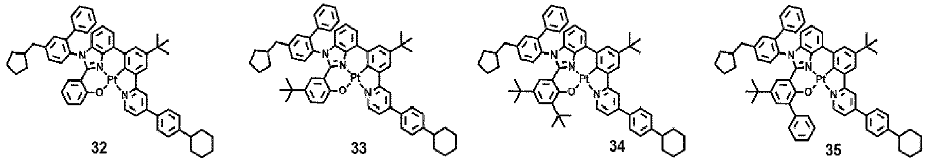

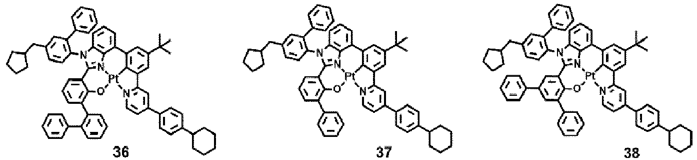

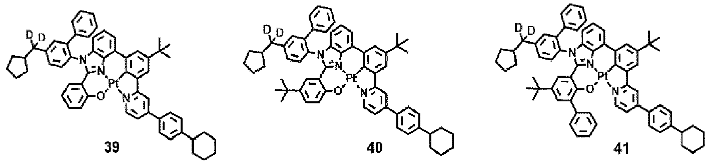

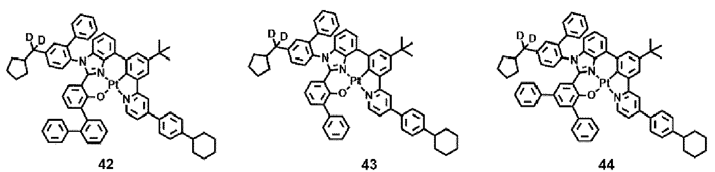

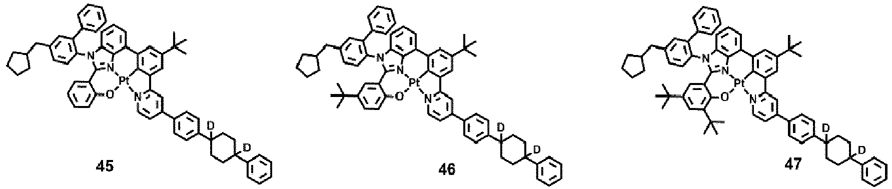

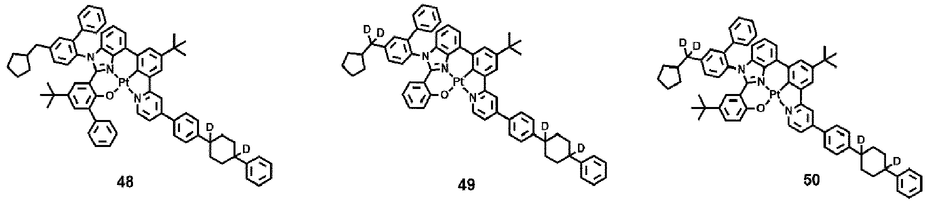

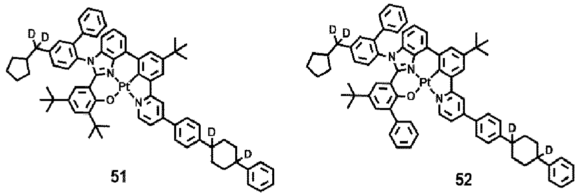

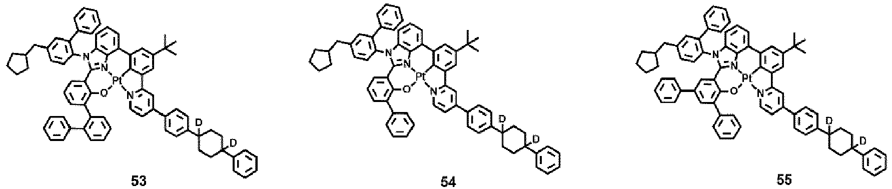

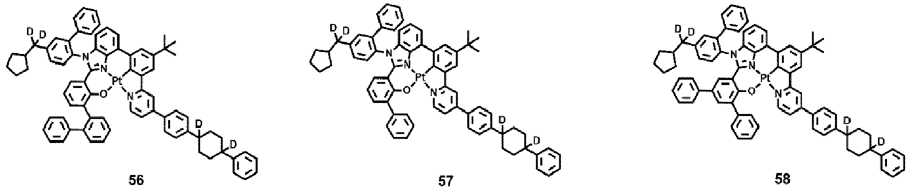

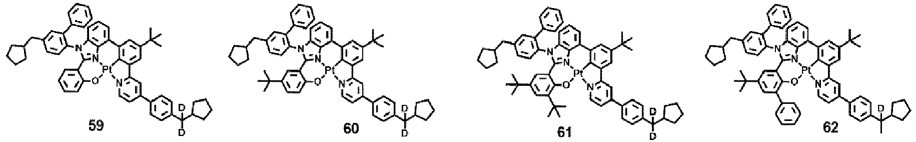

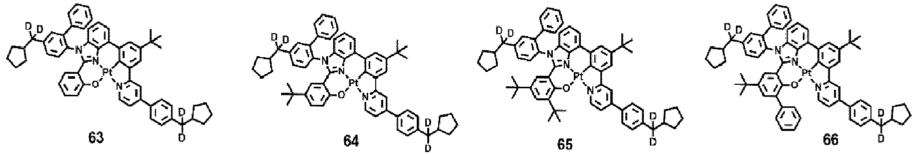

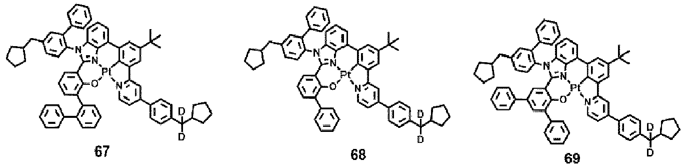

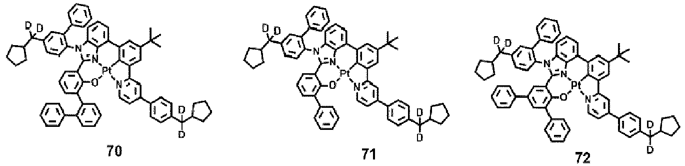

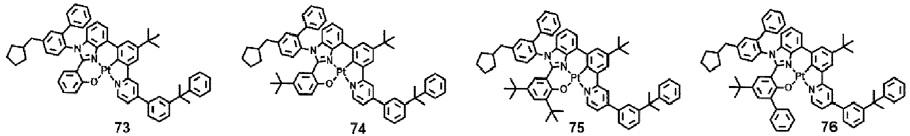

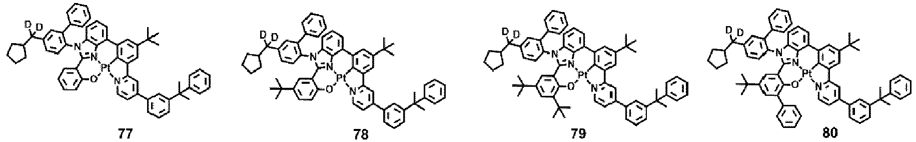

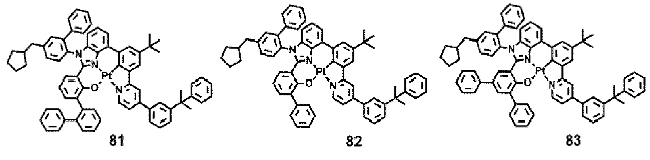

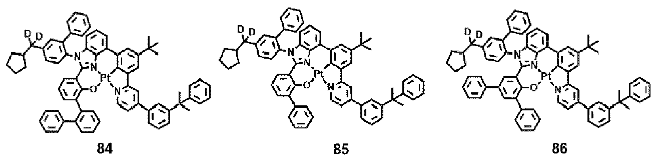

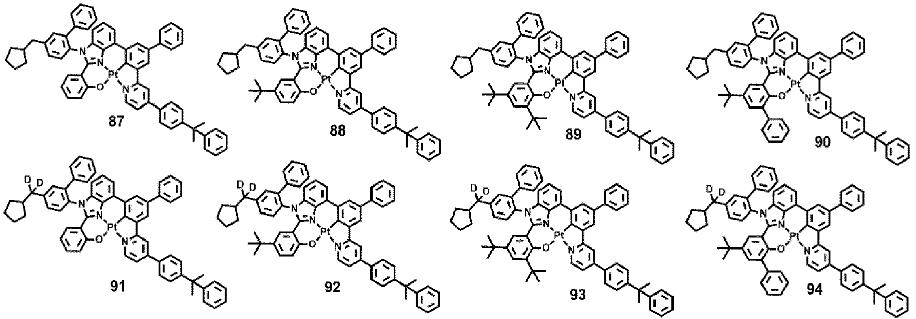

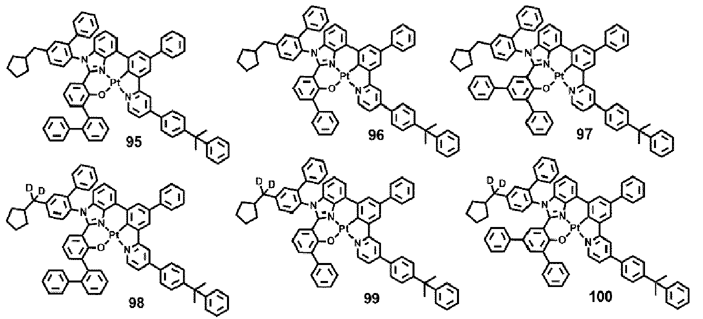

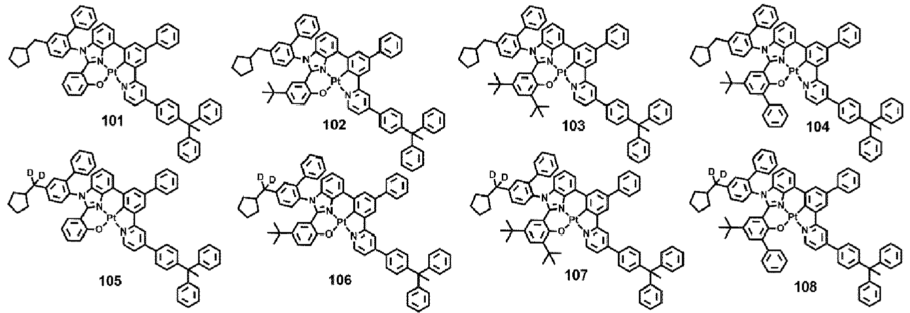

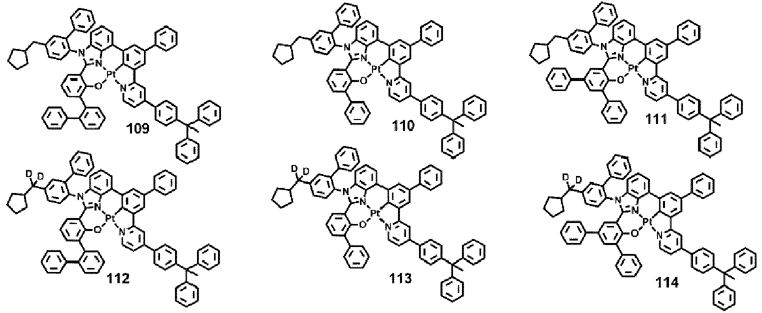

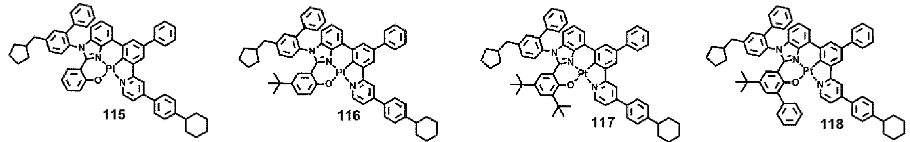

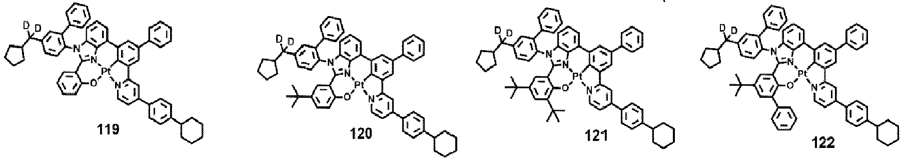

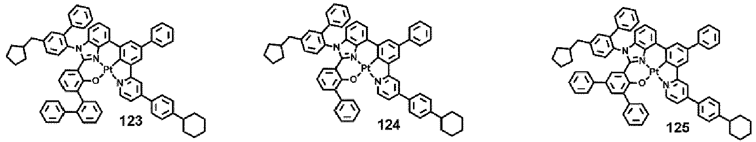

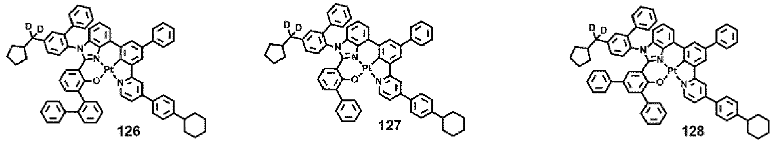

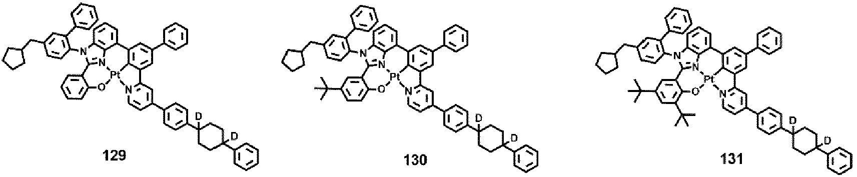

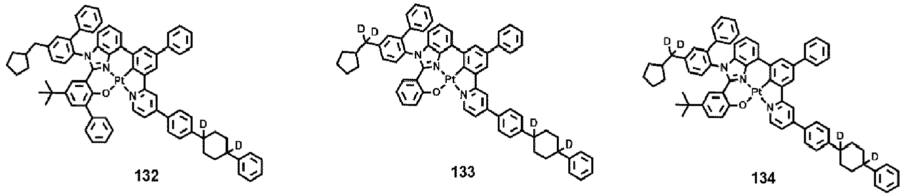

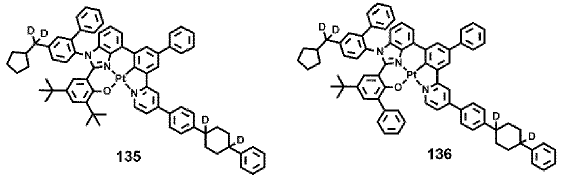

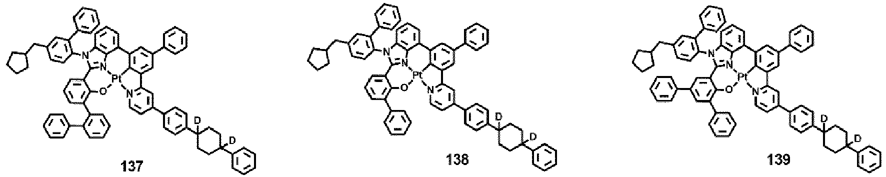

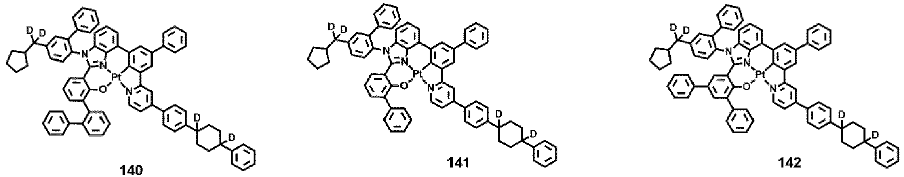

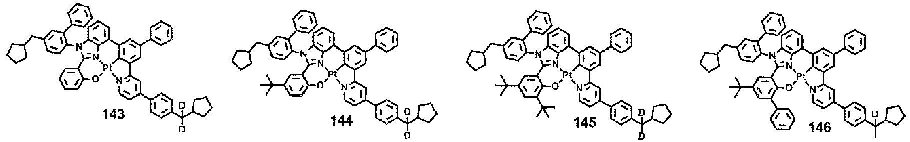

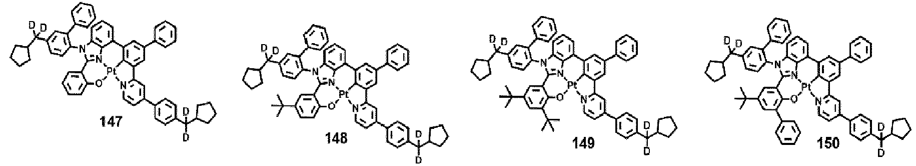

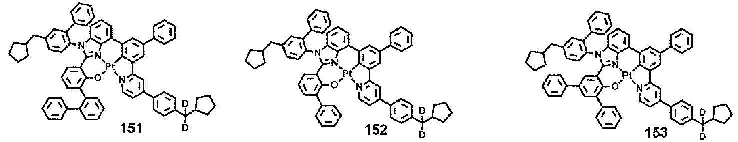

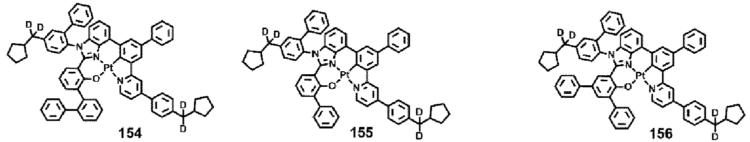

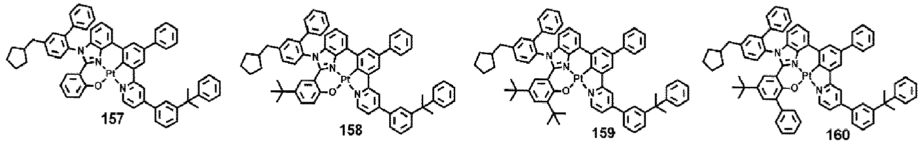

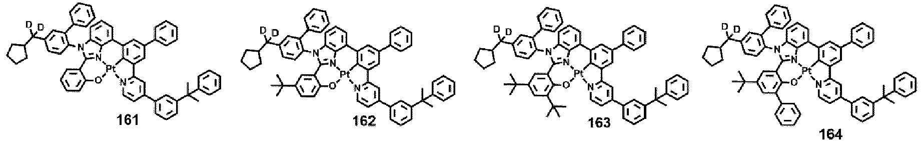

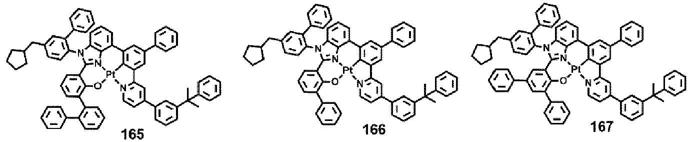

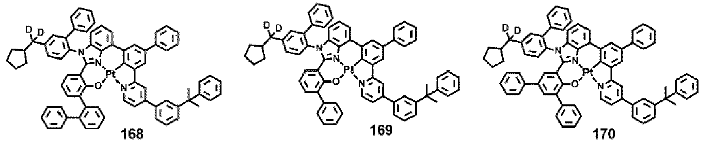

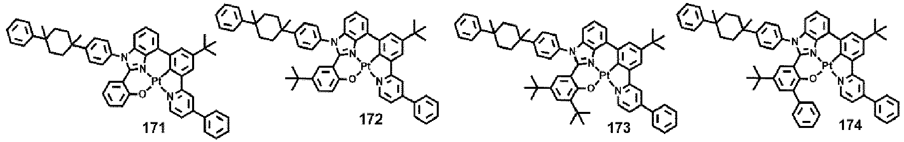

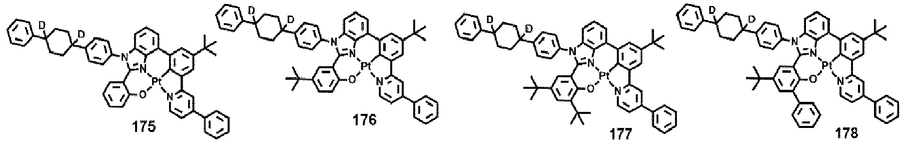

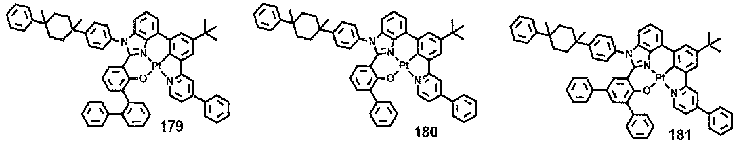

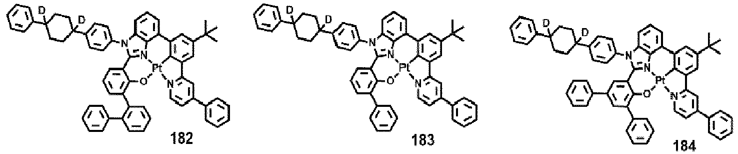

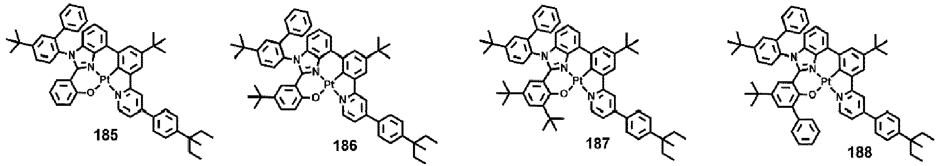

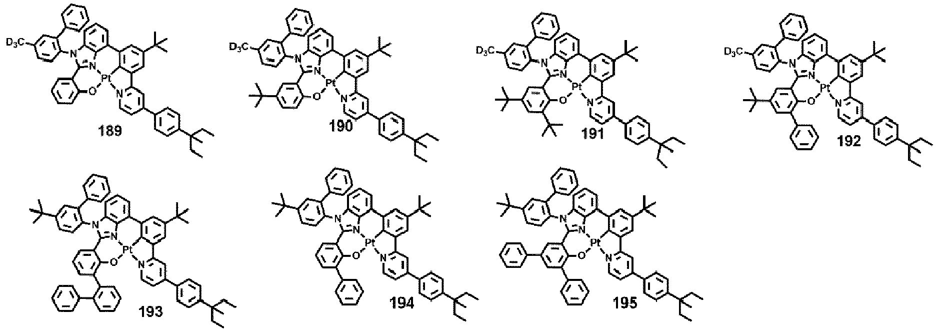

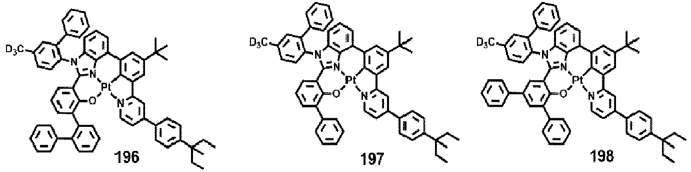

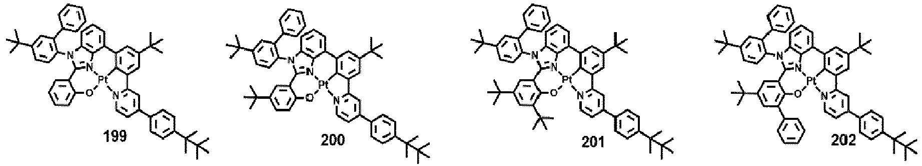

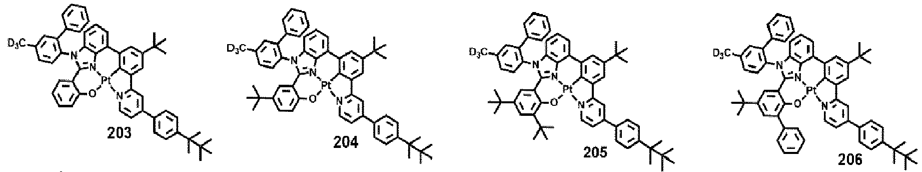

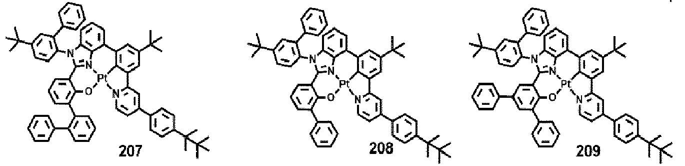

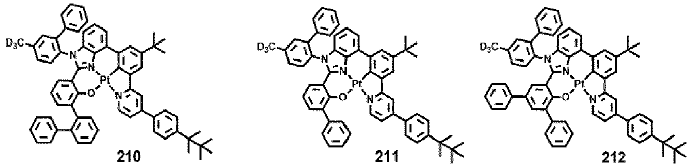

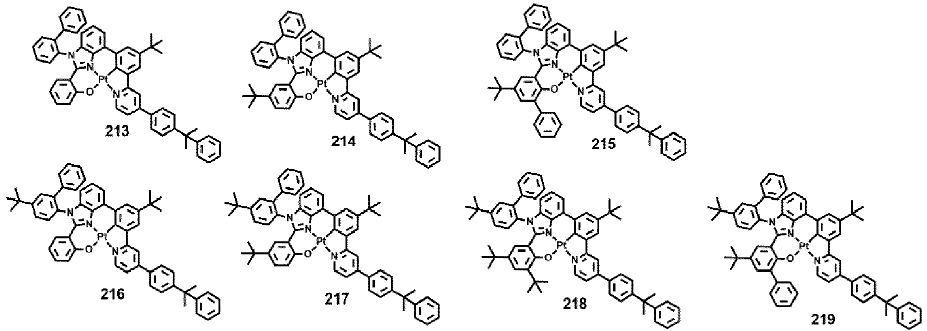

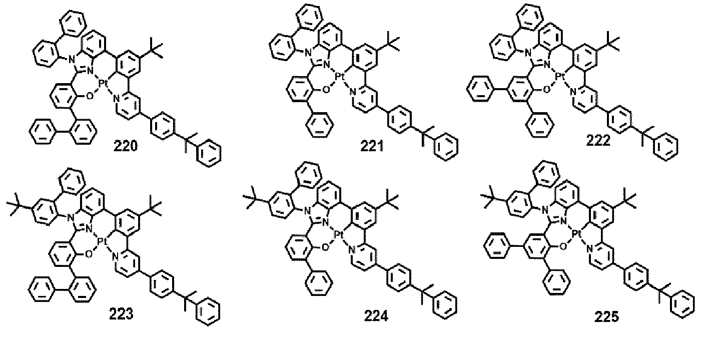

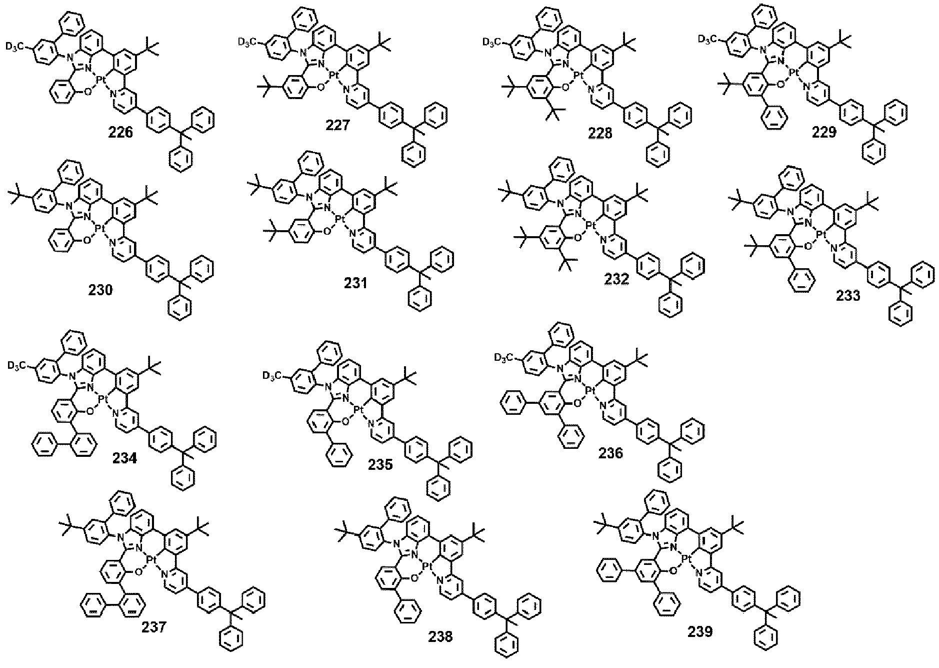

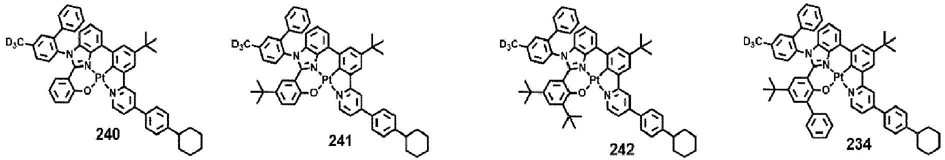

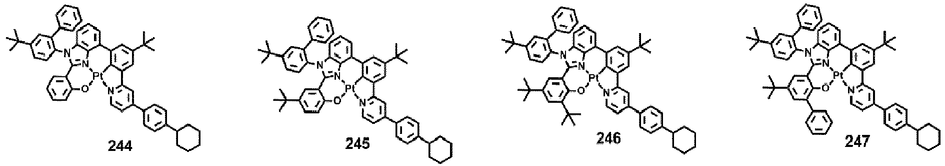

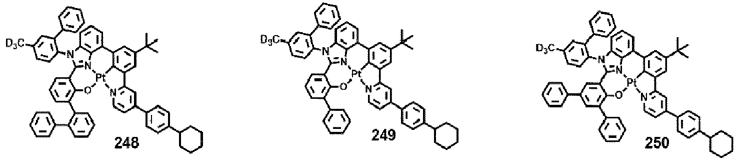

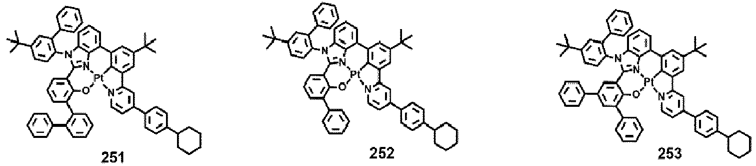

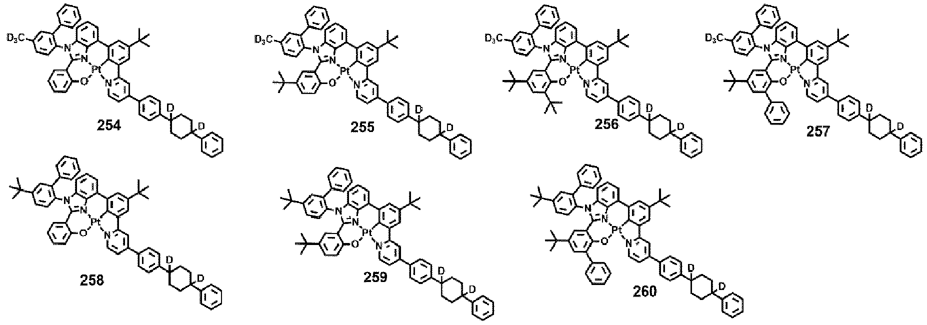

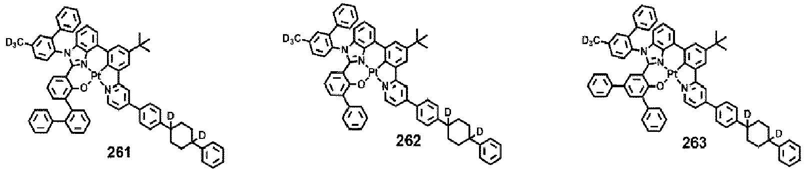

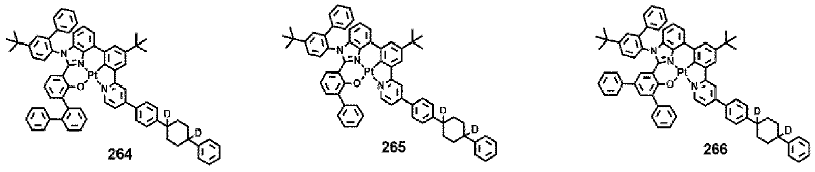

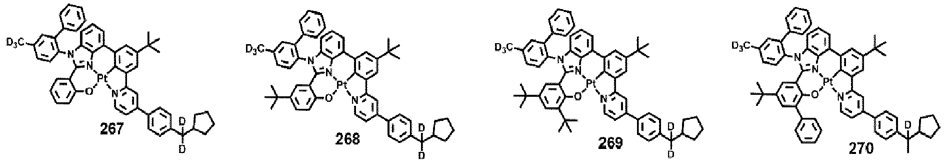

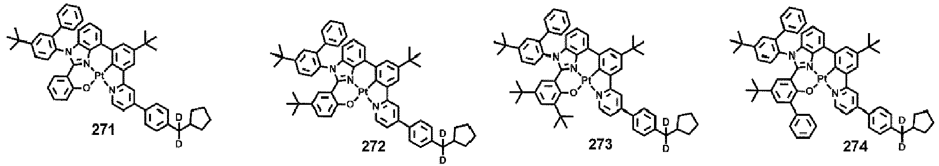

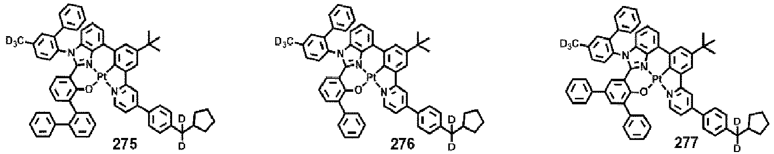

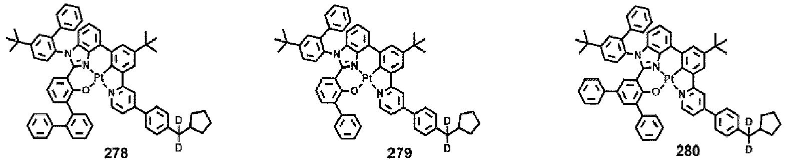

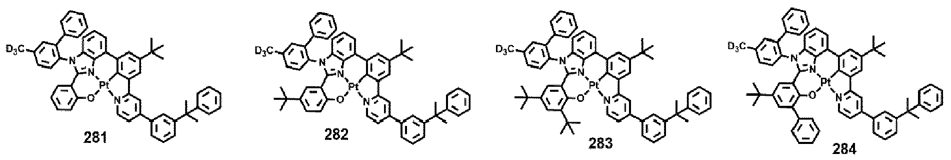

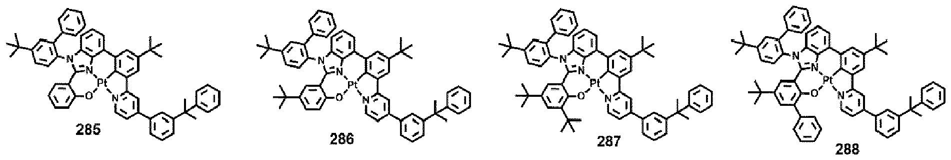

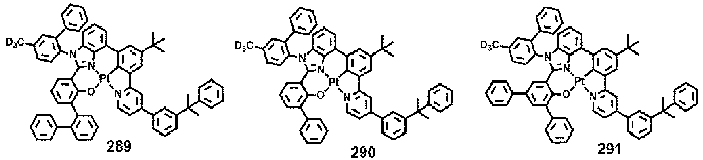

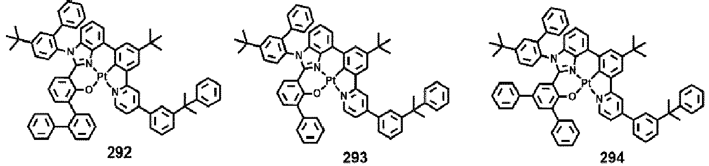

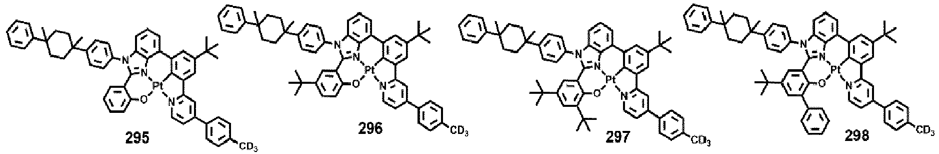

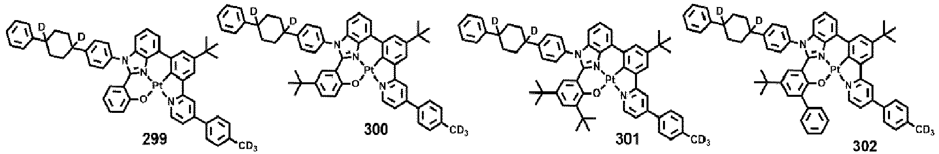

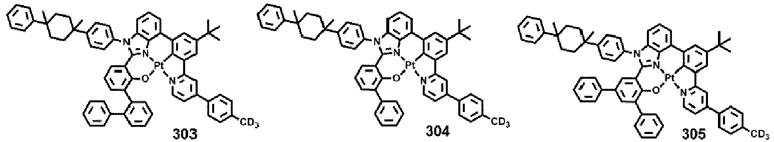

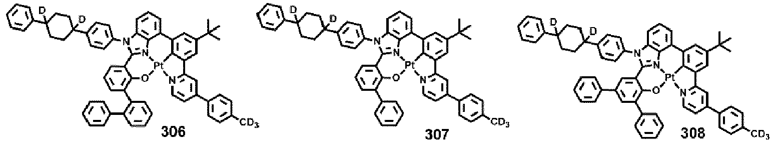

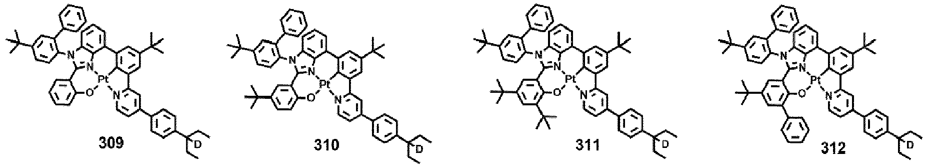

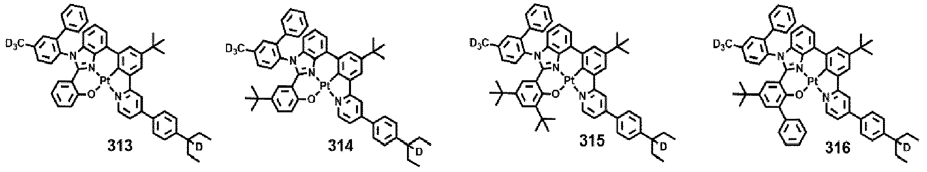

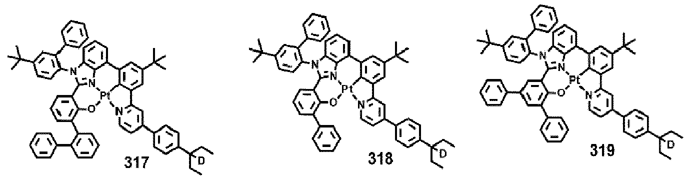

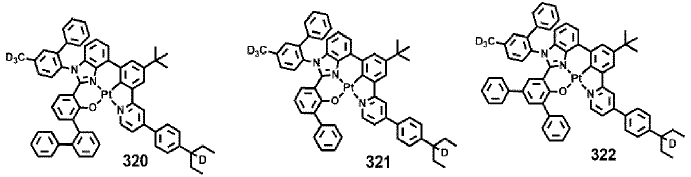

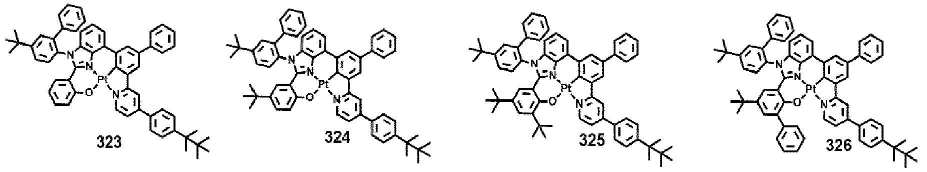

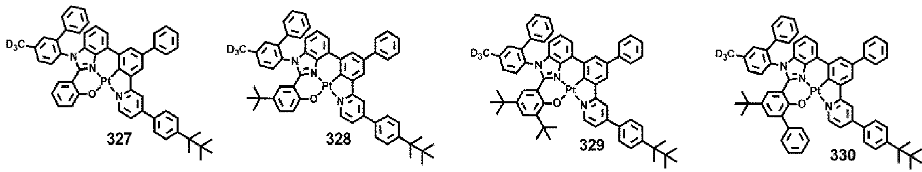

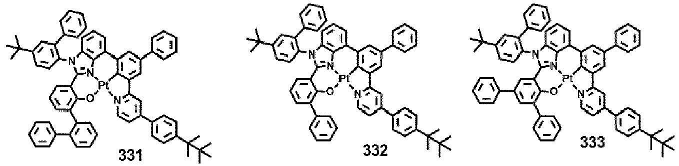

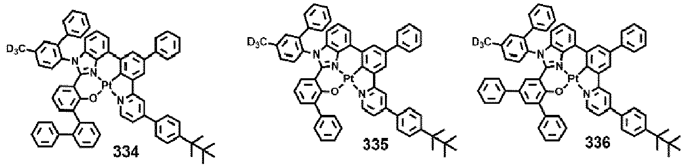

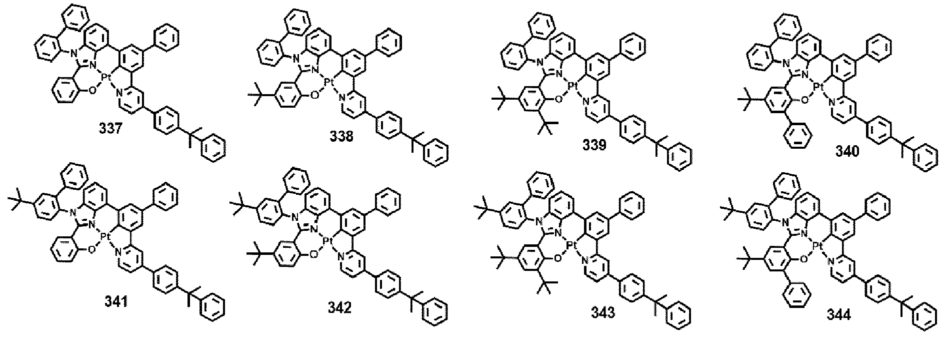

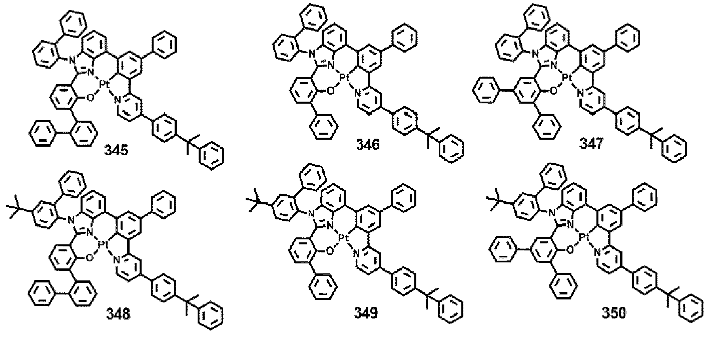

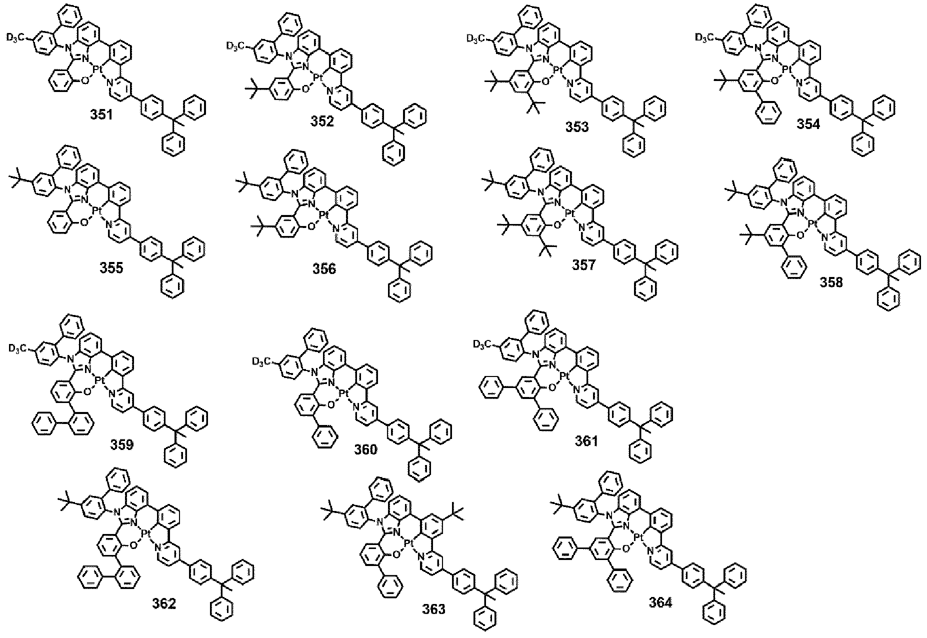

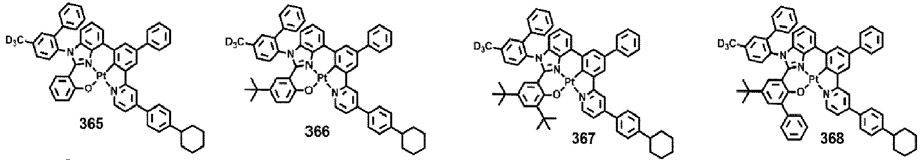

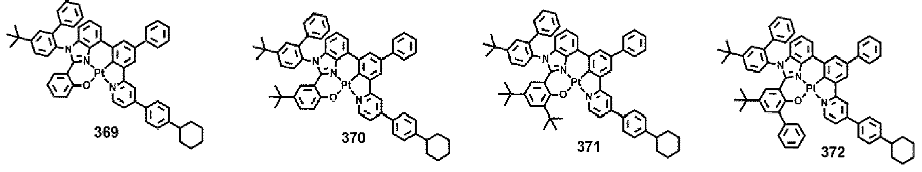

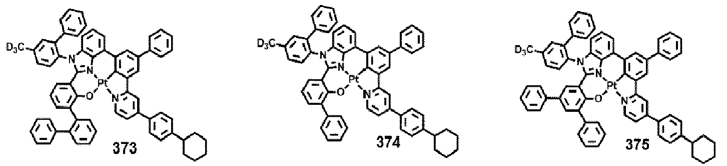

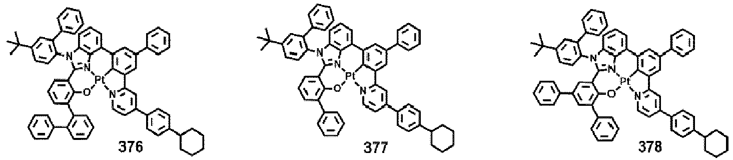

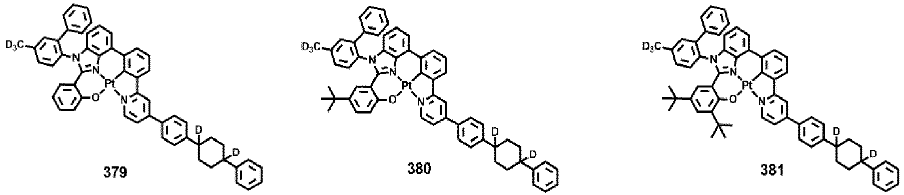

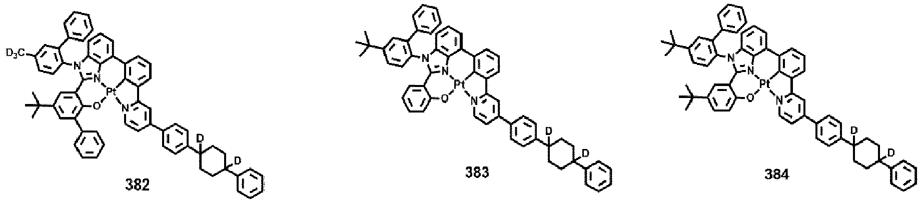

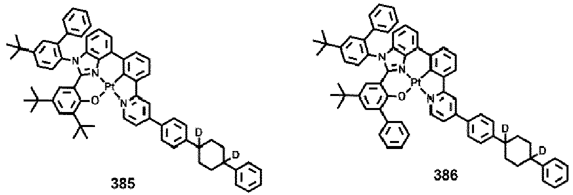

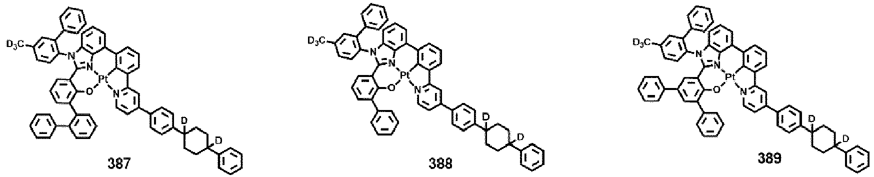

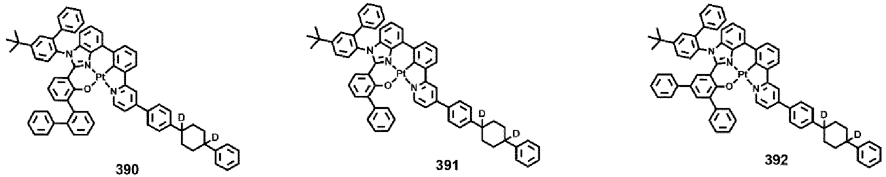

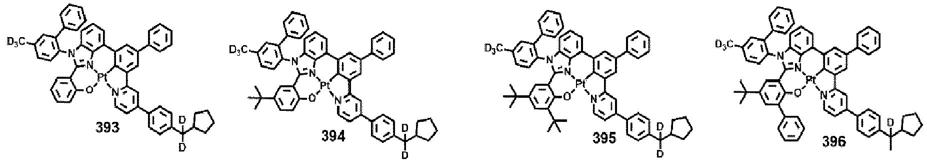

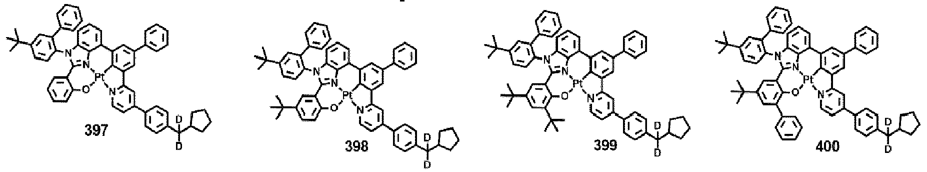

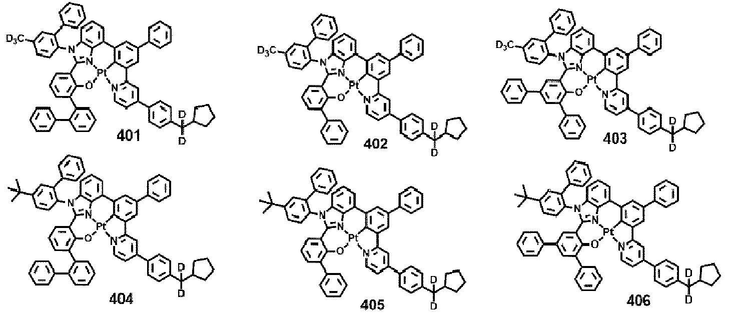

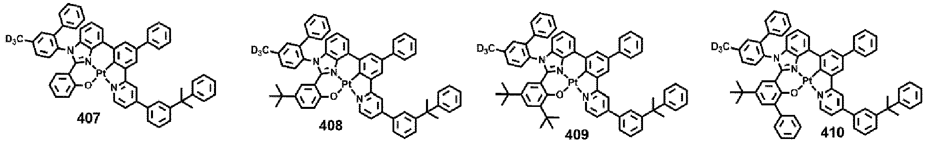

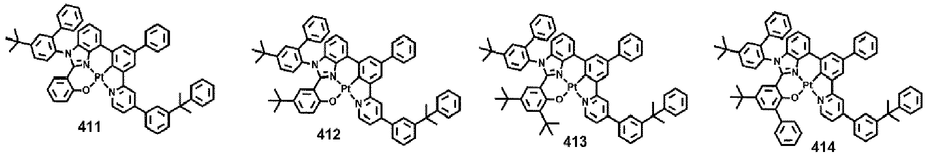

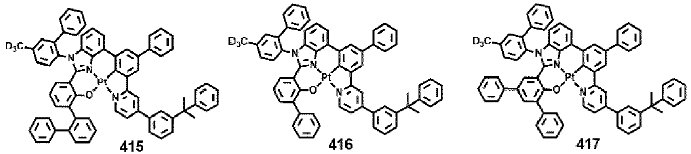

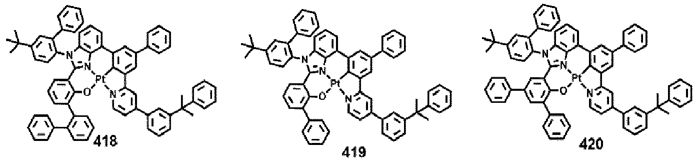

The organometallic compound represented by Formula 1-1 may have excellent electrical characteristics and thermal stability. Thus, an organic light-emitting device having a high luminescence efficiency may be manufactured.

A method of synthesizing the organometallic compound may be apparent to one of ordinary skill in the art by referring to Synthesis Examples provided herein.

Accordingly, the organometallic compound may be suitable for use in an organic layer of an organic light-emitting device, e.g., as a dopant in the organic layer. Thus, according to another aspect, there is provided an organic light-emitting device that may include a first electrode; a second electrode; and an organic layer between the first electrode and the second electrode and including an emission layer, wherein the organic layer may include at least one organometallic compound represented by Formula 1-1.

The organic light-emitting device may include an organic layer including the organometallic compound. Thus, the organic light-emitting device may have excellent driving voltage, excellent luminescence efficiency and external quantum efficiency characteristics.

The organometallic compound may be used in a pair of electrodes of an organic light-emitting device. In some embodiments, the organometallic compound may be included in an emission layer. In this embodiment, the organometallic compound may serve as a dopant, and the emission layer may further include a host (that is, an amount of the organometallic compound may be smaller than that of the host in the emission layer). The emission layer may emit red light or green light, e.g., red light or green light having a maximum emission wavelength of about 500 nanometers (nm) or longer, e.g., about 500 nm to about 650 nm.

In some embodiments, the emission layer may emit green light.

As used herein, the expression the "(organic layer) includes at least one organometallic compound" may be construed as meaning the "(organic layer) may include one organometallic compound of Formula 1-1 or two different organometallic compounds of Formula 1-1".

For example, Compound 1 may only be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode may be an anode, which is a hole injection electrode, and the second electrode may be a cathode, which is an electron injection electrode. In some embodiments, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single and/or a plurality of layers between the first electrode and the second electrode in an organic light-emitting device. The "organic layer" may include not only organic compounds but also organometallic complexes including metals.

The FIGURE illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

### First electrode 11 in organic light-emitting device 10

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO.

The organic layer 15 may be on the first electrode 11.

### Organic layer 15 in organic light-emitting device 10

The organic layer 15 may include a hole transport region, an emission layer, and an electron transport region.

### Hole transport region in organic layer 15

The hole transport region may be between the first electrode 11 and the emission layer.

The hole transport region may include a hole injection layer, a hole transport layer, an electron blocking layer, a buffer layer, or a combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum-deposition, for example, the vacuum deposition may be performed at a temperature in a range of about 100°C to about 500°C, at a vacuum degree in a range of about 10⁻⁸ torr to about 10⁻³ torr, and at a rate in a range of about 0.01 Angstroms per second (Å/sec) to about 100 Å/sec, though the conditions may vary depending on a compound used as a hole injection material and a structure and thermal properties of a desired hole injection layer.

When a hole injection layer is formed by spin coating, the spin coating may be performed at a rate in a range of about 2,000 revolutions per minute (rpm) to about 5,000 rpm and at a temperature in a range of about 80°C to 200°C to facilitate removal of a solvent after the spin coating, though the conditions may vary depending on a compound used as a hole injection material and a structure and thermal properties of a desired hole injection layer.

The conditions for forming a hole transport layer and an electron blocking layer may be inferred from the conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or any combination thereof: 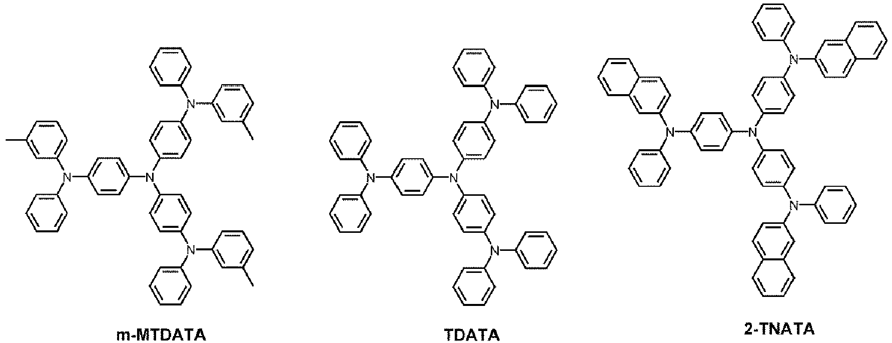 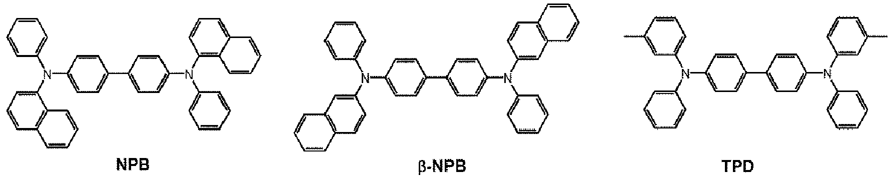 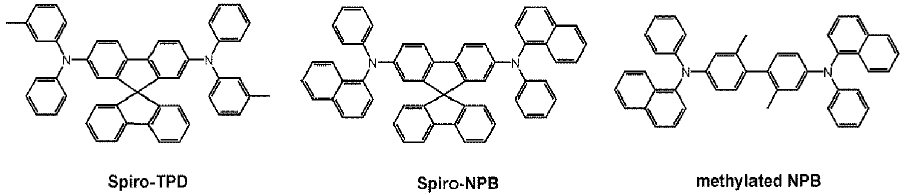 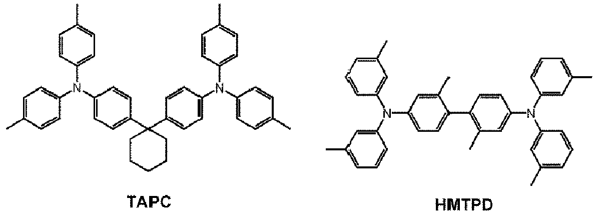 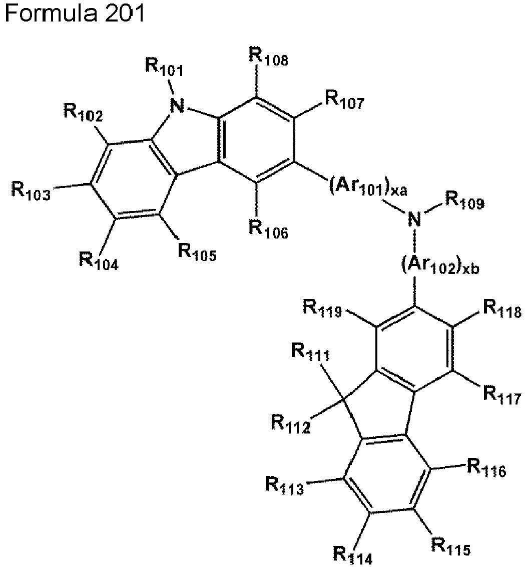 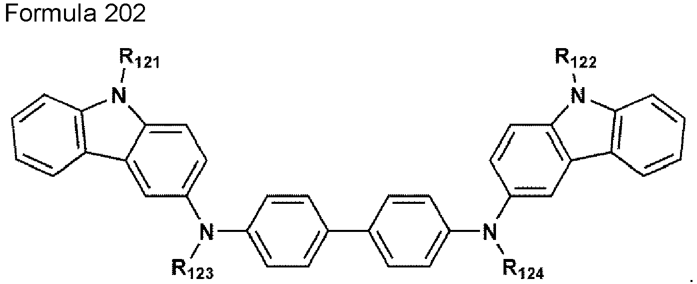 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5. In some embodiments, xa and xb may each independently be an integer from 0 to 2. In some embodiments, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, or a hexyl group), or a C₁-C₁₀ alkoxy group (e.g., a methoxy group, an ethoxy group, a propoxy group, a butoxy group, or a pentoxy group);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In some embodiments, the compound represented by Formula 201 may be represented by Formula 201A: 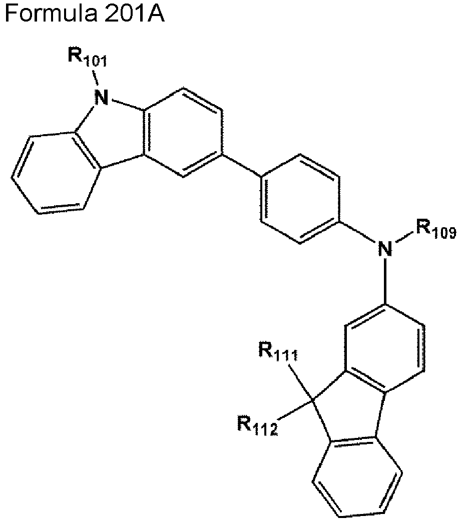 wherein, in Formula 201A, R₁₀₁, R₁₁₁, R₁₁₂, and R₁₀₉ may respectively be understood by referring to the descriptions of R₁₀₁, R₁₁₁, R₁₁₂, and R₁₀₉ provided herein. In some embodiments, the hole transport region may include one of Compounds HT1 to HT21 or any combination thereof:

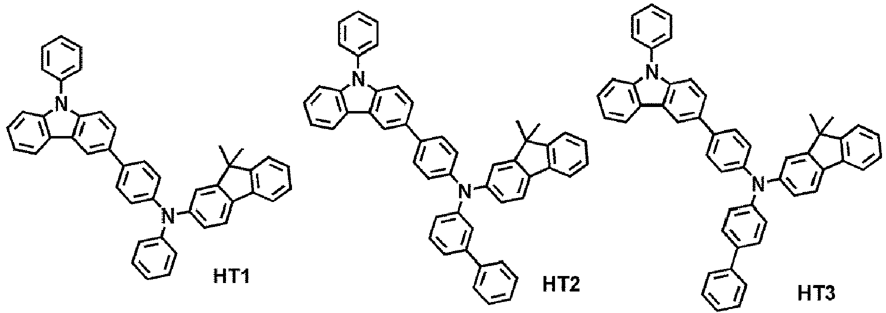

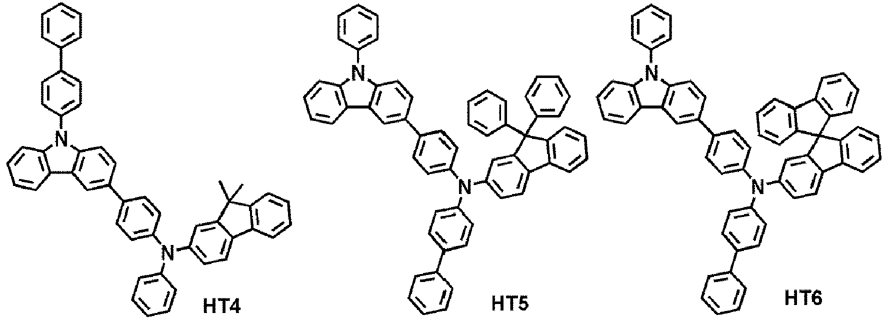

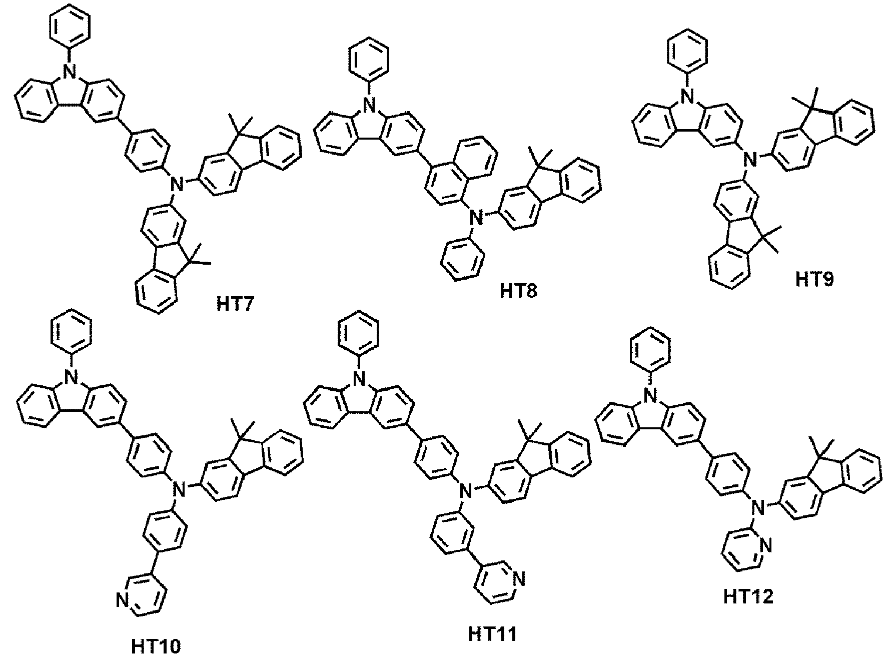

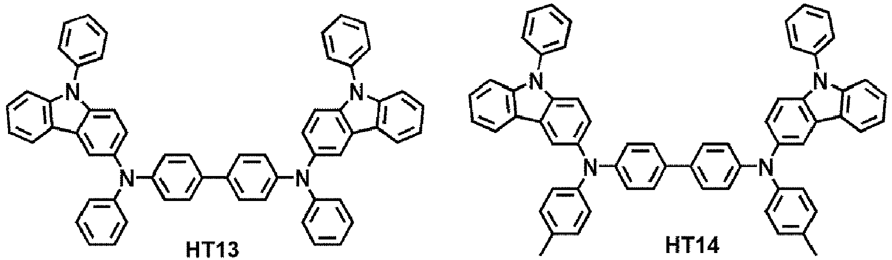

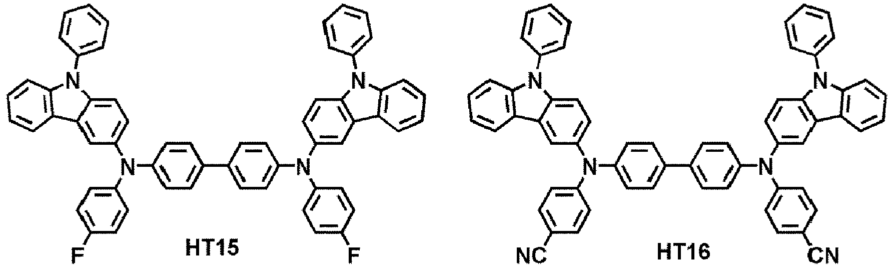

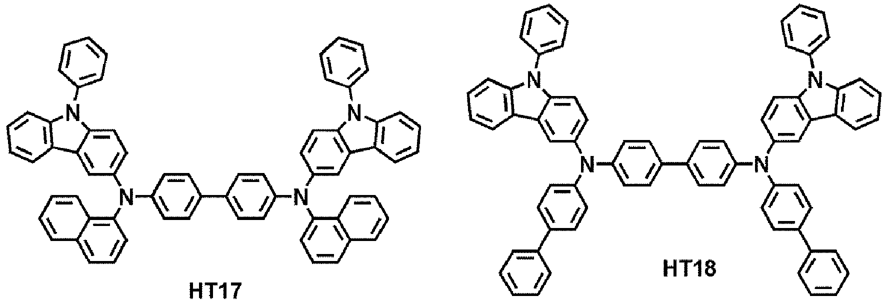

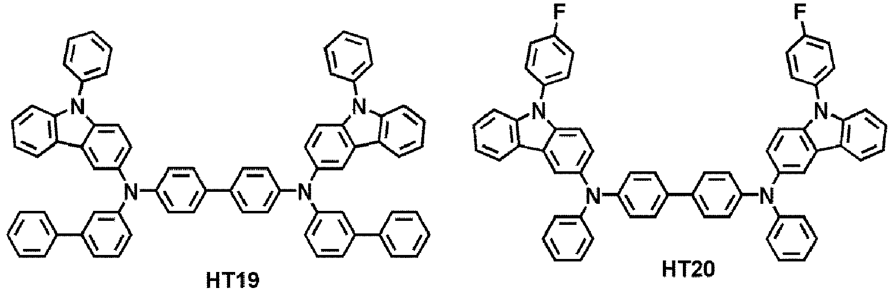

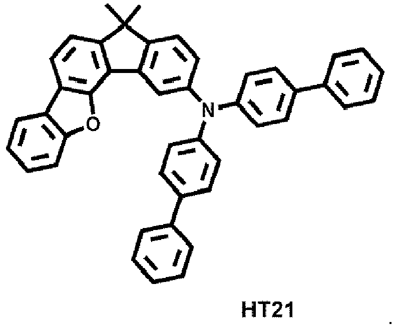

The thickness of the hole transport region may be in a range of about 100 Angstroms (Å) to about 10,000 Å, for example, about 100 Å to about 3,000 Å. When the hole transport region includes a hole injection layer, a hole transport layer, an electron blocking layer, or any combination thereof, the thickness of the hole injection layer may be in a range of about 50 Å to about 10,000 Å, for example, about 100 Å to about 1,000 Å, the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may be a quinone derivative, a metal oxide, a compound containing a cyano group, or any combination thereof. In some embodiments, the p-dopant may be a quinone derivative, such as tetracyanoquinodimethane (TCNQ), a 2,3,5,6-tetrafluoro-tetracyano-1,4-benzoquinonedimethane (F4-TCNQ), or F6-TCNNQ; a metal oxide, such as a tungsten oxide or a molybdenum oxide; a compound containing a cyano group, such as Compound HT-D1; or any combination thereof:

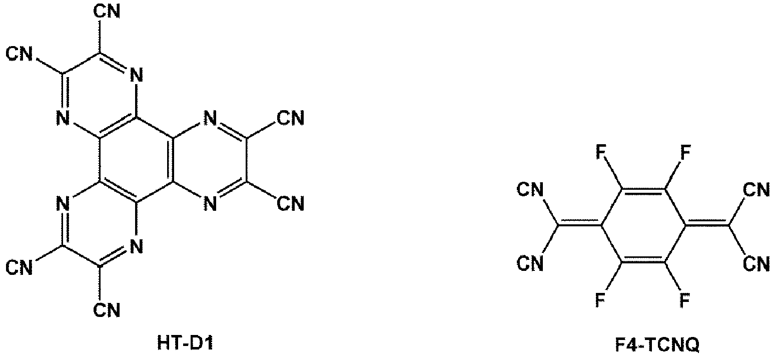

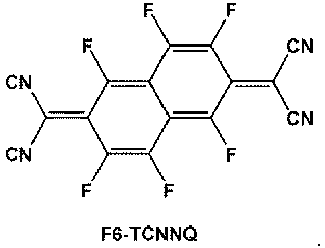

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein or any combination thereof. In some embodiments, when the hole transport region includes an electron blocking layer, mCP described herein, Compound H21, H-H1, or any combination thereof may be used for forming the electron blocking layer.

### Emission layer in organic layer 15

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The emission layer may include a host and a dopant, and the dopant may include the organometallic compound represented by Formula 1-1 described herein.

### Host in emission layer

The host may include TPBi, TBADN, ADN (also known as "DNA"), CBP, CDBP, TCP, mCP, Compound H50, Compound H51, Compound H52, or any combination thereof:

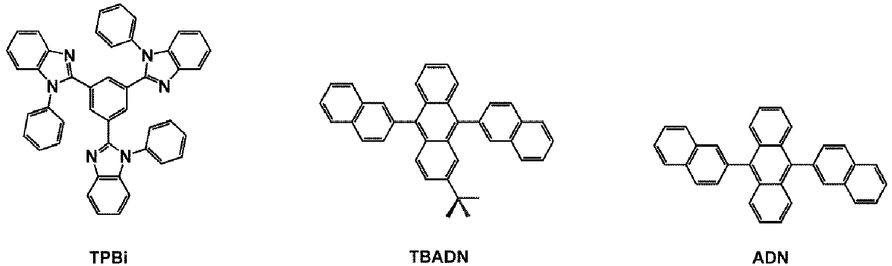

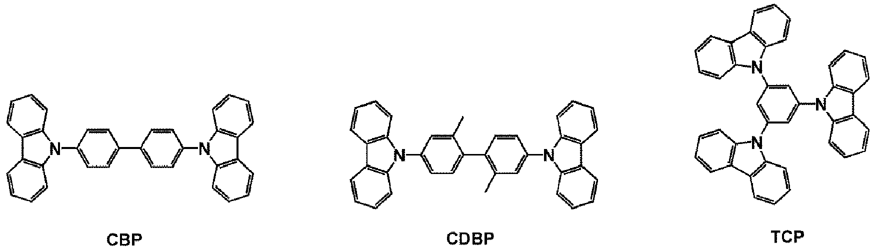

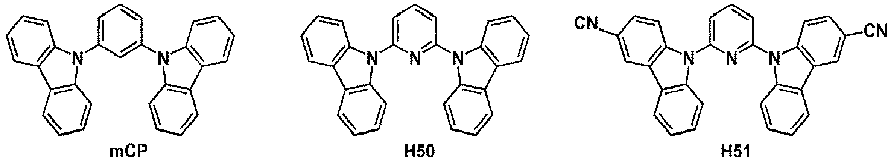

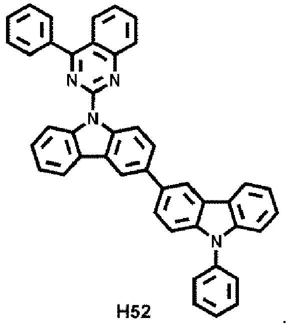

The host may consist of one type of compound or a mixture of at least two different kinds of compounds.

In an embodiment, the host may include an electron transporting host including at least one electron transporting moiety, a hole transporting host not including an electron transporting moiety, or any combination thereof.

The electron transporting moiety may include a cyano group, a π electron-depleted nitrogen-containing cyclic group, a group represented by one of following Formulae, or any combination thereof: 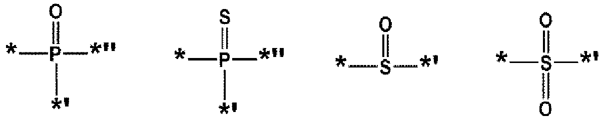 wherein, in the Formulae above, *, *', and *" may each indicate a binding site to an adjacent atom.

For example, the electron transporting host may include at least one π electron-rich cyclic group and at least one electron transporting moiety.

In some embodiments, the hole transporting host may include at least one π electron-rich cyclic group and not include an electron transporting moiety.

In one or more embodiments, the host may include an electron transporting host and a hole transporting host, and the electron transporting host may be different from the hole transporting host.

The term "π electron-depleted nitrogen-containing cyclic group" as used herein refers to a cyclic group having at least one *-N=*' moiety. Examples thereof may include an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group.

The π electron-rich cyclic group refers to a cyclic group not including a *-N=*' moiety. Examples thereof may include a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group.

According to another embodiment, the electron transporting host may include a compound represented by Formula E-1.

In one or more embodiments, the hole transporting host may include a compound represented by Formula H-1.

Formula E-1 [Ar₃₀₁ ]_{xb11}-[(L₃₀₁)_{xb1}-R₃₀₁]_{xb21}

wherein, in Formula E-1,

Ar₃₀₁ may be a C₅-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
L₃₀₁ may each independently be a single bond, a group represented by one of the Formulae below, a C₅-C₆₀ carbocyclic group unsubstituted or substituted with at least one R₁₀ₐ or a C₁-C₆₀ heterocyclic group unsubstituted or substituted with at least one R₁₀ₐ, wherein in Formulae, *, *', and *" each indicate a binding site to an adjacent atom, 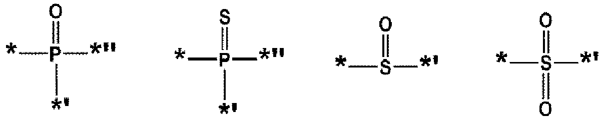 xb1 may be an integer from 1 to 5,
R₃₀₁ may be hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C1-C₆₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂),-B(Q₃₀₁)(Q₃₀₂), -C(=O)(Q₃₀₁), -S(=O)₂(Q₃₀₁), -S(=O)(Q₃₀₁), -P(=O)(Q₃₀₁)(Q₃₀₂), or-P(=S)(Q₃₀₁)(Q₃₀₂),
xb21 may be an integer from 1 to 5,
wherein Q₃₀₁ to Q₃₀₃ may each independently be a C₁-C₁₀ alkyl group, a C₁-C₁₀ alkoxy group, a phenyl group, a biphenyl group, a terphenyl group, or a naphthyl group,
R₁₀ₐ may be understood by referring to the description of T₁₁ provided herein, and
at least one of Conditions 1 to 3 may be satisfied:
Condition 1
   at least one of Ar₃₀₁, L₃₀₁, and R₃₀₁ in Formula E-1 may each independently include a π electron-depleted nitrogen-containing cyclic group,
Condition 2
   L₃₀₁ in Formula E-1 may be a group represented by one of the following Formulae: 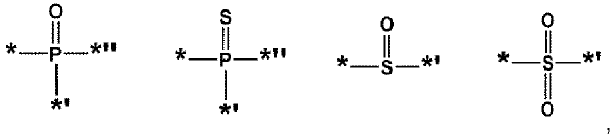 and
Condition 3
   R₃₀₁ in Formula E-1 may be a cyano group, -S(=O)₂(Q₃₀₁), -S(=O)(Q₃₀₁), - P(=O)(Q₃₀₁)(Q₃₀₂), or -P(=S)(Q₃₀₁)(Q₃₀₂).

   Formula H-1 Ar₄₀₁-(L₄₀₁)_{xd1}-(Ar₄₀₂)_{xd11}

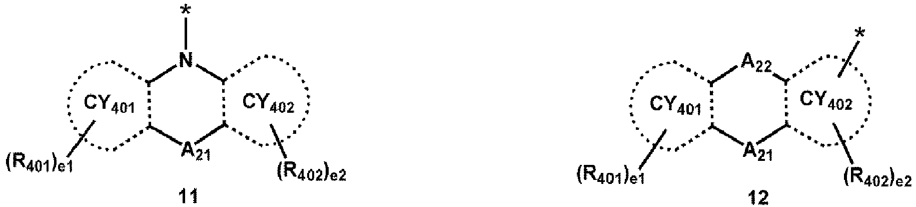

   wherein, in Formulae H-1, 11, and 12,
   L₄₀₁ may be:
   a single bond; or
   a π electron-rich cyclic group (e.g., a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group) unsubstituted or substituted with deuterium, a C₁-C₁₀ alkyl group, a C₁-C₁₀ alkoxy group, a π electron-rich cyclic group (e.g., a phenyl group, a naphthyl group, a fluorenyl group, a carbazolyl group, a dibenzofuranyl group, a dibenzothiophenyl group, a triphenylenyl group, a biphenyl group, a terphenyl group, or a tetraphenyl group (or, quaterphenyl)), - Si(Q₄₀₁)(Q₄₀₂)(Q₄₀₃), or any combination thereof,
   xd1 may be an integer from 1 to 10, and when xd1 is 2 or greater, at least two L₄₀₁(s) may be identical to or different from each other,
   Ar₄₀₁ may be a group represented by Formula 11 or a group represented by Formula 12,
   Ar₄₀₂ may be:
      a group represented by Formula 11 or a group represented by Formula 12; or
      a π electron-rich cyclic group (e.g., a phenyl group, a naphthyl group, a fluorenyl group, a carbazolyl group, a dibenzofuranyl group, a dibenzothiophenyl group, a biphenyl group, a terphenyl group, or a triphenylenyl group) unsubstituted or substituted with deuterium, a C₁-C₂₀ alkyl group, a C₁-C₂₀ alkoxy group, a π electron-rich cyclic group (e.g., a phenyl group, a naphthyl group, a fluorenyl group, a carbazolyl group, a dibenzofuranyl group, a dibenzothiophenyl group, a biphenyl group, a terphenyl group, or a triphenylenyl group), or any combination thereof,
      xd11 may be an integer from 0 to 10 (for example, an integer from 1 to 10), and when xd11 is 2 or greater, at least two Ar₄₀₂(s) may be identical to or different from each other,
      CY₄₀₁ and CY₄₀₂ may each independently be a π electron-rich cyclic group (e.g., a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonapthothiophene group, or a benzonaphthosilole group),
      A₂₁ may be a single bond, O, S, N(R₅₁), C(R₅₁)(R₅₂), or Si(R₅₁)(R₅₂),
      A₂₂ may be a single bond, O, S, N(R₅₃), C(R₅₃)(R₅₄), or Si(R₅₃)(R₅₄),
      at least one of A₂₁ and A₂₂ in Formula 12 may not be a single bond,
      R₅₁ to R₅₄ and R₄₀₁ to R₄₀₂ may each independently be:
         hydrogen or deuterium;
         a C₁-C₂₀ alkyl group and a C₁-C₂₀ alkoxy group, each unsubstituted or substituted with deuterium, a π electron-rich cyclic group (e.g., a phenyl group, a naphthyl group, a fluorenyl group, a carbazolyl group, a dibenzofuranyl group, or a dibenzothiophenyl group), or any combination thereof;
         a π electron-rich cyclic group (e.g., a phenyl group, a naphthyl group, a fluorenyl group, a carbazolyl group, a dibenzofuranyl group, a dibenzothiophenyl group, a biphenyl group, a terphenyl group, or a triphenylenyl group) unsubstituted or substituted with deuterium, a C₁-C₂₀ alkyl group, a C₁-C₂₀ alkoxy group, a π electron-rich cyclic group (e.g., a phenyl group, a naphthyl group, a fluorenyl group, a carbazolyl group, a dibenzofuranyl group, a dibenzothiophenyl group, a biphenyl group, a terphenyl group, or a triphenylenyl group), or any combination thereof,
         -Si(Q₄₀₄)(Q₄₀₅)(Q₄₀₆),
         e1 and e2 may each independently be an integer from 0 to 10,
         wherein Q₄₀₁ to Q₄₀₆ may each independently be hydrogen, deuterium, a C₁-C₂₀ alkyl group, a C₁-C₂₀ alkoxy group, or a π electron-rich cyclic group (e.g., a phenyl group, a naphthyl group, a fluorenyl group, a carbazolyl group, a dibenzofuranyl group, a dibenzothiophenyl group, or a biphenyl group), and
         * indicates a binding site to an adjacent atom.

In an embodiment, in Formula E-1, Ar₃₀₁ may be a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, or a dibenzothiophene group, each unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), -P(=O)(Q₃₁)(Q₃₂), or any combination thereof,
at least one of L₃₀₁(s) in the number of xb1 may each independently be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), -P(=O)(Q₃₁)(Q₃₂), or any combination thereof, and
R₃₀₁ may be hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a tetraphenyl group, a naphthyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), or -P(=O)(Q₃₁)(Q₃₂),
wherein Q₃₁ to Q₃₃ may each independently be a C₁-C₁₀ alkyl group, a C₁-C₁₀ alkoxy group, a phenyl group, a biphenyl group, a terphenyl group, or a naphthyl group.

In one or more embodiments, R₃₀₁ may be represented by one of Formulae 7-1 to 7-9:

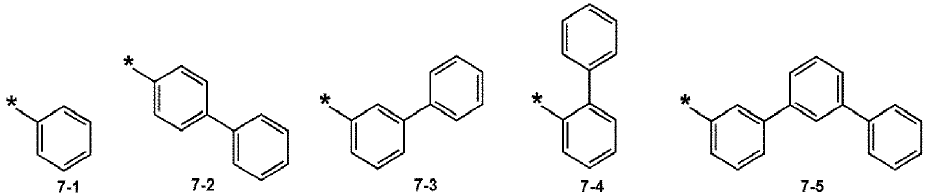

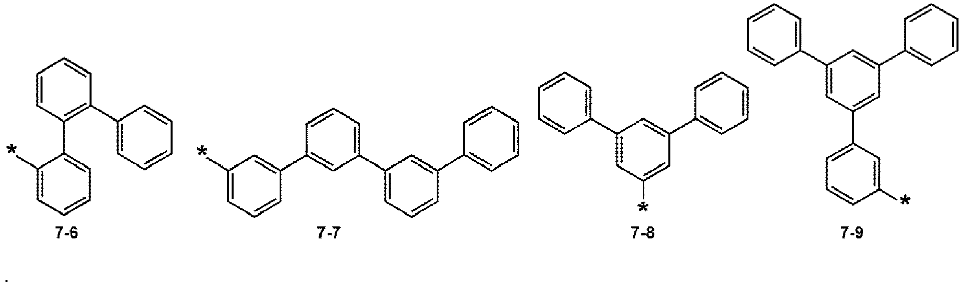

The electron transporting host may be, for example, at least one of Compounds H-E1 to H-E84:

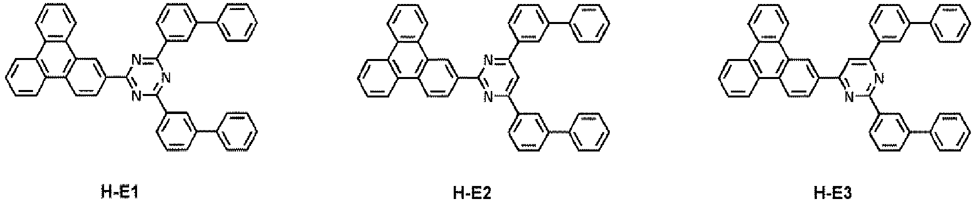

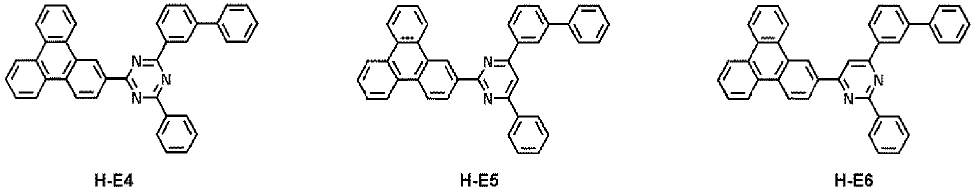

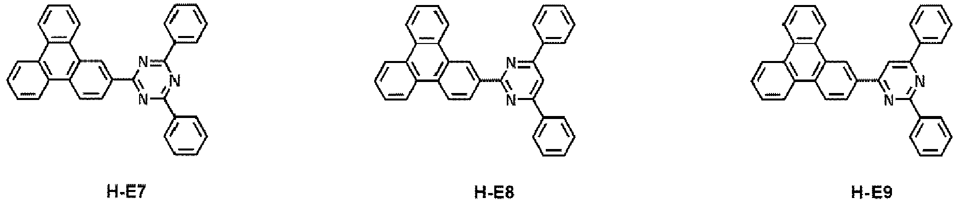

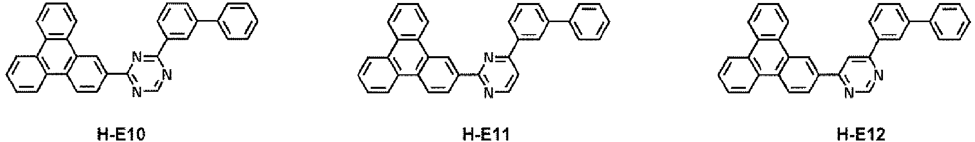

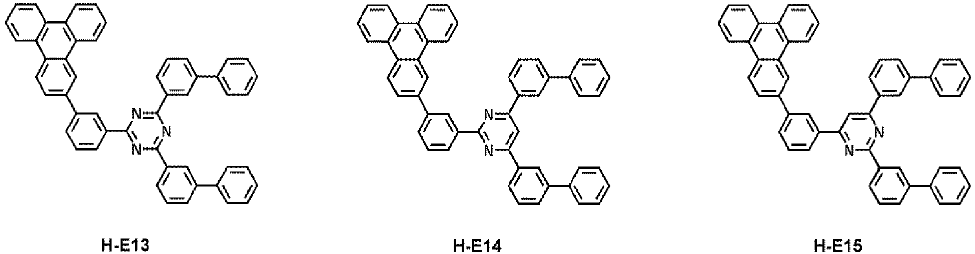

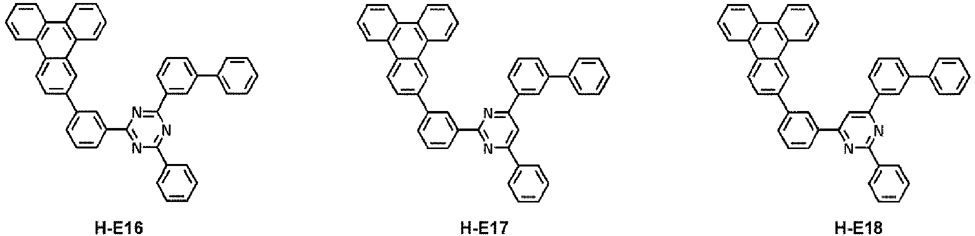

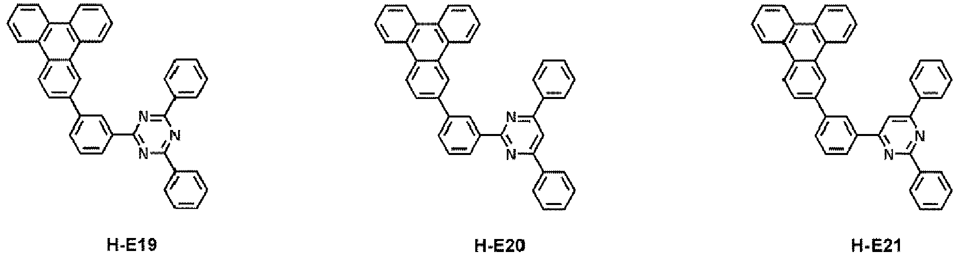

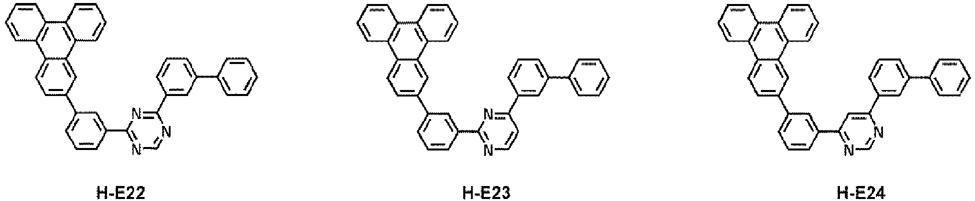

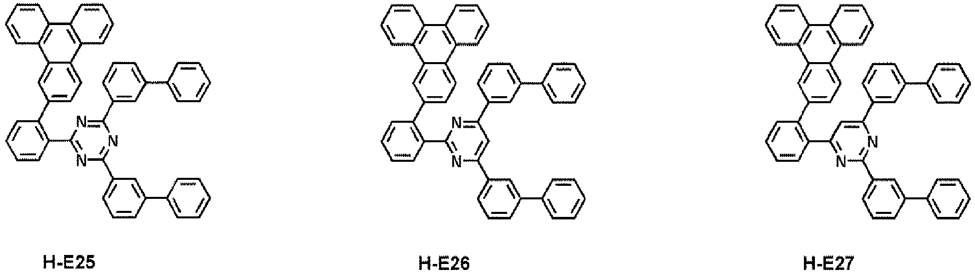

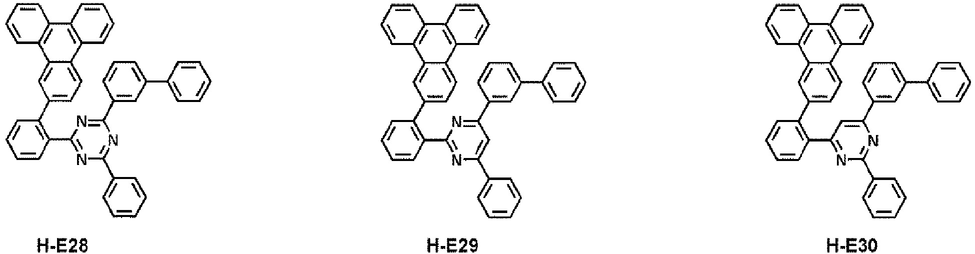

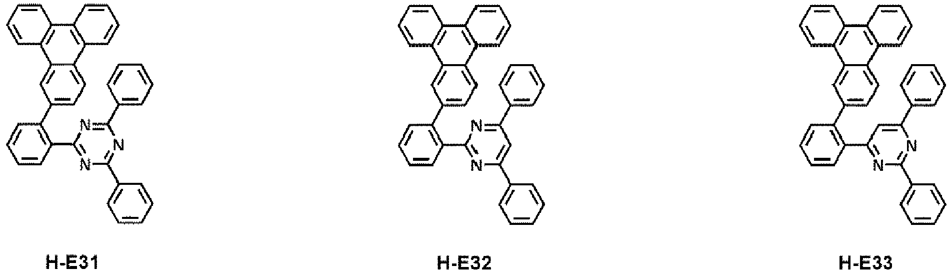

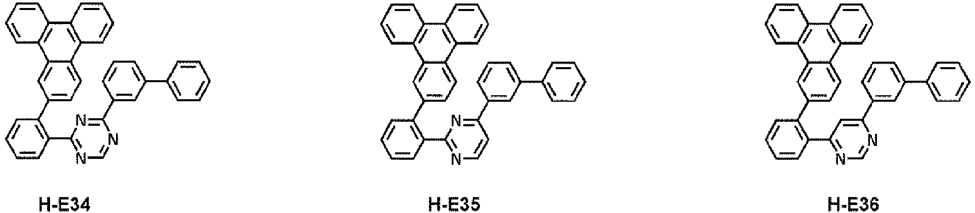

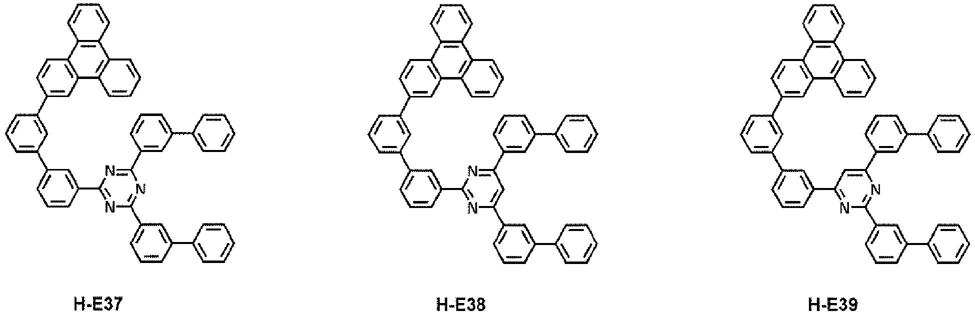

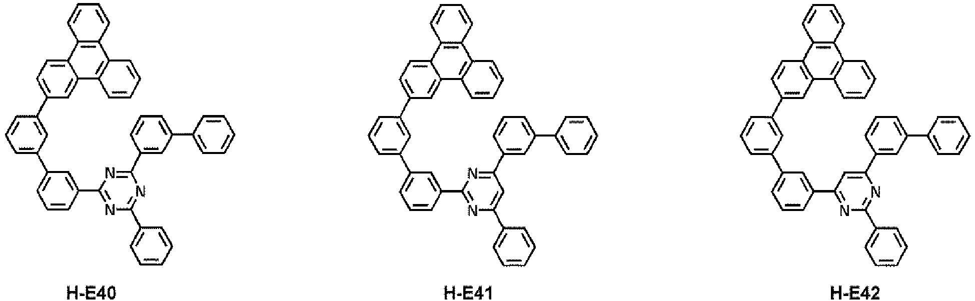

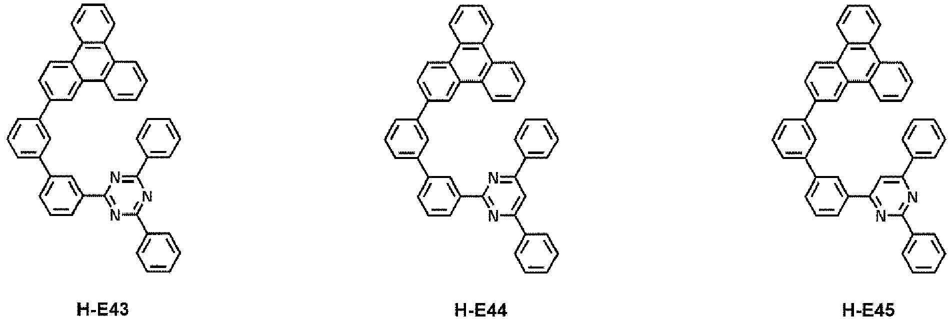

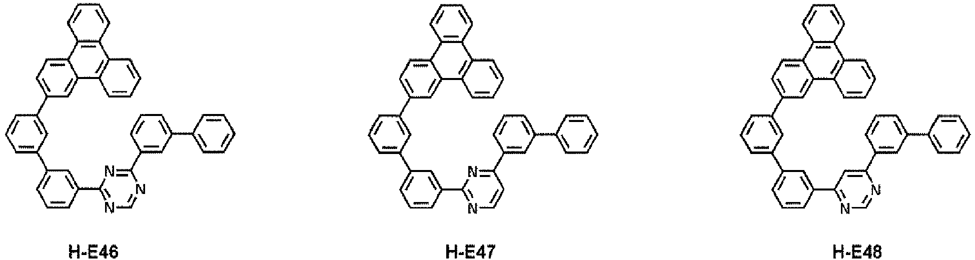

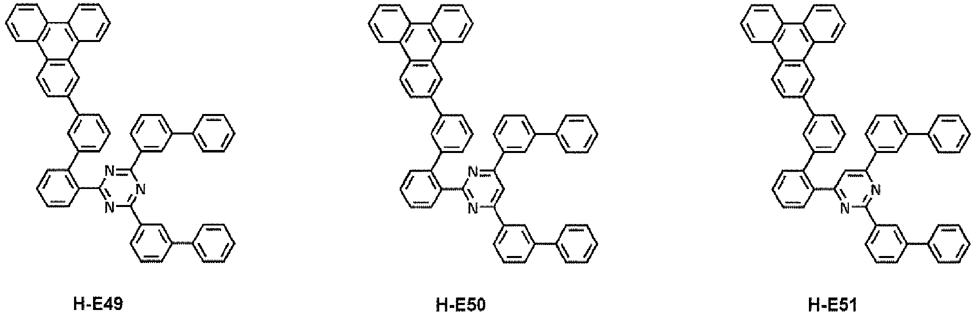

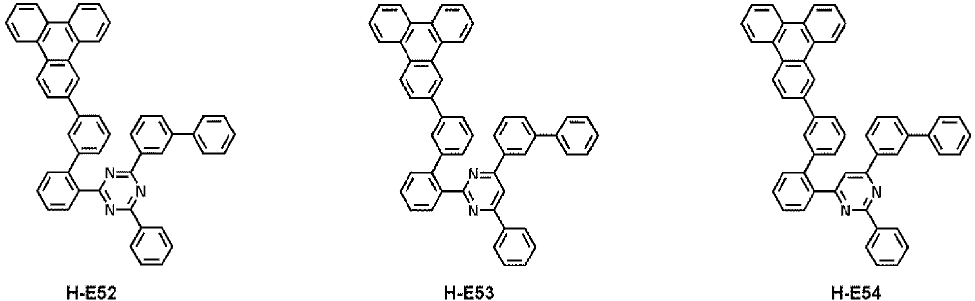

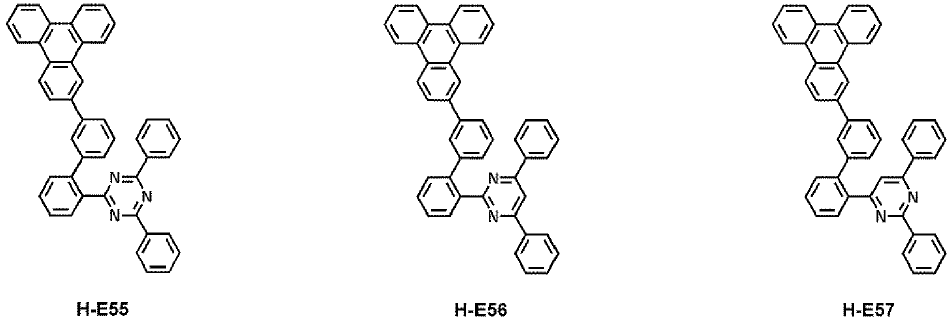

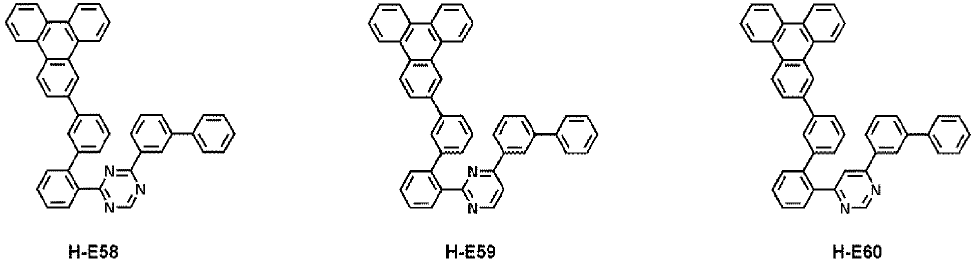

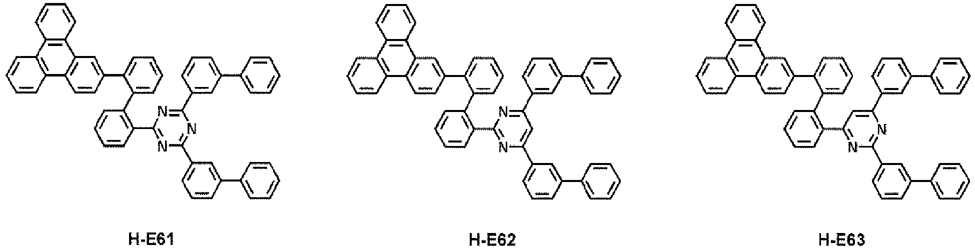

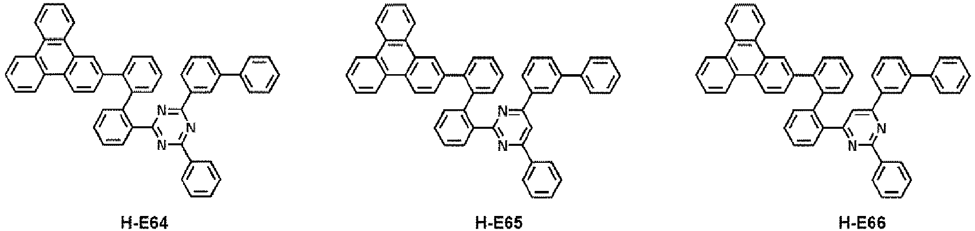

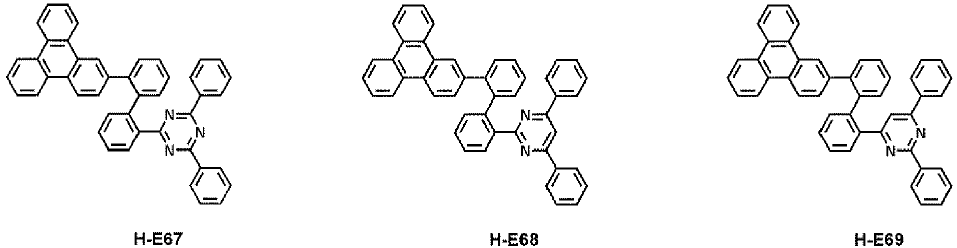

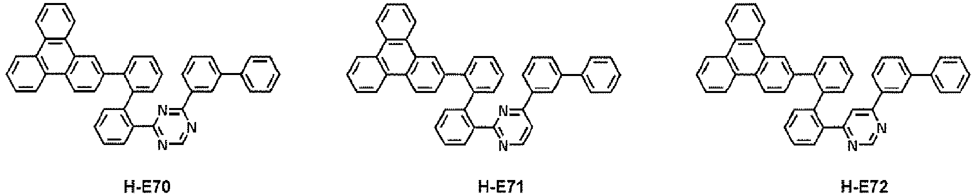

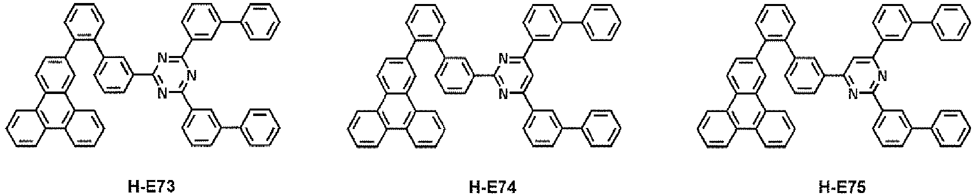

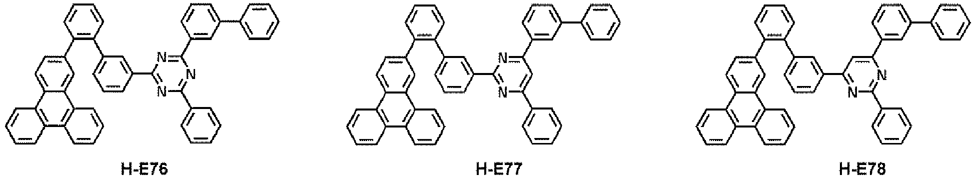

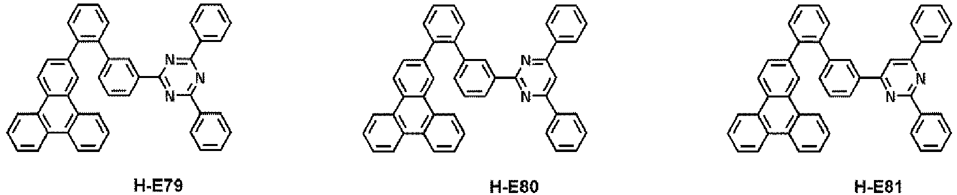

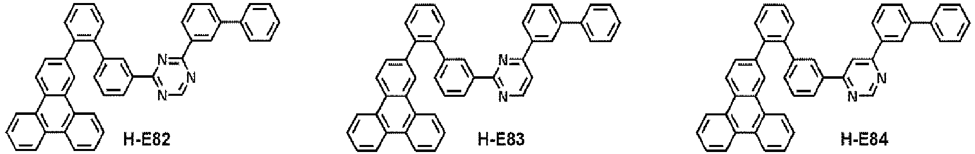

In some embodiments, the hole transporting host may be selected from Compounds H-H1 to H-H103:

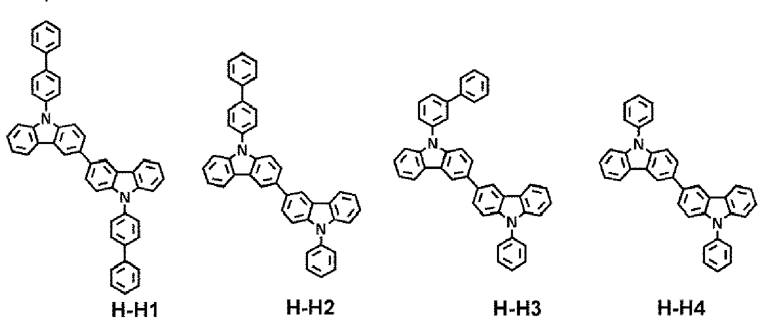

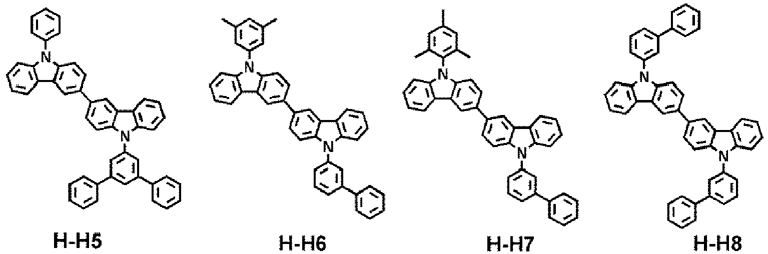

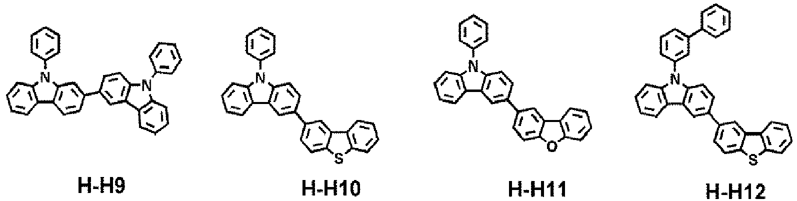

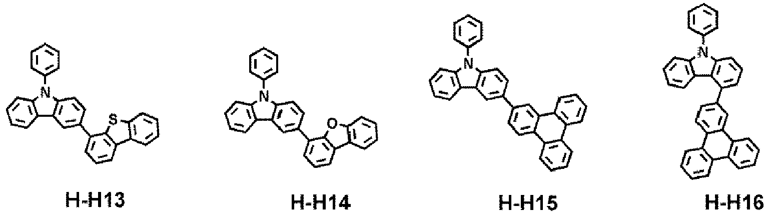

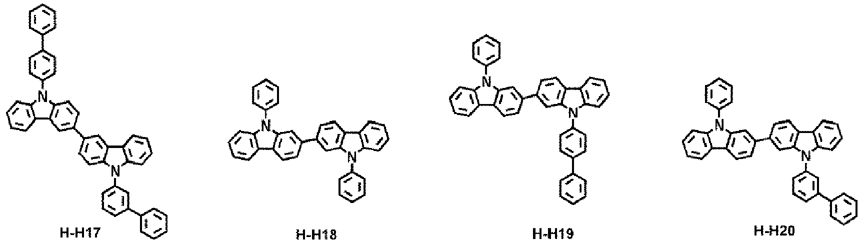

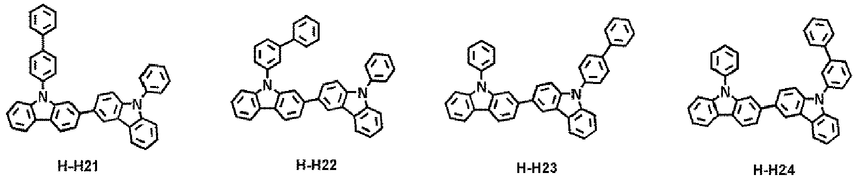

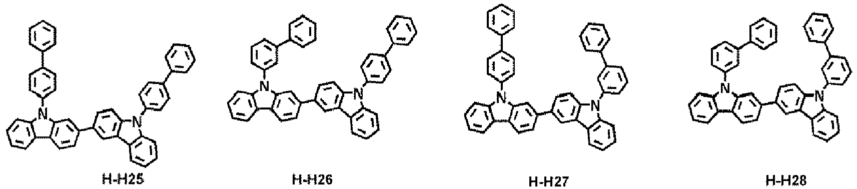

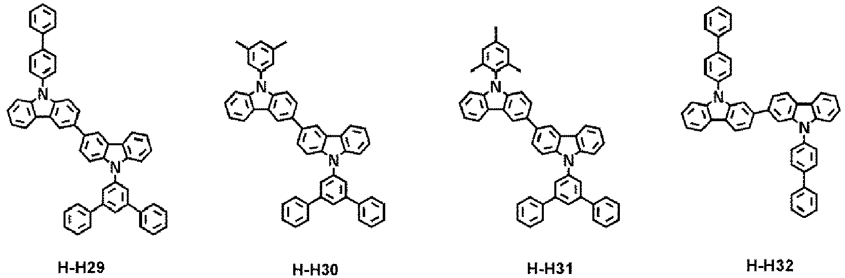

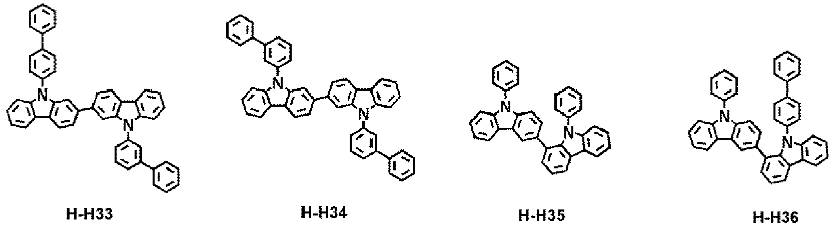

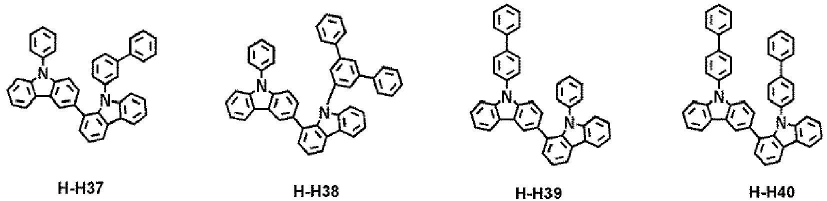

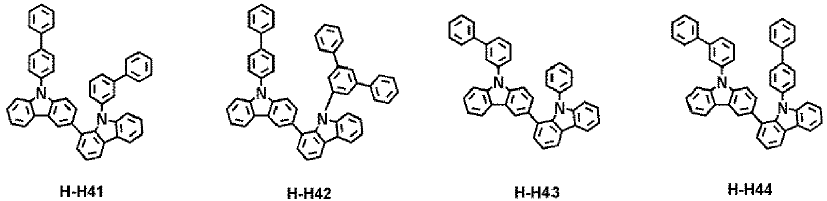

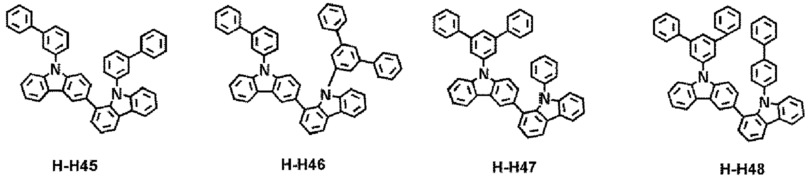

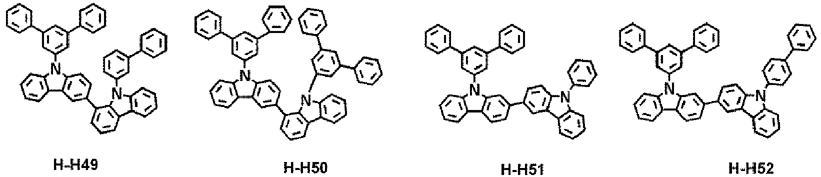

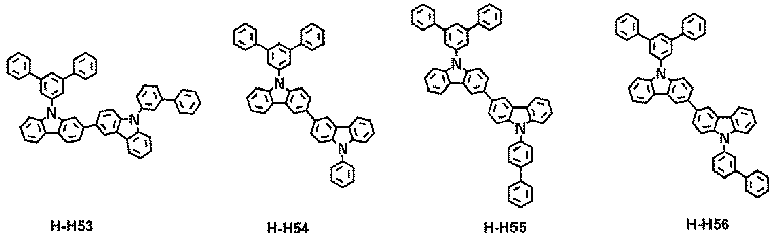

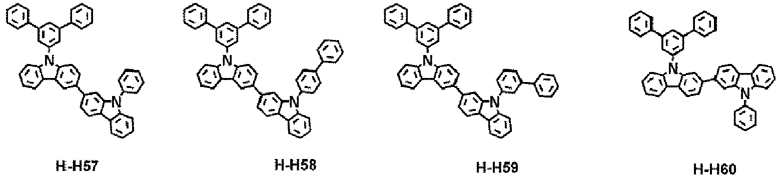

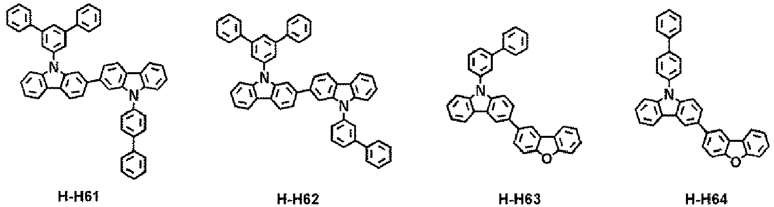

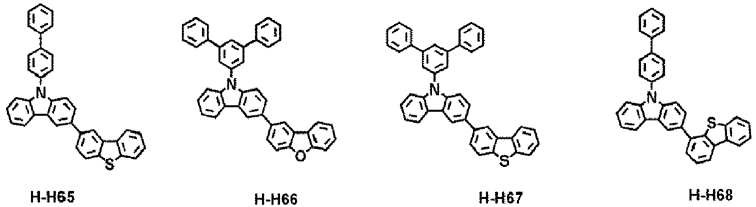

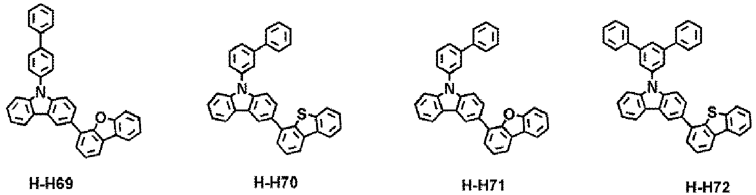

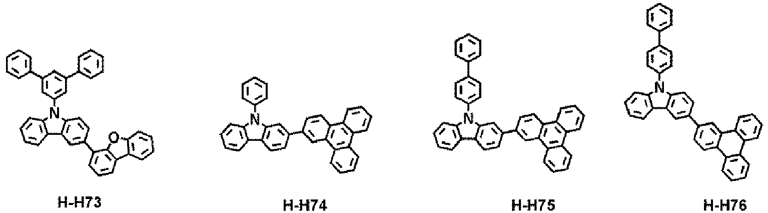

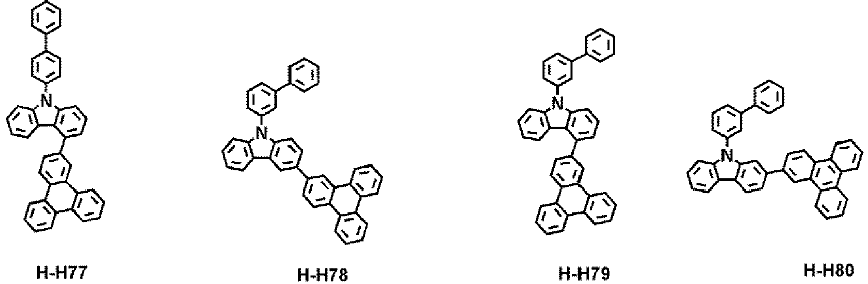

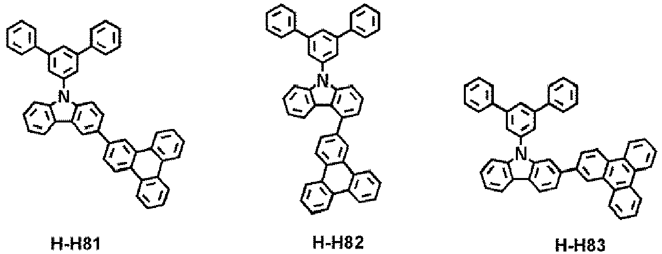

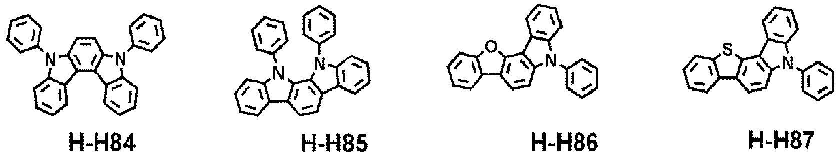

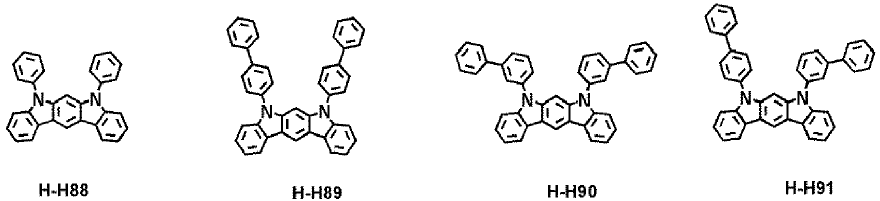

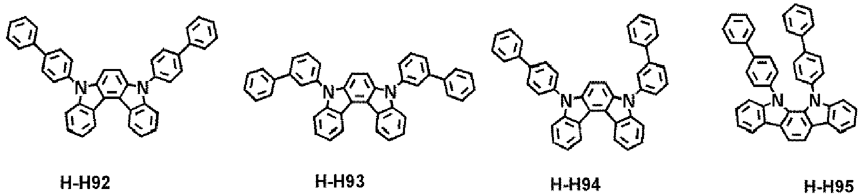

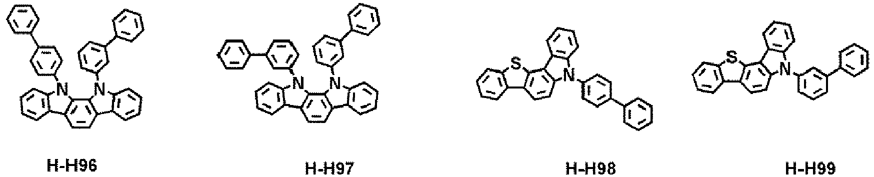

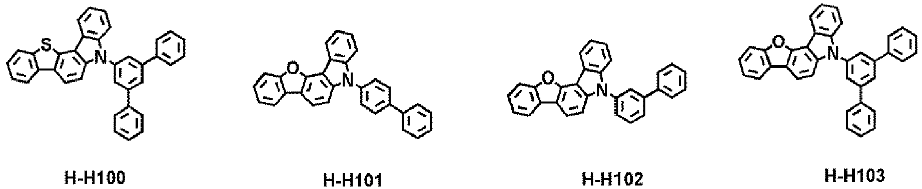

In some embodiments, the host may include an electron transporting host and a hole transporting host, the electron transporting host may include a triphenylene group and a triazine group, and the hole transporting host may include a carbazole group.

A weight ratio of the electron transporting host to the hole transporting host may be in a range of about 1:9 to about 9:1, for example, about 2:8 to about 8:2, or for example, about 4:6 to about 6:4. When a weight ratio of the electron transporting host to the hole transporting host is within any of these ranges, holes and electrons transport balance into the emission layer may be achieved.

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount of the dopant may be selected from a range of about 0.01 parts to about 15 parts by weight based on about 100 parts by weight of the host.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

### Electron transport region in emission layer

Next, an electron transport region may be formed on the emission layer.

The electron transport region may include a hole blocking layer, an electron transport layer, an electron injection layer, or a combination thereof.

In some embodiments, the electron transport region may have a hole blocking layer/an electron transport layer/an electron injection layer structure or an electron transport layer/an electron injection layer structure. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, at least one of BCP, Bphen, and BAlq:

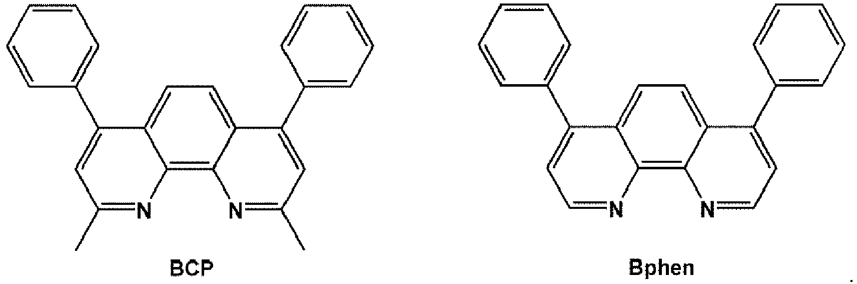

In some embodiments, the hole blocking layer may include the host, the material for forming an electron transport layer described herein, the material for forming an electron injection layer described herein, or any combination thereof.

The thickness of the hole blocking layer may be in a range of about 20 Å to about 1,000 Å, for example, about 30 Å to about 600 Å. When the thickness of the hole blocking layer is within any of these ranges, excellent hole blocking characteristics may be obtained without a substantial increase in driving voltage.

The electron transport layer may include BCP, Bphen, TPBi, Alq₃, BAlq, TAZ, NTAZ, or any combination thereof:

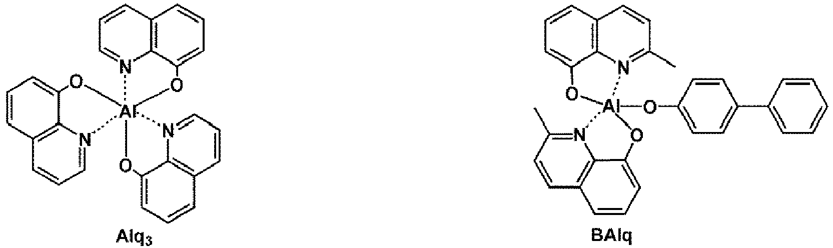

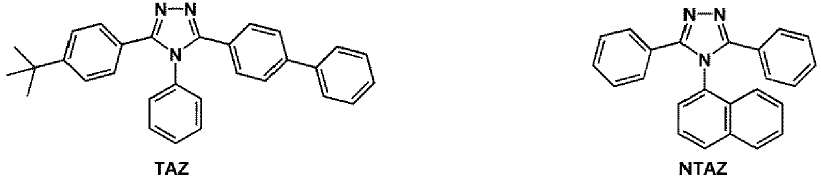

In some embodiments, the electron transport layer may include one of Compounds ET1 to ET25 or any combination thereof:

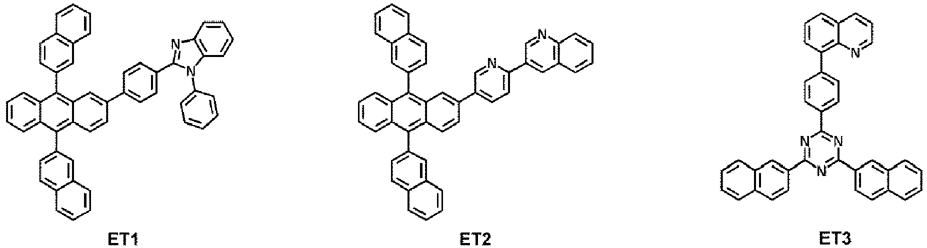

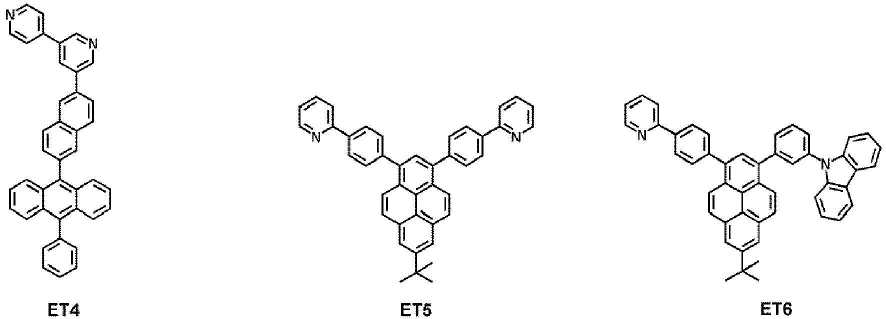

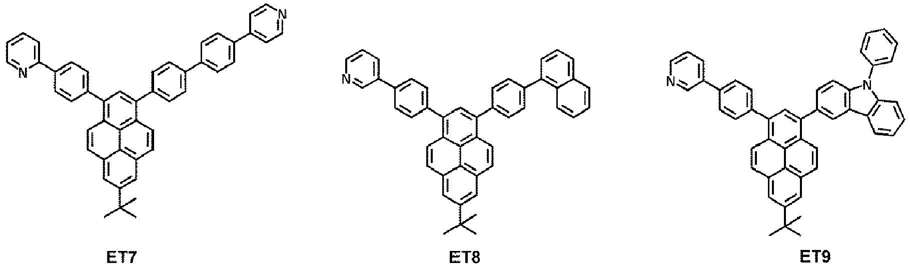

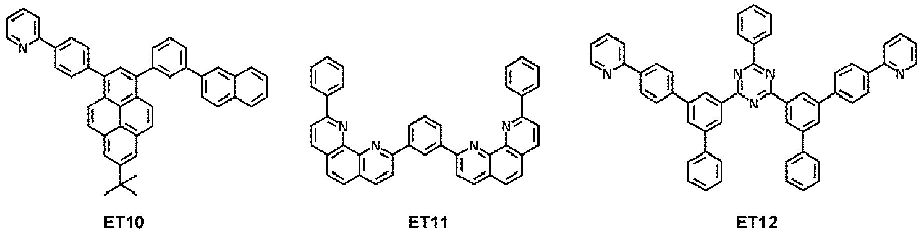

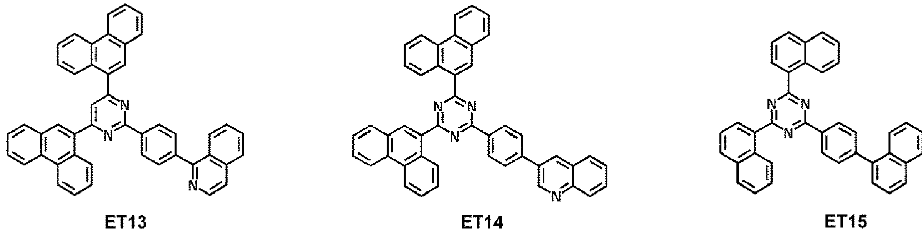

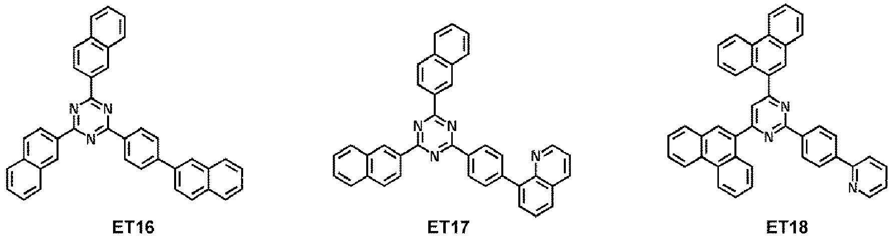

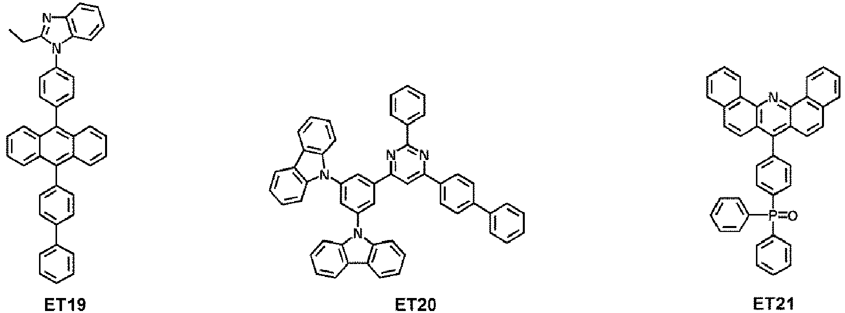

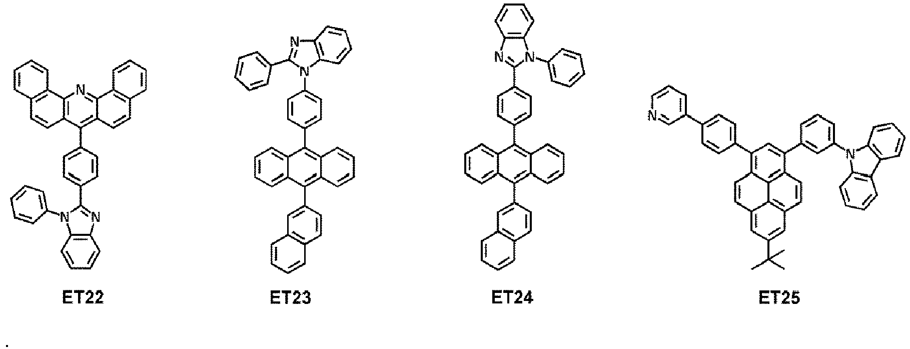

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 or Compound ET-D2:

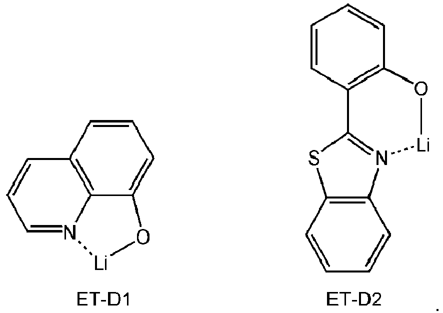

The electron transport region may include an electron injection layer that facilitates electron injection from the second electrode 19.

The electron injection layer may include LiF, NaCl, CsF, Li₂O, BaO, or any combination thereof.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or any combination thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to the FIGURE, but embodiments are not limited thereto.

According to an aspect of another embodiment, an electronic apparatus may include the organic light-emitting device. Thus, an electronic apparatus including the organic light-emitting device may be provided. The electronic apparatus may include, for example, a display, lighting, a sensor, or the like.

According to an aspect of still another embodiment, a diagnostic composition may include at least one organometallic compound represented by Formula 1-1.

Since the organometallic compound represented by Formula 1-1 provides high luminescence efficiency, the diagnostic efficiency of the diagnostic composition that includes the organometallic compound represented by Formula 1-1 may be excellent.

The diagnostic composition may be applied in various ways, such as in a diagnostic kit, a diagnostic reagent, a biosensor, or a biomarker.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. In some embodiments, Formula 9-33 may be a branched C₆ alkyl group. Formula 9-33 may be a tert-butyl group substituted with two methyl groups.

The term "C₁-C₆₀ alkoxy group" as used herein refers to a monovalent group represented by -OA₁₀₁ (wherein A₁₀₁ is a C₁-C₆₀ alkyl group).

Examples of the C₁-C₆₀ alkoxy group, the C₁-C₂₀ alkoxy group, or the C₁-C₁₀ alkoxy group as used herein may include a methoxy group, an ethoxy group, a propoxy group, a butoxy group, or a pentoxy group.

The term "C₂-C₆₀ alkenyl group" as used herein refers to a group formed by placing at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group as used herein may include a cyclopropyl group, a cyclobutyl group, a cyclopentyl group, a cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, or a bicyclo[2.2.2]octyl group.

The term "C₁-C₁₀ heterocycloalkyl group" as used herein refers to a monovalent saturated monocyclic group having 1 to 10 carbon atoms and at least one heteroatom of N, O, P, Si, S, Ge, Se and B as a ring-forming atom. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group as used herein may include a silolanyl group, a silinanyl group, a tetrahydrofuranyl group, a tetrahydro-2H-pyranyl group, or a tetrahydrothiophenyl group.

The term "C₃-C₁₀ cycloalkenyl group" as used herein refers to a monovalent cyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group including at least one heteroatom of N, O, P, Si, S, Ge, Se and B as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include a plurality of rings, the plurality of rings may be fused to each other.

The term "C₇-C₆₀ alkyl aryl group" as used herein refers to a C₆-C₆₀ aryl group substituted with at least one C₁-C₆₀ alkyl group.

The term "C₁-C₆₀ heteroaryl group" as used herein refers to a monovalent group having a heterocyclic aromatic system having at least one heteroatom of N, O, P, Si, S, Ge, Se and B as a ring-forming atom and 1 to 1 carbon atoms. The term "C₁-C₆₀ heteroarylene group" as used herein refers to a divalent group having a heterocyclic aromatic system having at least one heteroatom of N, O, P, Si, S, Ge, Se and B as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include a plurality of rings, the plurality of rings may be fused to each other.

The term "C₂-C₆₀ alkyl heteroaryl group" as used herein refers to a C₁-C₆₀ heteroaryl group substituted with at least one C₁-C₆₀ alkyl group.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group). The term "C₁-C₆₀ alkylthio group" as used herein is represented by -SA₁₀₄ (wherein A₁₀₄ is the C₁-C₆₀ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, S, Ge, Se and B and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Examples of the "C₅-C₃₀ carbocyclic group (unsubstituted or substituted with at least one R₁₀ₐ)" may include an adamantane group, a norbornene group, a bicyclo[1.1.1]pentane group, a bicyclo[2.1.1]hexane group, a bicydo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each (unsubstituted or substituted with at least one R₁₀ₐ).

The term "C₁-C₃₀ heterocyclic group" as used herein refers to saturated or unsaturated cyclic group including 1 to 30 carbon atoms and at least one heteroatom selected from N, O, P, Si, Se, Ge, B, and S as ring-forming atoms. The C₁-C₃₀ heterocyclic group may be a monocyclic group or a polycyclic group. Examples of the "C₁-C₃₀ heterocyclic group (unsubstituted or substituted with at least one R₁₀ₐ)" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ).

Examples of the "C₅-C₃₀ carbocyclic group" and the "C₁-C₃₀ heterocyclic group" as used herein include i) a first ring, ii) a second ring, iii) a condensed ring in which at least two first rings are condensed, iv) a condensed ring in which at least two second rings are condensed, or v) a condensed ring in which at least one first ring and at least one second ring are condensed,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one fluoro group (-F). Examples of the "fluorinated C₁ alkyl group (i.e., a fluorinated methyl group)" may include -CF₃, -CF₂H, and -CFH₂. The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", or "fluorinated phenyl group" may respectively be: i) a fully fluorinated C₁-C₆₀ alkyl group (or fully fluorinated C₁-C₂₀ alkyl group or the like), fully fluorinated C₃-C₁₀ cycloalkyl group, fully fluorinated C₁-C₁₀ heterocycloalkyl group, or fully fluorinated phenyl group, in which all hydrogen atoms are substituted with fluoro groups; or ii) a partially fluorinated C₁-C₆₀ alkyl group (or partially fluorinated C₁-C₂₀ alkyl group or the like), partially fluorinated C₃-C₁₀ cycloalkyl group, partially fluorinated C₁-C₁₀ heterocycloalkyl group, or partially fluorinated phenyl group, in which some of hydrogen atoms are substituted with fluoro groups.

The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", and "deuterated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one deuterium. Examples of the "deuterated C₁ alkyl group (i.e., a deuterated methyl group)" may include -CD₃, -CD₂H, and -CDH₂. Examples of the "deuterated C₃-C₁₀ cycloalkyl group" may include Formula 10-501. The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", or deuterated phenyl group may respectively be: i) a fully deuterated C₁-C₆₀ alkyl group (or fully deuterated C₁-C₂₀ alkyl group or the like), fully deuterated C₃-C₁₀ cycloalkyl group, fully deuterated C₁-C₁₀ heterocycloalkyl group, or fully deuterated phenyl group, in which all hydrogens are substituted with deuteriums; or ii) a partially deuterated C₁-C₆₀ alkyl group (or partially deuterated C₁-C₂₀ alkyl group or the like), partially deuterated C₃-C₁₀ cycloalkyl group, partially deuterated C₁-C₁₀ heterocycloalkyl group, or partially deuterated phenyl group, in which some of hydrogens are substituted with deuteriums.

The "(C₁-C₂₀ alkyl)'X' group" refers to a 'X' group substituted with at least one C₁-C₂₀ alkyl group. For example, The "(C₁-C₂₀ alkyl)C₃-C₁₀ cycloalkyl group" as used herein refers to a C₃-C₁₀ cycloalkyl group substituted with at least one C₁-C₂₀ alkyl group, and the "(C₁-C₂₀ alkyl)phenyl group" as used herein refers to a phenyl group substituted with at least one C₁-C₂₀ alkyl group. Examples of the (C₁ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

A substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₆), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or-P(Q₃₈)(Q₃₉); or
any combination thereof.

In the present specification, Q1 to Q9, Q11 to Q19, Q21 to Q29, and Q31 to Q39 may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used based on molar equivalence.

### Examples

### Synthesis Example 1 (Compound 1)

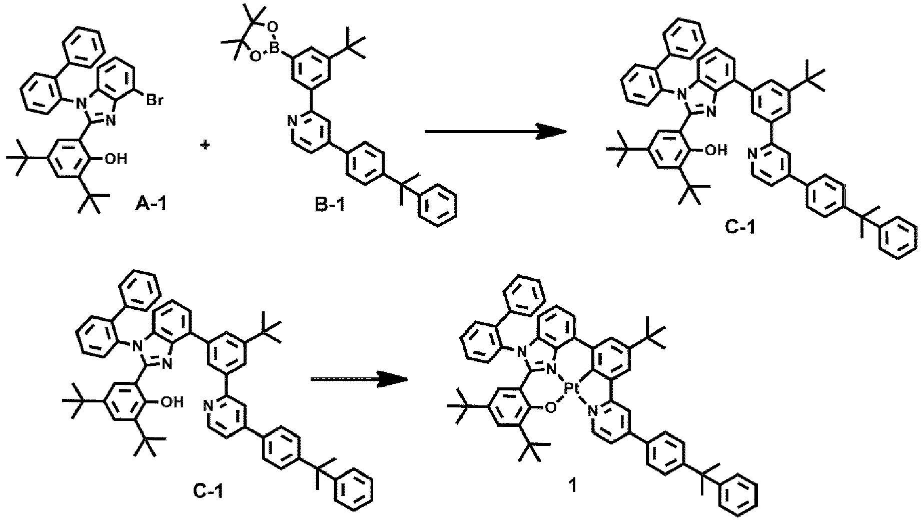

### Synthesis of ligand C-1 (2-(1-([1,1'-biphenyl]-2-yl)-4-(3-(tert-butyl)-5-(4-(4-(2-phenylpropan-2-yl)phenyl)pyridin-2-yl)phenyl)-1H-benzo[d]imidazol-2-yl)-4,6-di-tertbutylphenol)

5.7 grams (g) of Intermediate B-1 (0.011 mol, 0.9 equiv.), 6.6 g of Intermediate A-1 (0.012 mol, 1 equiv.), 0.96 g of tetrakis(triphenylphosphine)palladium(0) (0.00084 mol, 0.07 equiv.), and 4.9 g of potassium carbonate (0.036 mol, 3 equiv.) were dissolved in 80 milliliters (mL) of a solvent in which tetrahydrofuran (THF) and distilled water (H₂O) were mixed at a volume ratio of 3:1, followed by reflux for 12 hours. The resulting product was cooled to room temperature, and a precipitate was filtered to obtain a filtrate. The obtained filtrate was washed with EA (ethyl acetate) and H₂O, a column chromatography (while increasing a rate of EA/hexane to between 8 % and 15 %) was performed, and recrystallization was performed using MC (methylene chloride) /MeOH to obtain 4.8 g of Ligand C-1 (having a purity of 99 % or higher). The resulting compound was identified by using mass spectroscopy and HPLC analysis.

HRMS(MALDI) calcd for C₆₃H₆₃N₃O: m/z 877.4971, Found: 877.4975

### Synthesis of Compound 1

4.9 g of ligand C-1 (5.55 mmol) and 2.76 g of K₂PtCl₄ (6.65 mmol, 1.2 equiv.) were dissolved in 110 mL of a mixture of 100 mL of AcOH (acetic acid) and 10 mL of H₂O, followed by reflux for 16 hours. The resulting product was cooled to room temperature, and a precipitate was filtered to obtain a filtrate. The obtained filtrate was dissolved in MC and washed with H₂O, and a column chromatography was performed thereon to obtain 2.2 g of Compound 1 (yield: 37 %). The resulting compound was identified by using mass spectroscopy and HPLC analysis.

HRMS(MALDI) calcd for C₆₃H₆₁N₃OPt: m/z 1070.4462, Found: 1070.4464

### Synthesis Example 2 (Compound 3)

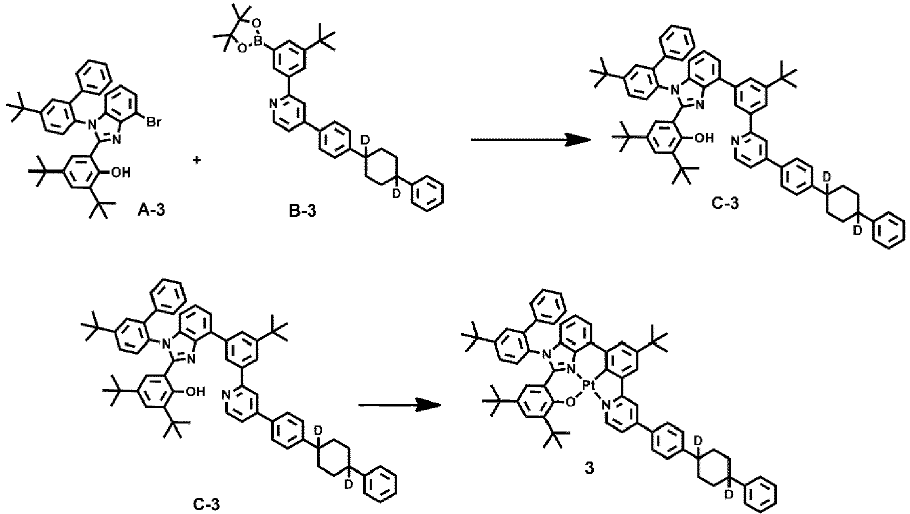

### Synthesis of ligand C-3 (2,4-di-tert-butyl-6-(4-(3-(tert-butyl)-5-(4-(4-(4-phenylcyclohexyl-1,4-d2)phenyl)pyridin-2-yl)phenyl)-1-(5-(tert-butyl)-[1,1'-biphenyl]-2-yl)-1H-benzo[d]imidazol-2-yl)phenol)

3.4 grams (g) of Intermediate B-3 (0.0054 mol, 0.9 equiv.), 4.0 g of Intermediate A-3 (0.006 mol, 1 equiv.), 0.53 g of tetrakis(triphenylphosphine)palladium(0) (0.00042 mol, 0.07 equiv.), and 2.7 g of potassium carbonate (0.020 mol, 3 equiv.) were dissolved in 80 milliliters (mL) of a solvent in which tetrahydrofuran (THF) and distilled water (H₂O) were mixed at a volume ratio of 3:1, followed by reflux for 12 hours. The resulting product was cooled to room temperature, and a precipitate was filtered to obtain a filtrate. The obtained filtrate was washed with EA and H₂O, a column chromatography (while increasing a rate of EA/hexane to between 8 % and 15 %) was performed, and recrystallization was performed using MC/MeOH to obtain 4.5 g of Ligand C-3 (having a purity of 99 % or higher). The resulting compound was identified by using mass spectroscopy and HPLC analysis.

HRMS(MALDI) calcd for C₇₀H₇₃D₂N₃O: m/z 975.6036, Found: 975.6039

### Synthesis of Compound 3

4.5 g of ligand C-3 (5.25 mmol) and 2.61 g of K₂PtCl₄ (6.30 mmol, 1.2 equiv.) were dissolved in 100 mL of a mixture of 100 mL of AcOH and 10 mL of H₂O, followed by reflux for 16 hours. The resulting product was cooled to room temperature, and a precipitate was filtered to obtain a filtrate. The obtained filtrate was dissolved in MC and washed with H₂O, and a column chromatography (MC 40%, Hexane 60%) was performed thereon to obtain 1.84 g of Compound 3 (yield: 30 %). The resulting compound was identified by using mass spectroscopy and HPLC analysis.

HRMS(MALDI) calcd for C₇₀H₇₁D₂N₃OPt: m/z 1168.5527, Found: 1168.5528

### Synthesis Example 3 (Compound 177)

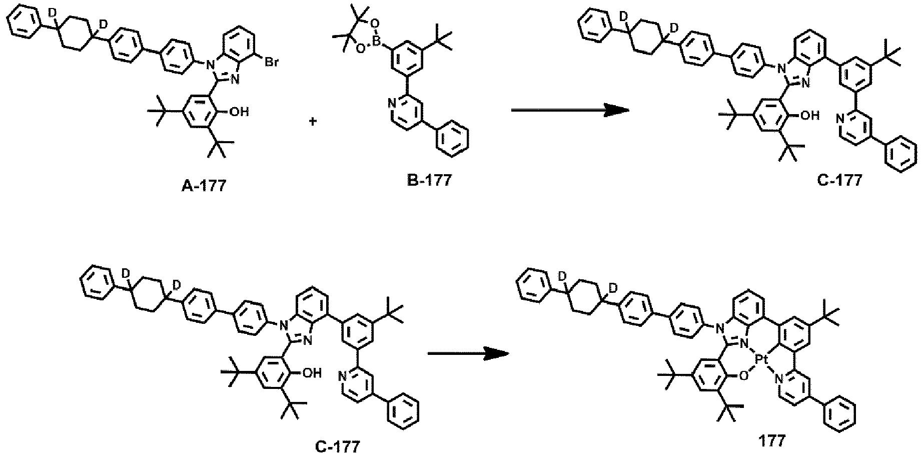

### Synthesis of ligand C-177

3.0 g of ligand C-177 (having a purity of 98 % or higher) was obtained in substantially the same manner as in Synthesis of ligand C-3 in Synthesis Example 2, except that Intermediate A-177 and Intermediate B-177 were used instead of Intermediate A-3 and Intermediate B-3, respectively. The resulting compound was identified by using mass spectroscopy and HPLC analysis.

HRMS(MALDI) calcd for C₆₆H₆₅D₂N₃O: m/z 919.5410, Found: 919.5412

### Synthesis of Compound 177

1.2 g of Compound 177 (yield: 34 %) was obtained in substantially the same manner as in Synthesis of Compound 3 in Synthesis Example 2, except that ligand C-177 was used instead of ligand C-3. The resulting compound was identified by using mass spectroscopy and HPLC analysis.

HRMS(MALDI) calcd for C₆₆H₆₃D₂N₃OPt. m/z 1112.4901, Found: 1112.4903

### Synthesis Example 4 (Compound 187)

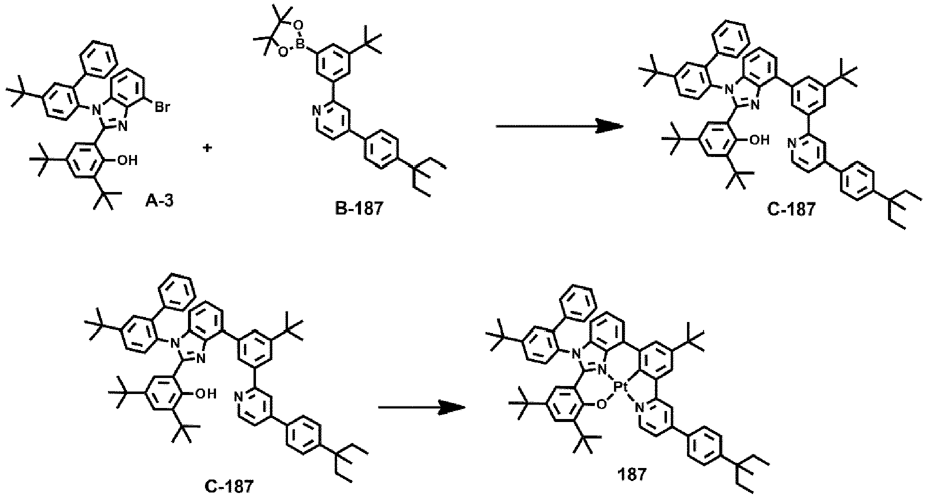

### Synthesis of ligand C-187

3.2 g of ligand C-187 (having a purity of 98 % or higher) was obtained in substantially the same manner as in Synthesis of ligand C-3 in Synthesis Example 2, except that Intermediate B-187 was used instead of Intermediate B-3. The resulting compound was identified by using mass spectroscopy and HPLC analysis.

HRMS(MALDI) calcd for C₆₄H₇₃N₃O: m/z 899.5754, Found: 899.5757

### Synthesis of Compound 187

1.67 g of Compound 187 (yield: 43 %) was obtained in substantially the same manner as in Synthesis of Compound 3 in Synthesis Example 2, except that ligand C-187 was used instead of ligand C-3. The resulting compound was identified by using mass spectroscopy and HPLC analysis.

HRMS(MALDI) calcd for C₆₄H₇₁N₃OPt: m/z 1092.5245, Found: 1092.5243

### Synthesis Example 5 (Compound 218)

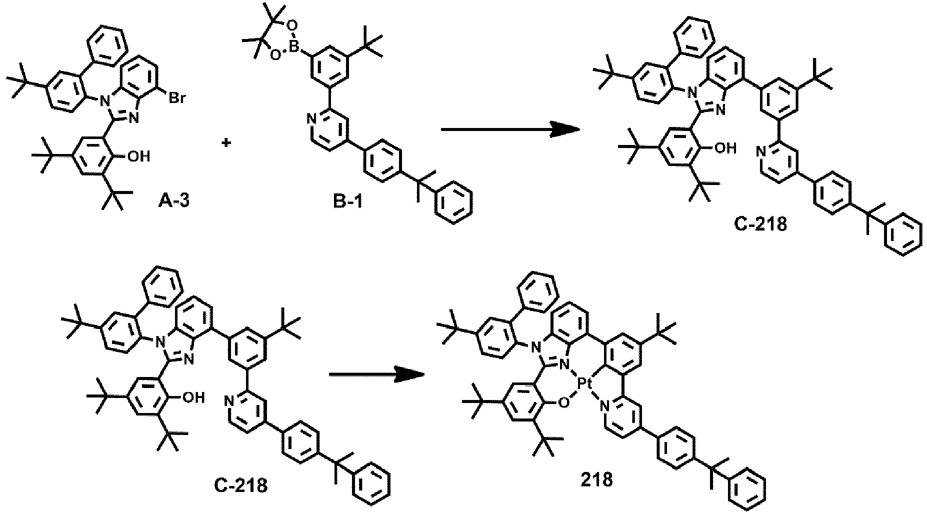

### Synthesis of ligand C-218

2.8 g of ligand C-218 (having a purity of 97 % or higher) was obtained in substantially the same manner as in Synthesis of ligand C-3 in Synthesis Example 2, except that Intermediate B-1 was used instead of Intermediate B-3. The resulting compound was identified by using mass spectroscopy and HPLC analysis.

HRMS(MALDI) calcd for C₆₇H₇₁N₃O. m/z 933.5597, Found: 933.5599

### Synthesis of Compound 218

1.39 g of Compound 218 (yield: 41 %) was obtained in substantially the same manner as in Synthesis of Compound 3 in Synthesis Example 2, except that ligand C-218 was used instead of ligand C-3. The resulting compound was identified by using mass spectroscopy and HPLC analysis.

HRMS(MALDI) calcd for C₆₇H₆₉N₃OPt: m/z 1126.5088, Found: 1126.5087

### Synthesis Example 6 (Compound 246)

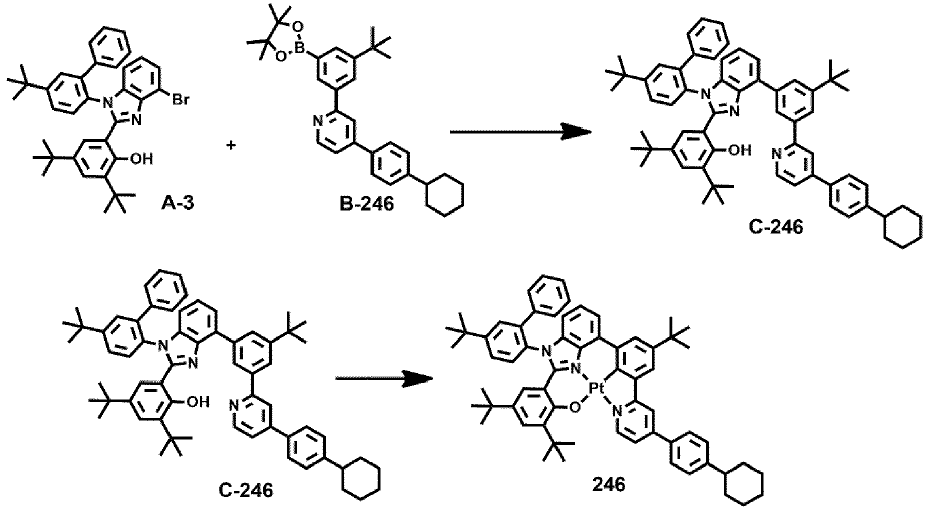

### Synthesis of ligand C-246

3.0 g of ligand C-246 (having a purity of 97 % or higher) was obtained in substantially the same manner as in Synthesis of ligand C-3 in Synthesis Example 2, except that Intermediate B-246 was used instead of Intermediate B-3. The resulting compound was identified by using mass spectroscopy and HPLC analysis.

HRMS(MALDI) calcd for C₆₄H₇₁N₃O: m/z 897.5597, Found: 897.5599

### Synthesis of Compound 246

1.42 g of Compound 246 (yield: 39 %) was obtained in substantially the same manner as in Synthesis of Compound 3 in Synthesis Example 2, except that ligand C-246 was used instead of ligand C-3. The resulting compound was identified by using mass spectroscopy and HPLC analysis.

HRMS(MALDI) calcd for C₆₄H₆₉N₃OPt: m/z 1090.5088, Found: 1090.5087

### Evaluation Example 1: Evaluation on singlet (S1) energy level and triplet (T1) energy level

The singlet (S₁) energy level and the triplet (T₁) energy level of the organometallic Compounds 1, 3, 177, 187, 218 and 246 and Compounds A, B, and C were evaluated by using a Gaussian program according to a density functional theory (DFT) method (structure optimization was performed at a degree of B3LYP, and 6-31 G(d,p)). The results thereof are shown in Table 1.

**Table 1**

| Compound No. | S₁ (eV) | T₁ (eV) | ΔST (eV) |
|---|---|---|---|
| 1 | 2.515 | 2.371 | 0.144 |
| 3 | 2.527 | 2.369 | 0.158 |
| 177 | 2.510 | 2.347 | 0.163 |
| 187 | 2.512 | 2.352 | 0.160 |
| 218 | 2.485 | 2.342 | 0.143 |
| 246 | 2.512 | 2.353 | 0.159 |
| A | 2.521 | 2.215 | 0.306 |
| B | 2.741 | 2.244 | 0.497 |
| C | 2.751 | 2.517 | 0.234 |

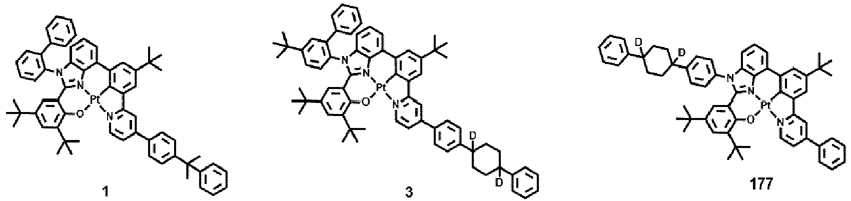

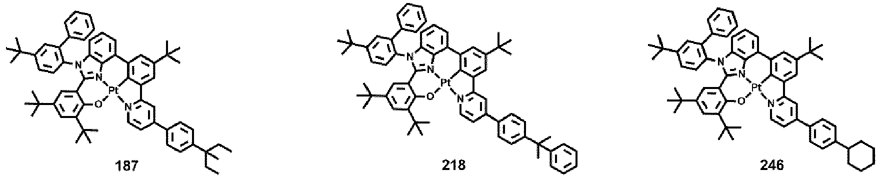

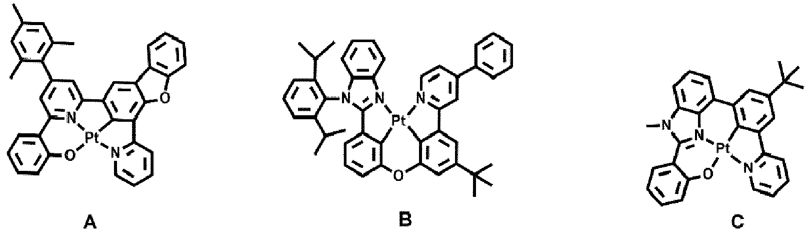

As shown in Table 1, Compounds 1, 3, 177, 187, 218 and 246 were found to have ΔST in a range of 0.1 eV to 0.2 eV.

### Evaluation Example 2: Evaluation of Horizontal Orientation Ratio

mCP and Compound 1 were co-deposited on a quartz substrate at a weight ratio of 92:8 in a vacuum degree of 10⁻⁷ torr to form a film having a thickness of 40 nm.

Then, a glass substrate for encapsulation was attached on the film to encapsulate the film.

The photoluminescence (PL) intensity according to angle of the film was measured by using a Luxol-OLED/analyzer LOA-100 (available from CoCoLink) from -150 ° to +150°. Then, the horizontal orientation ratio of Compound 1 was calculated by using a fitting program of the analyzer. The results thereof are shown in Table 2. The same process was performed on the compounds shown in Table 2. The results thereof are also shown in Table 2.

**Table 2**

| Sample No. | Co-deposition material | Horizontal orientation ratio (%) |
|---|---|---|
| 1 | mCP:Compound 1 (8 wt%) | 89 |
| 3 | mCP:Compound 3 (8 wt%) | 94 |
| 177 | mCP:Compound 177 (8 wt%) | 91 |
| 187 | mCP:Compound 187 (8 wt%) | 90 |
| 218 | mCP:Compound 218 (8 wt%) | 92 |
| 246 | mCP:Compound 246 (8 wt%) | 92 |
| A | mCP:Compound A (8 wt%) | 75 |
| B | mCP:Compound B (8 wt%) | 75 |
| C | mCP:Compound C (8 wt%) | 71 |

Referring to the results of Table 2, the horizontal orientation ratios of Compounds 1, 3, 177, 187, 218 and 246 were found to be higher than the horizontal orientation ratios of Compounds A, B, and C.

### Evaluation Example 3: Thermal characteristics evaluation

Thermal analysis (N₂ atmosphere, a temperature range: from room temperature to 800 °C (10°C/min)-TGA, from room temperature to 400 °C-DSC, Pan Type: Pt Pan in disposable Al Pan (TGA) and disposable Al pan (DSC)) was performed on Compounds 1, 3, 177, 187, 218 and 246 by using thermo gravimetric analysis (TGA) and differential scanning calorimetry (DSC). The evaluation results are shown in Table 3. Ts_10% in Table 3 is a temperature of a sample when a loss of the sample is 10wt% of an initial weight of the sample.

**Table 3**

| Compound No. | Ts_10% (°C) |
|---|---|
| 1 | 291 |
| 177 | 325 |
| 187 | 285 |
| 218 | 299 |
| 246 | 300 |

Referring to the results of Table 3, Compounds 1, 177, 187, 218 and 246 were each found to have a relatively low sublimation temperature. Thus, a thin film having excellent performance may be prepared by using above compounds.

### Example 1

A glass substrate, on which ITO is patterned as an anode, was cut to a size of 50 millimeters (mm) × 50 mm × 0.5 mm, sonicated in isopropyl alcohol and water for 5 minutes each, and cleaned by exposure to ultraviolet rays and ozone for 30 minutes. Subsequently, the glass substrate was mounted on a vacuum-deposition device.

HT3 and F6-TCNNQ were vacuum-co-deposited at a weight ratio of 98:2 on the anode to form a hole injection layer having a thickness of 100 Å. HT3 was vacuum-deposited on the hole injection layer to form a hole transport layer having a thickness of 1,350 Å. Then, H-H1 was vacuum-deposited on the hole transport layer to form an electron blocking layer having a thickness of 300 Å.

Subsequently, H-H1 and H-E43 (as hosts) and Compound 1 (as a dopant) were co-deposited on the electron blocking layer at a weight ratio of 47.5:47.5:5 to form an emission layer having a thickness of 400 Å.

ET3 and ET-D1 were co-deposited at a volume ratio of 50:50 on the emission layer to form an electron transport layer having a thickness of 350 Å, ET-D1 was deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

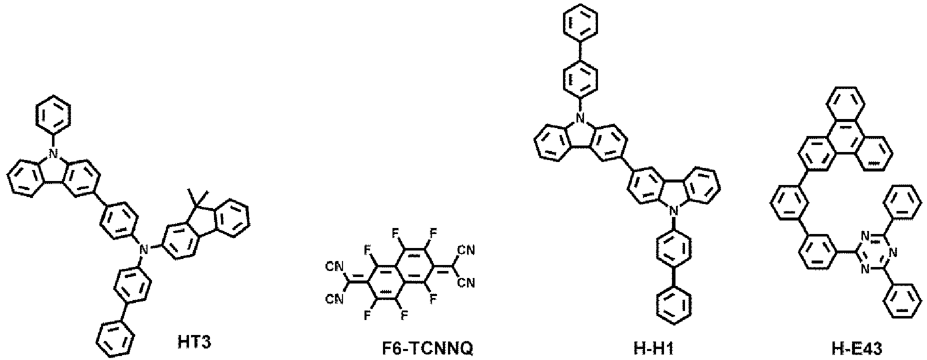

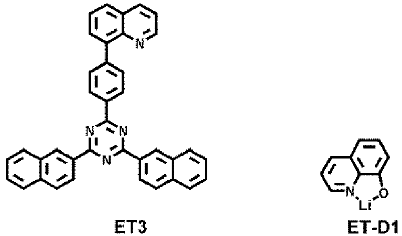

### Examples 2 to 6 and Comparative Examples A. B. and C

Organic light-emitting devices were manufactured in substantially the same manner as in Example 1, except that the compounds listed in Table 4 were used instead of Compound 1 as a dopant in the formation of an emission layer.

### Evaluation Example 4: Evaluation of characteristics of organic light-emitting device

A current voltmeter (Keithley 2400) and a luminescence meter (Minolta Cs-1000A) were used on the organic light-emitting devices of Examples 1 to 6 and Comparative Examples A, B, and C to measure the driving voltage, luminescence efficiency (cd/A), and a quantum emission yield (%). The results thereof are shown in Table 4. The luminescence efficiency is shown in a relative value.

**Table 4**

| | Dopant Compound No. | Driving voltage (V) | Luminescence efficiency (relative value, %) | Maximum quantum emission yield (%) |
|---|---|---|---|---|
| Example 1 | 1 | 4.01 | 104 | 108 |
| Example 2 | 3 | 4.02 | 110 | 112 |
| Example 3 | 177 | 4.05 | 106 | 107 |
| Example 4 | 187 | 4.04 | 109 | 108 |
| Example 5 | 218 | 4.01 | 104 | 104 |
| Example 6 | 246 | 4.02 | 105 | 107 |
| Compara tive Example A | A | 4.30 | 87 | 84 |
| Compara tive Example B | B | 4.40 | 77 | 75 |
| Compara tive Example C | C | 4.57 | 74 | 97 |

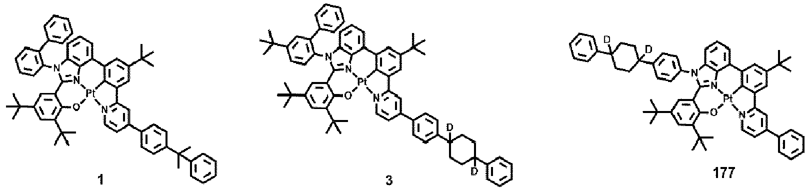

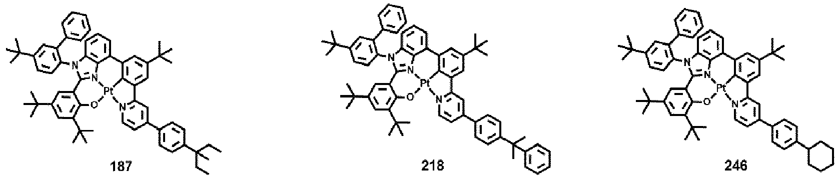

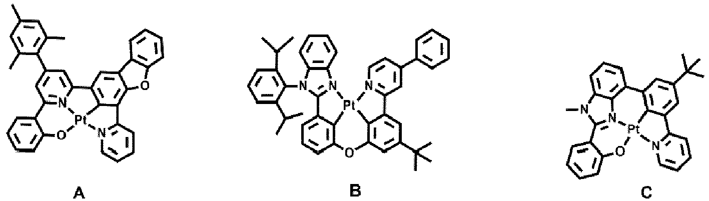

Referring to the results of Table 4, the organic light-emitting devices of Examples 1 to 6 were found to have excellent driving voltage, excellent luminescence efficiency, and improved quantum emission yield, as compared with the organic light-emitting devices of Comparative Examples A, B, and C.

As apparent from the foregoing description, the organometallic compound has excellent electrical characteristics and thermal stability. Accordingly, an organic light-emitting device including the organometallic compound may have an improved driving voltage, improved luminescence efficiency, and improved external quantum emission yield. Therefore, a high-quality electronic apparatus may be realized by using the organic light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1-1: 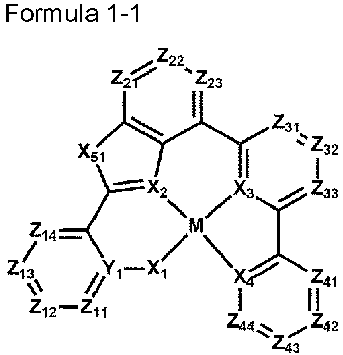 wherein, in Formula 1-1,
M is a transition metal,
X₁ is O, S, or N(R"'),
a bond between X₁ and M is a covalent bond,
X₂ to X₄ and Y₁ are each independently C or N,
one bond of a bond between X₂ and M, a bond between X₃ and M, and a bond between X₄ and M is a covalent bond, while the remaining bonds are each a coordinate bond,
X₅₁ is O, S, N-[(L₇)_{b7}-(R₇)_{c7}], C(R₇)(R₈), Si(R₇)(R₈), Ge(R₇)(R₈), or C(=O),
Z₁₁ is N or C-[(L₁₁)_{b11}-(T₁₁)_{c11}], Z₁₂ is N or C-[(L₁₂)_{b12}-(T₁₂)_{c12}], Z₁₃ is N or C-[(L₁₃)_{b13}-(T₁₃)_{c13}], and Z₁₄ is N or C-[(L₁₄)_{b14}-(T₁₄)_{c14}],
Z₂₁ is N or C-[(L₂₁)_{b21}-(T₂₁)_{c21}], Z₂₂ is N or C-[(L₂₂)_{b22}-(T₂₂)_{c22}], and Z₂₃ is N or C-[(L₂₃)b₂₃-(T₂₃)_{c23}],
Z₃₁ is N or C-[(L₃₁)_{b31}-(T₃₁)_{c31}], Z₃₂ is N or C-[(L₃₂)_{b32}-(T₃₂)_{c32}], and Z₃₃ is N or C-[(L₃₃)_{b33}-(T₃₃)_{c33}],
Z₄₁ is N or C-[(L₄₁)_{b41}-(T₄₁)_{c41}], Z₄₂ is N or C-[(L₄₂)_{b42}-(T₄₂)_{c42}], Z₄₃ is N or C-[(L₄₃)_{b43}-(T₄₃)_{c43}], and Z₄₄ is N or C-[(L₄₄)_{b44}-(T₄₄)_{c44}],
L₇, L₁₁ to L₁₄, L₂₁ to L₂₃, L₃₁ to L₃₃ and L₄₁ to L₄₄ are each independently a single bond, a C₁-C₁₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ,
b7, b11 to b14, b21 to b23, b31 to b33 and b41 to b44 are each independently 1, 2, 3, 4, or 5,
R'", R₇, R₈, T₁₁ to T₁₄, T₂₁ to T₂₃, T₃₁ to T₃₃ and T₄₁ to T₄₄ are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or-P(Q₆)(Q₉),
c7, c11 to c14, c21 to c23, c31 to c33 and c41 to c44 are each independently 1, 2, 3, 4, or 5,
wherein, the organometallic compound represented by Formula 1-1 satisfies:
1) one of Condition 11, Condition 12 and Condition 13,
2) Condition 11 and Condition 13, or
3) Condition 12 and Condition 13,
Condition 11
Z₄₂ in Formula 1-1 is C-[(L₄₂)_{b42}-(T₄₂)_{c42}],
T₄₂ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
c42 is 1,
Condition 12
Z₄₂ in Formula 1-1 is C-[(L₄₂)_{b42}-(T₄₂)_{c42}],
T₄₂ is a group represented by Formula 41, and
c42 is 1:
Formula 41 *-C(Q₄₁)(Q₄₂)(Q₄₃)
wherein in Formula 41,
Q₄₁ to Q₄₃ are each independently deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
at least one of Q₄₁ to Q₄₃ are each independently a substituted or unsubstituted C₂-C₆₀ alkyl group, a substituted or unsubstituted C₃-C₁₀ cycloalkyl group, or a substituted or unsubstituted C₆-C₆₀ aryl group, and
* indicates a binding site to an adjacent atom,
Condition 13
X₅₁ in Formula 1-1 is N-[(L₇)_{b7}-(R₇)_{c7}],
L₇ is a benzene group, or a naphthalene group, each unsubstituted or substituted with at least one R₁₀ₐ,
R₇ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, or a substituted or unsubstituted C₁-C₁₀ heterocycloalkenyl group, and
c7 is 1,
each of i) at least two of T₁₁ to T₁₄, ii) at least two of T₂₁ to T₂₃, iii) at least two of T₃₁ to T₃₃, iv) at least two of T₄₁ to T₄₄ and v) at least two of T₁₁ to T₁₄, T₂₁ to T₂₃, T₃₁ to T₃₃, and T₄₁ to T₄₄ are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is understood by referring to the description of T₁₁ provided herein,
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C1-C10 heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), -Ge(Q₁₃)(Q₁₄)(Q₁₆), -B(Q₁₆)(Q₁₇), -P(=O)(Q₁₈)(Q₁₉),-P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇),-P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The organometallic compound of claim 1, wherein ΔST of the organometallic compound is in a range of 0.1 electron volts (eV) to 0.2 eV, preferably in a range of 0.13 electron volts (eV) to 0.2 eV, and
ΔST indicates an energy gap between a singlet (S₁) energy level and a triplet (T₁) energy level of the organometallic compound.

3. The organometallic compound of claims 1 or 2, wherein a horizontal orientation ratio of the organometallic compound is in a range of 85 percent (%) or greater;
preferably wherein a horizontal orientation ratio of the organometallic compound is in a range of 85 percent (%) to 95 %.

4. The organometallic compound of any of claims 1-3, wherein a sublimation temperature of the organometallic compound is in a range of 200 °C to 350 °C.

5. The organometallic compound of any of claims 1-4, wherein the organometallic compound satisfies Condition 11, and
L₄₂ is a benzene group, or a naphthalene group, each unsubstituted or substituted with at least one R₁₀ₐ.

6. The organometallic compound of any of claims 1-5, wherein the organometallic compound satisfies Condition 12, and
L₄₂ is a benzene group, or a naphthalene group, each unsubstituted or substituted with at least one R₁₀ₐ.

7. The organometallic compound of any of claims 1-6, wherein the organometallic compound satisfies Condition 11 or Condition 13, and
T₄₂ and R₇ are each independently a C₃-C₁₀ cycloalkyl group unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a (C₁-C₂₀ alkyl)phenyl group, a deuterated phenyl group, a fluorinated phenyl group, or any combination thereof.

8. The organometallic compound of any of claims 1-7, wherein the organometallic compound satisfies Condition 12, and
Q₄₁ to Q₄₃ in Formula 41 are each independently:
deuterium; or
a C₁-C₂₀ alkyl group, a C₃-C₁₀ cycloalkyl group, a phenyl group, a biphenyl group or a naphtyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a (C₁-C₂₀ alkyl)C₃-C₁₀ cycloalkyl group, a deuterated C₃-C₁₀ cycloalkyl group, a fluorinated C₃-C₁₀ cycloalkyl group, or any combination thereof.

9. The organometallic compound of any of claims 1-8, wherein the organometallic compound satisfies Condition 12, and
at least one of Q₄₁ to Q₄₃ in Formula 41 are each independently a C₂-C₂₀ alkyl group, a C₃-C₁₀ cycloalkyl group, a phenyl group, a biphenyl group or a naphtyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a (C₁-C₂₀ alkyl)C₃-C₁₀ cycloalkyl group, a deuterated C₃-C₁₀ cycloalkyl group, a fluorinated C₃-C₁₀ cycloalkyl group, or any combination thereof.

10. The organometallic compound of any of claims 1-9, wherein X₅₁ in Formula 1-1 is N-[(L₇)_{b7}-(R₇)_{c7}], and a group represented by *-[(L₇)_{b7}-(R₇)_{c7}] is Formula N51: 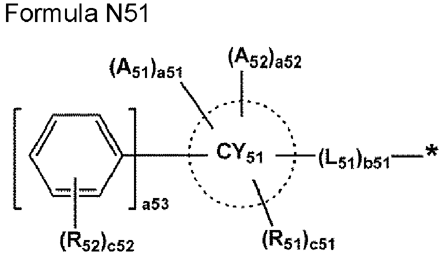 wherein, in Formula N51,
ring CY₅₁ is a C₅-C₃₀ carbocyclic group or a C₁-C₃₀ heterocyclic group, L₅₁, b51, R₅₁, and c51 are respectively understood by referring to the descriptions of L₇, b7, R₇, and c7 in claim 1,
R₅₂ and c52 are respectively understood by referring to the descriptions of R₇ and c7 in claim 1,
A₅₁ is a C₁-C₆₀ alkyl group unsubstituted or substituted with a C₃-C₁₀ cycloalkyl group,
A₅₂ is a deuterated C₁-C₆₀ alkyl group unsubstituted or substituted with a C₃-C₁₀ cycloalkyl group,
a51 and a52 are each independently an integer from 0 to 10, and a sum of a51 and a52 is 1 or greater,
a53 is an integer from 1 to 10, and
* indicates a binding site to an adjacent nitrogen atom.

11. The organometallic compound of any of claims 1-10, wherein Z₃₂ in Formula 1-1 is C-[(L₃₂)_{b32}-(T₃₂)_{c32}],
L₃₂ is a single bond, and
T₃₂ is a substituted or unsubstituted C₁-C₆₀ alkyl group, or a substituted or unsubstituted C₆-C₆₀ aryl group.

12. An organic light-emitting device comprising:
a first electrode;
a second electrode; and
an organic layer between the first electrode and the second electrode and comprising an emission layer and
at least one of the organometallic compound of any of claims 1-11.

13. The organic light-emitting device of claim 12, wherein the first electrode is an anode,
the second electrode is a cathode, and
the organic layer further comprises a hole transport region between the first electrode and the emission layer and an electron transport region between the emission layer and the second electrode,
wherein the hole transport region comprises a hole injection layer, a hole transport layer, an electron blocking layer, or any combination thereof, and
the electron transport region comprises a hole blocking layer, an electron transport layer, an electron injection layer, or any combination thereof.

14. The organic light-emitting device of claims 12 or 13, wherein the emission layer comprises the organometallic compound;
preferably wherein the emission layer further comprises a host in an amount greater than an amount of the organometallic compound;
preferably wherein the host comprises an electron transporting host and a hole transporting host, and the electron transporting host is different from the hole transporting host;
preferably wherein the electron transporting host comprises a triphenylene group and a triazine group, and the hole transporting host comprises a carbazole group.

15. An electronic apparatus comprising the organic light-emitting device of any of claims 12-14.
